# EUROPEAN PATENT SPECIFICATION

(11) **EP 2 372 807 B1**
(45) Date of publication and mention of the grant of the patent: **16.11.2016**
(21) Application number: 11160768.5
(22) Date of filing: 01.04.2011
(51) Int. Cl.: H01L 51/54

(54) **Organic light-emitting device**
Organische lichtemittierende Vorrichtung
Dispositif électroluminescent organique

(30) Priority: 02.04.2010 KR 20100030502
(43) Date of publication of application: 05.10.2011
(73) Proprietor: Samsung Display Co., Ltd., Gyeonggi-do (KR)
(72) Inventor: Kim, Tae-Shick, 446-711, Gyunggi-Do (KR); Lee, Kwan-Hee, 446-711, Gyunggi-Do (KR); Kim, Dong-Heon, 446-711, Gyunggi-Do (KR)
(74) Representative: Gulde & Partner

(56) References cited:
- JP-A- 2004 091 334
- US-A1- 2004 146 744
- US-A1- 2006 159 953
- US-A1- 2008 171 228
- US-A1- 2008 176 099
- US-A1- 2009 302 759
- US-A1- 2010 133 996
- US-B2- 6 878 469

## Description

The present invention relates to an organic light-emitting device.

### Description of the Related Art

Organic light-emitting devices (OLEDs), which are self-emitting devices, have advantages such as a wide viewing angle, excellent contrast, quick response, high brightness, and excellent driving voltage characteristics, and can provide multicolored images.

A typical OLED has a structure including a substrate, and an anode, a hole transport layer (HTL), an emission layer (EML), an electron transport layer (ETL), and a cathode which are sequentially stacked on the substrate. In this regard, the HTL, the EML, and the ETL are organic thin films formed of organic compounds.

An operating principle of an OLED having the above-described structure is as follows.

When a voltage is applied between the anode and the cathode, holes injected from the anode move to the EML via the HTL, and electrons injected from the cathode move to the EML via the ETL. The holes and electrons recombine in the EML to generate excitons. When the excitons drop from an excited state to a ground state, light is emitted.

An OLED has not had fully satisfactory characteristics in terms of luminance, efficiency, driving stability, lifetime, and the like, and thus there is an urgent need for development of various technologies. To address these problems, it is necessary to develop an OLED that has high luminance, drives at a low voltage, and has excellent efficiency and performance.

### SUMMARY

It is a feature of an embodiment to provide an organic light-emitting device (OLED) having excellent driving voltage characteristics, luminous efficiency characteristics, and power efficiency characteristics.

At least one of the above and other features and advantages may be realized by providing an organic light-emitting device including at least one cyano group-containing compound as defined in claim 1.

The cyano group-containing compound may be one represented by Formulae 1 through 20.

In Formulae 1 through 20,
X₁ through X₄ may each independently be compounds represented by Formulae 30A through 30D;
Y₁ through Y₈ may each independently be N or C(R₁₀₃);
Z₁ through Z₄ may each independently be C or N;
A₁ and A₂ may each independently be -O-, -S-, -N(R₁₀₄), or -C(R₁₀₅)(R₁₀₆)-;
Q₁₀₁ and Q₁₀₂ may each independently be a C₂-C₁₀ alkylene group; a C₂-C₁₀ alkenylene group; or a substituted C₂-C₁₀ alkylene group or a substituted C₂-C₁₀ alkenylene group which have at least one substituent that is a halogen atom, a cyano group, a hydroxyl group, a C₁-C₁₀ alkyl group, or a C₁-C₁₀ alkoxy group;
T, and T₂ may each independently be a C₅-C₃₀ aromatic ring system; a C₂-C₃₀ heteroaromatic ring system; or a substituted C₅-C₃₀ aromatic ring system or a substituted C₂-C₃₀ heteroaromatic ring system which have at least one substituent that is a halogen atom, a cyano group, a hydroxyl group, a C₁-C₁₀alkyl group, or a C₁-C₁₀ alkoxy group;
p may be an integer from 1 to 10;
q may be an integer from 0 to 10;
R₁₀₁ through R₁₀₆ may each independently be hydrogen; a halogen atom; a cyano group; a hydroxyl group; a C₁-C₁₀ alkyl group; a C₁-C₁₀alkoxy group; a substituted C₁-C₁₀alkyl group or a substituted C₁-C₁₀ alkoxy group which have at least one substituent that is a halogen atom, a cyano group, a hydroxyl group, a C₅-C₁₄ aryl group, or a C₂-C₁₄ heteroaryl group; 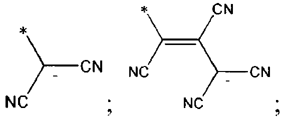 or -N(R₁₀₇)(R₁₀₈), wherein R₁₀₇ and R₁₀₈ may each independently be hydrogen, a C₁-C₁₀ alkyl group, a phenyl group, and a biphenyl group;
L₁₀₁ may be a C₅-C₁₄ arylene group; a C₅-C₁₄ heteroarylene group; or a substituted C₂-C₁₀ alkenylene group, a substituted C₅-C₁₄ arylene group, or a substituted C₅-C₁₄ heteroarylene group which have at least one substituent that is a halogen atom, a cyano group, a hydroxyl group, a C₁-C₁₀ alkyl group, or a C₁-C₁₀ alkoxy group.

X₁ through X₄ may each independently be the compound represented by Formula 30A or the compound represented by Formula 30D.

R₁₀₃ may be hydrogen; a halogen atom; a cyano group; a C₁-C₁₀ alkyl group; a C₁-C₁₀ alkoxy group; a substituted C₁-C₁₀ alkyl group or a substituted C₁-C₁₀ alkoxy group which have at least one substituent that is a halogen atom, a cyano group, a phenyl group, a naphthyl group, an anthryl group, a pyridinyl group, a thiophenyl group, or a benzothiophenyl group; or -N(R₁₀₇)(R₁₀₈), wherein R₁₀₇ and R₁₀₈ may each independently be hydrogen, a C₁-C₁₀ alkyl group, a phenyl group, or a biphenyl group.

T₁ and T₂ may each independently be benzene; naphthalene; anthracene; thiophene; thiadiazole; oxadiazole; or a substituted benzene, a substituted naphthalene, a substituted anthracene, a substituted thiophene, a substituted thiadiazole, or a substituted oxadiazole which have at least one substituent that is a halogen atom, a cyano group, a C₁-C₁₀ alkyl group, or a C₁-C₁₀ alkoxy group.

L₁₀₁ may be a thiophenylene group; a benzothiophenylene group; or a substituted thiophenylene group or a substituted benzothiophenylene group which have at least one substituent that is a halogen atom, a cyano group, or a C₁-C₁₀ alkyl group.

The cyano group-containing compound may be one represented by Formulae 1A through 20B.

In Formulae 1A through 20B, R₁₀₃ and R₁₀₉ may each independently be a hydrogen atom, -F, a cyano group, a methyl group, an ethyl group, a propyl group, a ethenyl group, a methoxy group, an ethoxy group, or a propoxy group.

The layer further includes a hole transporting compound.

The hole transporting compound is one represented by Formula 42, or one of the compounds 1 through 37.

In Formulae 41 and 42,
R₁₀ may be represented by -(Ar₁)ₙ-Ar₂;
R₁₆ may be represented by -(Ar₁₁)ₘ-Ar₁₂;
Ar₁, Ar₁₁, L₁, and L₁₁ may each independently be a substituted or unsubstituted C₁-C₃₀ alkylene group, a substituted or unsubstituted C₂-C₃₀ alkenylene group, a substituted or unsubstituted C₅-C₃₀ arylene group, a substituted or unsubstituted C₄-C₃₀ heteroarylene group, or -N(Q₁)-;
n, m, a, and b may each independently be an integer from 0 to 10;
R₁ through R₃, R₁₁ through R₁₅, R₁₇, R₁₈, R₂₁ through R₂₉, Ar₂, Ar₁₂, and Q₁ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, a C₄-C₃₀ heteroaryl group, or -N(Q₂)(Q₃);
Q₂ and Q₃ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, or a substituted or unsubstituted C₄-C₃₀ heteroaryl group; and
n groups of Ar₁ in -(Ar₁)ₙ- may be identical to or different from each other, m groups of Ar₁₁ in -(Ar₁₁)ₘ- may be identical to or different from each other, a groups of L₁ in -(L₁)ₐ- may be identical to or different from each other, and b groups of L₁₁ in -(L₁₁)_{b}- may be identical to or different from each other.

Ar₁ and Ar₁₁ may each independently be a C₁-C₁₀ alkylene group; a phenylene group; a naphthylene group; an anthrylene group; a fluorenylene group; a carbazolylene group; a pyrazolylene group; a pyridinylene group; a triazinylene group; -N(Q₁)-; or a substituted C₁-C₁₀ alkylene group, a substituted phenylene group, a substituted naphthylene group, a substituted anthrylene group, a substituted fluorenylene group, a substituted carbazolylene group, a substituted pyrazolylene group, a substituted pyridinylene group, or a substituted triazinylene group which have at least one substituent that is halogen atom, a cyano group, a hydroxyl group, a C₁-C₁₀alkyl group, a C₁-C₁₀ alkoxy group, a phenyl group, a naphthyl group, or an anthryl group; and
Q₁ may be hydrogen; a C₁-C₁₀ alkyl group; a phenyl group; a naphthyl group; a carbazolyl group; a fluorenyl group; or a substituted C₁-C₁₀ alkyl group, a substituted C₁-C₁₀ alkoxy group, a substituted phenyl group, a substituted naphthyl group, a substituted carbazolyl group, or a substituted fluorenyl group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group.

Ar₂ and Ar₁₂ may each independently be hydrogen; a C₁-C₁₀ alkyl group; a phenyl group; a naphthyl group; a carbazolyl group; a fluorenyl group; a pyrenyl group; a substituted C₁-C₁₀ alkyl group, a substituted C₁-C₁₀ alkoxy group, a substituted phenyl group, a substituted naphthyl group, a substituted carbazolyl group, a substituted fluorenyl group, or a substituted pyrenyl group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group; or -N(Q₂)(Q₃), wherein Q₂ and Q₃ may each independently be hydrogen, a methyl group, an ethyl group, a phenyl group, a methylphenyl group, a biphenyl group, a naphthyl group, or a methylnaphthyl group.

The amount of the cyano group-containing compound in the layer may be 0.1 to 20 parts by weight, based on 100 parts by weight of the first layer.

The layer may have a thickness of 10 Å to 2,100 Å.

A distance between the layer and the emission layer may be 50 A or greater.

The organic light emitting device comprises an electron transport layer which includes an anthracene-based compound and a quino late-based compound.

The anthracene-based compound may be one represented by Formula 101 and Formula 102, and the quinolate-based compound may be lithium quinolate (LiQ).

In Formulae 101 and 102,
R^{*}1 through R^{*}₆ may each independently be a hydrogen atom, a halogen atom, a hydroxy group, a cyano group, a substituted or unsubstituted C₁-C₃₀ alkyl group, a substituted or unsubstituted C₁-C₃₀ alkoxy group, a substituted or unsubstituted C₁-C₃₀ acyl group, a substituted or unsubstituted C₂-C₃₀ alkenyl group, a substituted or unsubstituted C₂-C₃₀ alkynyl group, a substituted or unsubstituted C₆-C₃₀ aryl group, or a substituted or unsubstituted C₃-C₃₀ heteroaryl group, wherein at least two adjacent groups of R^{*}₁ through R^{*}₆ are linked to form a saturated or unsaturated ring;
L^{*}₁ may be a single bond, a substituted or unsubstituted C₁-C₃₀ alkylene group, a substituted or unsubstituted C₆-C₃₀ arylene group, or a substituted or unsubstituted C₃-C₃₀ hetero arylene group;
Q^{*}₁ through Q^{*}₉ may each independently be a hydrogen atom, a substituted or unsubstituted C₆-C₃₀ aryl group, or a substituted or unsubstituted C₃-C₃₀ heteroaryl group; and
a^{*} may be an integer from 1 to 10.

The anthracene-based compound may also be one represented by Formula 103 and Formula 104, and the quinolate-based compound may be lithium quinolate (LiQ).

The amount of the anthracene-based compound may be 50 to 150 parts by weight, based on 100 parts by weight of the quinolate-based compound.

The emission layer may include a blue dopant and a blue host.

The emission layer may include a blue dopant represented by Formula 201 and a blue host represented by Formula 202.

In Formulae 201 and 202,
L₂₁ may be a substituted or unsubstituted C₁-C₃₀ alkylene group, a substituted or unsubstituted C₂-C₃₀ alkenylene group, a substituted or unsubstituted C₅-C₃₀ arylene group, or a substituted or unsubstituted C₄-C₃₀ heteroarylene group;
c may be an integer from 1 to 20;
R₃₁ through R₃₄ may each independently be a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₅-C₃₀ aryl group, or a substituted or unsubstituted C₄-C₃₀ heteroaryl group.

c groups of L₂₁ in -(L₂₁)_{c}- may be identical to or different from each other;
Ar₅₁, A₅₂, Ar₅₃, and Ar₅₄ may each independently be a phenylene group, a naphthylene, group, an anthrylene group, or a phenyl-substituted anthrylene group,
R₅₁ through R₅₆ may each independently be a hydrogen atom, a methyl group, an ethyl group, a propyl group, a butyl group, a phenyl group, a naphthyl group, an anthryl group, a pyrenyl group, a carbazolyl group, or -N(Q₂)(Q₃), wherein Q₂ and Q₃ may each independently be a methyl group, a phenyl group, a naphthyl group, or an anthryl group; and
d, e, f, and g may each independently be an integer from 0 to 10.

### BRIEF DESCRIPTION OF THE DRAWING

The above and other features and advantages will become more apparent to those of skill in the art by describing in detail example embodiments with reference to the attached drawing, in which:

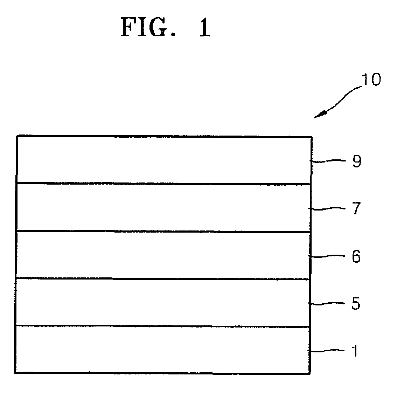

FIG. 1 illustrates a cross-sectional view of a structure of an organic light-emitting device (OLED) according to an embodiment.

### DETAILED DESCRIPTION

Example embodiments will now be described more fully hereinafter with reference to the accompanying drawing.

In the drawing figure, the dimensions of layers and regions are exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

FIG. 1 illustrates a schematic cross-sectional view of a structure of an organic light-emitting device (OLED) 10 according to an embodiment. Referring to FIG. 1, the OLED 10 according to an embodiment may include a substrate 1, a first electrode 5, a layer 6, an organic layer 7, and a second electrode 9 sequentially stacked in the stated order. The first layer 6 includes a cyano group-containing compound. The organic layer 7 includes an emission layer (EML) and an electron transport layer (ETL).

The substrate 1 is a suitable substrate that is used in conventional organic light-emitting devices. The substrate 1 may be, e.g., a glass substrate or a transparent plastic substrate providing one or more of mechanical strength, thermal stability, transparency, surface smoothness, ease of handling, and water resistance.

The first electrode 5 may constitute an anode or a cathode. Examples of the first electrode material include materials, such as indium tin oxide (ITO), indium zinc oxide (IZO), tin oxide (SnO₂), zinc oxide (ZnO), aluminum (Al), silver (Ag), and magnesium (Mg), which have excellent conductivity. The first electrode material may form a transparent or reflective electrode.

The layer 6 includes a cyano group-containing compound and is disposed on the first electrode 5. The cyano group-containing compound included in the layer 6 has two one-electron reduced forms, and may have an extended π-electron system capable of generating stable radicals (this can be identified by, e.g., cyclic voltammetry). The layer 6 may lower a barrier of hole injection from the first electrode 5 into the organic layer 7. Thus, the layer 6 may facilitate the injection of holes into the organic layer 7 from the first electrode 5. Thus, the OLED 10 may have excellent driving voltage characteristics and power efficiency characteristics.

The cyano group-containing compound included in the layer 6 may be one of the compounds represented by Formulae 1 through 20 below.

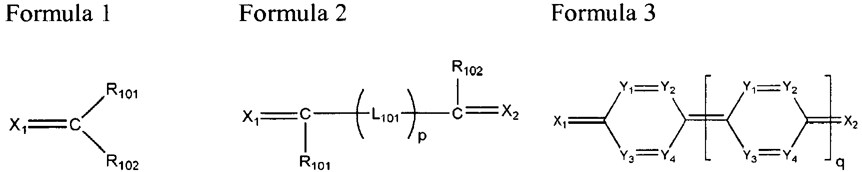

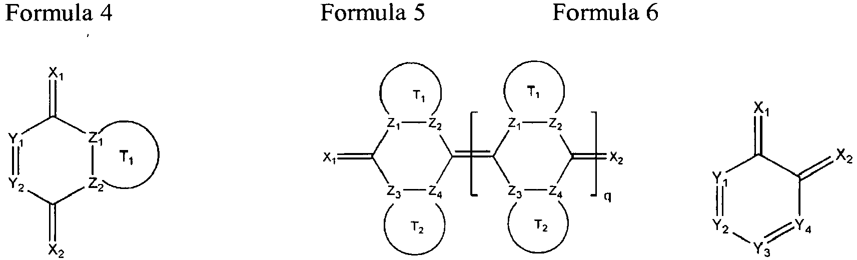

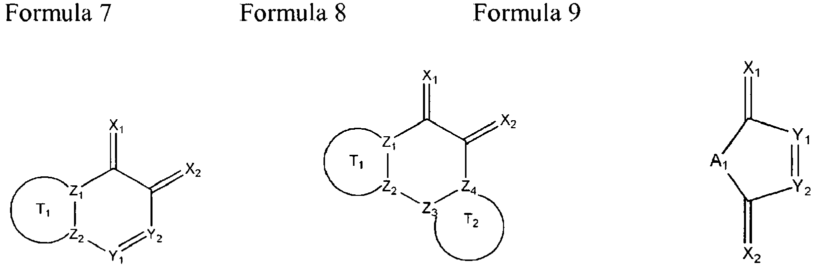

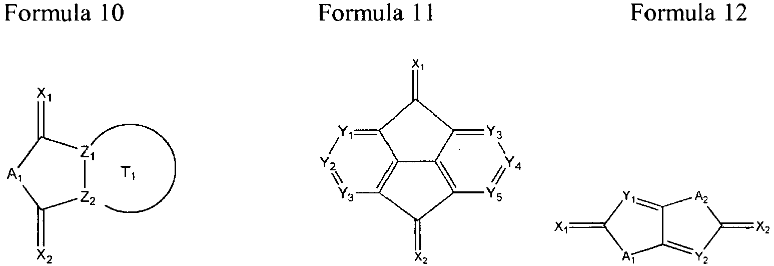

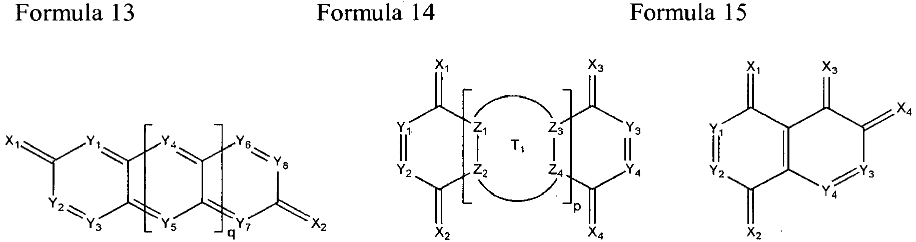

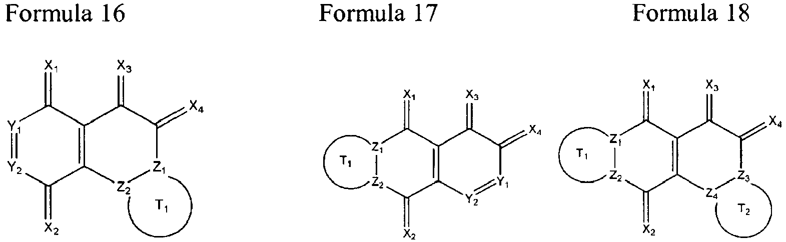

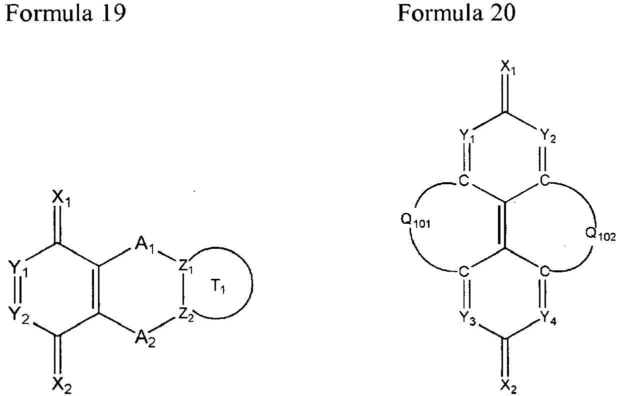

In Formulae 1 through 20, X₁ through X₄ are each independently be compounds represented by Formulae 30A through 30D below; Y₁ through Y₈ are each independently be N or C(R₁₀₃); Z₁ through Z₄ are each independently be C or N; A₁ and A₂ are each independently be -O-, -S-, -N(R₁₀₄) or -C(R₁₀₅)(R₁₀₆)-; Q₁₀₁ and Q₁₀₂ are each independently be a C₂-C₁₀ alkylene group, a C₂-C₁₀ alkenylene group, or a substituted C₂-C₁₀ alkylene group or a substituted C₂-C₁₀ alkenylene group which have at least one substituent that is a halogen atom, a cyano group, a hydroxyl group, a C₁-C₁₀ alkyl group or a C₁-C₁₀ alkoxy group; T₁ and T₂ are each independently be a C₅-C₃₀ aromatic ring system, a C₂-C₃₀ heteroaromatic ring system, or a substituted C₅-C₃₀ aromatic ring system or a substituted C₂-C₃₀ heteroaromatic ring system which have at least one substituent that is a halogen atom, a cyano group, a hydroxyl group, a C₁-C₁₀ alkyl group or a C₁-C₁₀ alkoxy group; p is an integer from 1 to 10; q is an integer from 0 to 10; R₁₀, through R₁₀₆ are each independently be hydrogen, a halogen atom, a cyano group, a hydroxyl group, a C₁-C₁₀ alkyl group, a C₁-C₁₀ alkoxy group, a substituted C₁-C₁₀ alkyl group or a substituted C₁-C₁₀ alkoxy group which have at least one substituent that is a halogen atom, a cyano group, a hydroxyl group, a C₅-C₁₄ aryl group, or a C₂-C₁₄ heteroaryl group, 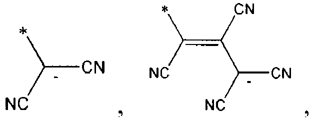 or -N(R₁₀₇)(R₁₀₈), wherein R₁₀₇ and R₁₀₈ are each independently hydrogen, a C₁-C₁₀ alkyl group, a phenyl group, or a biphenyl group; and L₁₀₁ is a C₅-C₁₄ arylene group, a C₅-C₁₄ heteroarylene group, or a substituted C₂-C₁₀ alkenylene group, a substituted C₅-C₁₄ arylene group or a substituted C₅-C₁₄ heteroarylene group which have at least one substituent that is a halogen atom, a cyano group, a hydroxyl group, a C₁-C₁₀ alkyl group, or a C₁-C₁₀ alkoxy group.

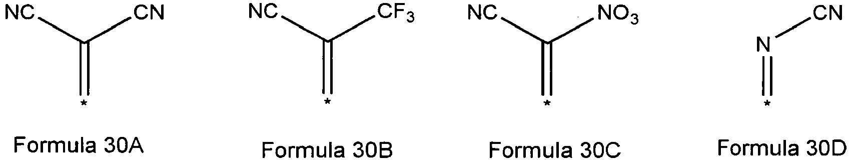

For example, in Formula 1 through 20, X₁ through X₄ may each independently be a compound represented by Formula 30A or a compound represented by Formula 30D.

For example, R₁₀₃ in C(R₁₀₃) for Y₁ through Y₈ in Formulae 1 through 20 may be hydrogen; a halogen atom; a cyano group; a C₁-C₁₀alkyl group; a C₁-C₁₀ alkoxy group; a substituted C₁-C₁₀alkyl group or a substituted C₁-C₁₀alkoxy group which have at least one substituent that is a halogen atom, a cyano group, a phenyl group, a naphthyl group, an anthryl group, a pyridinyl group, a thiophenyl group, or a benzothiophenyl group; or -N(R₁₀₇)(R₁₀₈), wherein R₁₀₇ and R₁₀₈ may each independently be hydrogen, a C₁-C₁₀ alkyl group, a phenyl group, or a biphenyl group.

In particular, R₁₀₃ may be hydrogen, -F, a cyano group, a methyl group, an ethyl group, a propyl group, an ethenyl group, a methoxy group, an ethoxy group, a propoxy group, a phenyl-substituted methyl group, a phenyl-substituted propyl group, or an -N(biphenyl group)(biphenyl group).

In Formulae 1 and 2, R₁₀₁ and R₁₀₂ may each independently be a cyano group, 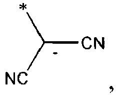 or

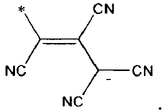

In Formulae 1 through 20, A₁ and A₂ may be -S-.

In Formula 20, Q₁₀₁ and Q₁₀₂ may each independently be an ethylene group, a propylene group, an ethenylene group, a propylene group, or a substituted ethylene group, a substituted propylene group, a substituted ethenylene group, or a substituted propylene group which have at least one substituent that is a halogen atom, a cyano group, or a hydroxyl group. In particular, Q₁₀₁ and Q₁₀₂ may each independently be an ethylene group, an ethenylene group, or a substituted ethylene group or a substituted ethenylene group which have at least one substituent that is -F or a cyano group.

In Formulae 1 through 20, T₁ and T₂ may each independently be a C₅-C₃₀ aromatic ring system including elements Z₁ and Z₂, or Z₃ and Z₄; a C₂-C₃₀ heteroaromatic ring system; a substituted C₅-C₃₀ aromatic ring system having at least one substituent that is a halogen atom, a cyano group, a hydroxyl group, a C₁-C₁₀ alkyl group, or a C₁-C₁₀ alkoxy group; or a substituted C₅-C₃₀ heteroaromatic ring system having at least one substituent that is a halogen atom, a cyano group, a hydroxyl group, a C₁-C₁₀ alkyl group, or a C₁-C₁₀ alkoxy group. In an implementation, T₁ and T₂ may each independently be a C₆-C₃₀ aromatic ring system including elements Z₁ and Z₂, or Z₃ and Z₄; a C₂-C₃₀ heteroaromatic ring system; a substituted C₆-C₃₀ aromatic ring system having at least one substituent that is a halogen atom, a cyano group, a hydroxyl group, a C₁-C₁₀ alkyl group, or a C₁-C₁₀ alkoxy group; or a substituted C₅-C₃₀ heteroaromatic ring system having at least one substituent that is a halogen atom, a cyano group, a hydroxyl group, a C₁-C₁₀ alkyl group, or a C₁-C₁₀ alkoxy group. As identified from Formulae 1 through 20, T₁ and T₂ are fused to the backbones of Formulae 1 through 20.

The C₅-C₃₀ aromatic ring system refers to a C₅-C₃₀ carbocyclic aromatic system including at least one aromatic ring. In this regard, the term "system" used herein indicates that the C₅-C₃₀ aromatic ring system may include a polycyclic structure.

When the C₅-C₃₀ aromatic ring system includes 2 or more aromatic rings, the 2 or more aromatic rings may be fused together. The C₂-C₃₀ heteroaromatic ring system refers to a C₂-C₃₀ carbocyclic aromatic system including at least one heteroaromatic ring, wherein the at least one heteroaromatic ring includes at least one heteroatom that is nitrogen (N), oxygen (O), phosphorous (P) or sulfur (S), and has carbon (C) as the other ring atoms.

When the C₂-C₃₀ heteroaromatic ring system further includes at least one of an aromatic ring group and a heteroaromatic ring, two or more (hetero)aromatic rings may be fused together.

Examples of the C₅-C₃₀ aromatic ring system include benzene, pentalene, indene, naphthalene, azulene, heptalene, indacene, acenaphthylene, fluorene, phenalene, phenanthrene, anthracene, fluoranthene, triphenylene, pyrene, chrysene, naphthacene, picene, perylene, pentaphene, and hexacene.

Examples of the C₅-C₃₀ heteroaromatic ring system include pyrrole, pyrazole, imidazole, imidazoline, pyridine, pyrazine, pyrimidine, indole, purine, quinoline, phthalazine, indolizine, naphthyridine, quinazoline, cinnoline, indazole, carbazole, phenazine, phenanthridine, pyran, chromene, benzofuran, thiophene, benzothiophene, isothiazole, isoxazole, thiadiazole, and oxadiazole.

For example, in Formulae 1 through 20, T₁ and T₂ may each independently be benzene; naphthalene; anthracene; thiophene; thiadiazole; oxadiazole; or a substituted benzene, a substituted naphthalene, a substituted anthracene, a substituted thiophene, a substituted thiadiazole, or a substituted oxadiazole which have at least one substituent that is a halogen atom, a cyano group, a C₁-C₁₀ alkyl group, or a C₁-C₁₀ alkoxy group.

In Formulae 1 through 20, p may be 1. In addition, q may be 0, 1, or 2. For example, when q in Formula 3 is 0, the compound represented by Formula 3 may be a compound represented by Formula 3A, which will be described below.

In Formula 2, L₁₀₁ may be a C₅-C₁₄ arylene group; a C₅-C₁₄ heteroarylene group; a substituted C₅-C₁₄ arylene group having at least one substituent that is a halogen atom, a cyano group, a hydroxyl group, a C₁-C₁₀alkyl group or a C₁-C₁₀ alkoxy group; or a substituted C₅-C₁₄ heteroarylene group having at least one substituent that is a C₂-C₁₀ alkenylene group, a halogen atom, a cyano group, a hydroxyl group, a C₁-C₁₀ alkyl group, or a C₁-C₁₀ alkoxy group. In an implementation, L₁₀₁ may be a C₆-C₁₄ arylene group; a C₅-C₁₄ heteroarylene group; a substituted C₆-C₁₄ arylene group having at least one substituent that is a halogen atom, a cyano group, a hydroxyl group, a C₁-C₁₀ alkyl group or a C₁-C₁₀ alkoxy group; or a substituted C₅-C₁₄ heteroarylene group having at least one substituent that is a C₂-C₁₀ alkenylene group, a halogen atom, a cyano group, a hydroxyl group, a C₁-C₁₀ alkyl group, or a C₁-C₁₀ alkoxy group. For example, L₁₀₁ may be a thiophenylene group; a benzothiophenylene group; or a substituted thiophenylene group or a substituted benzothiophenylene group which have at least one substituent that is a halogen atom, a cyano group, or a C₁-C₁₀ alkyl group.

One or more of the compounds represented by Formulae 1A through 20B, below, may be used for the cyano group-containing compound included in the layer 6 of the OLED 10:

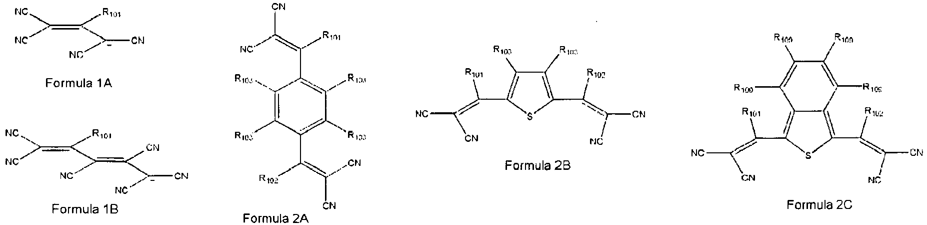

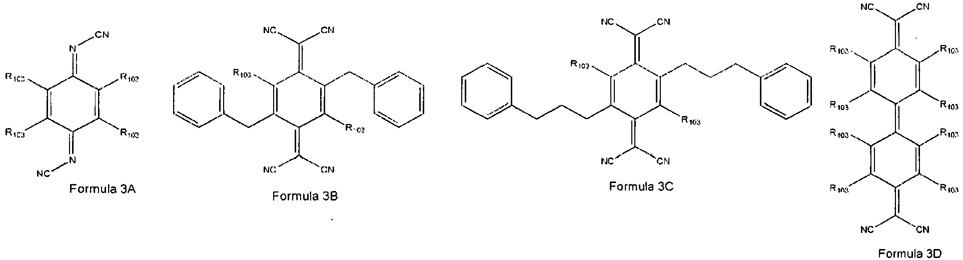

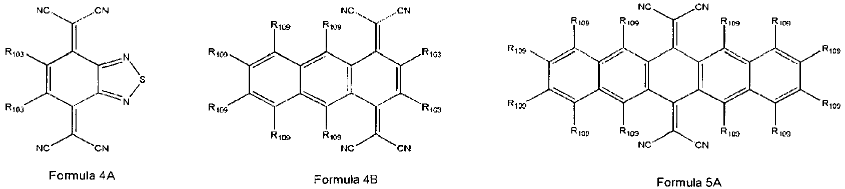

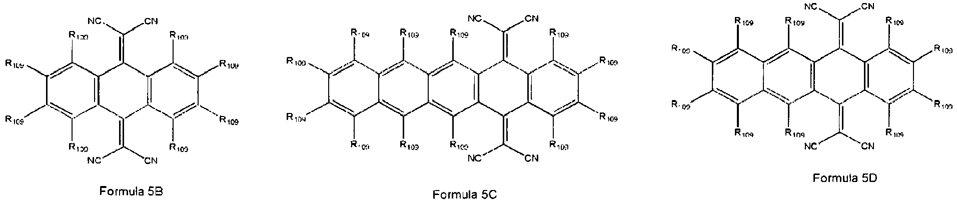

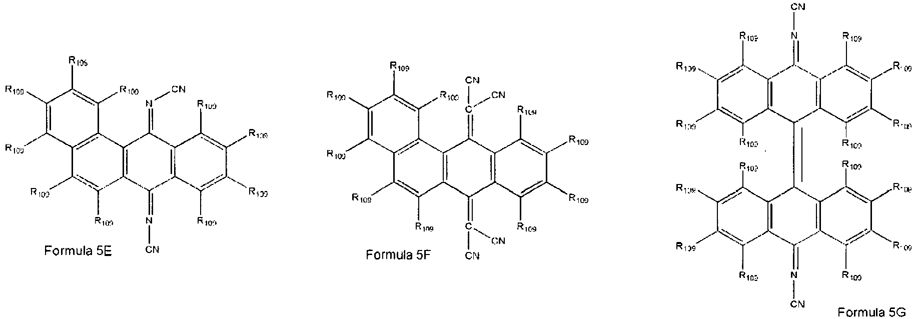

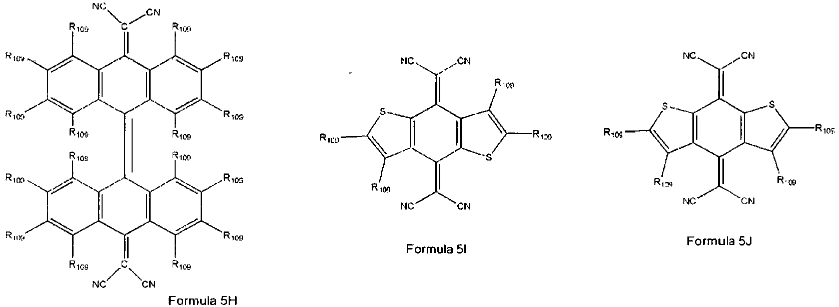

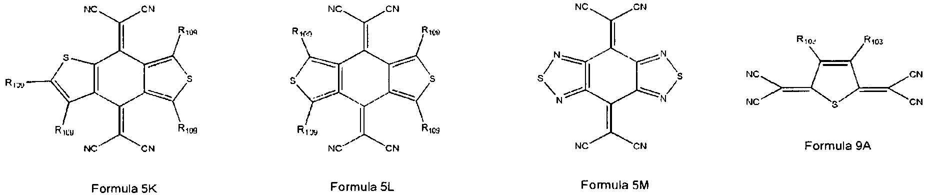

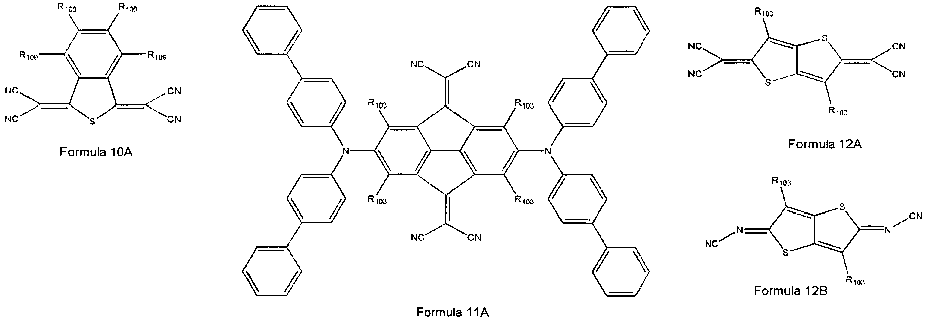

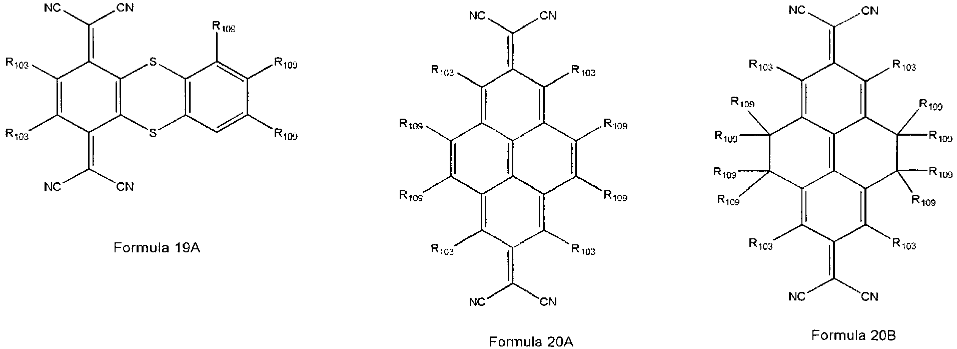

In Formulae 1A through 20B, R₁₀₃ and R₁₀₉ may each independently be a hydrogen atom, -F, a cyano group, a methyl group, an ethyl group, a propyl group, a methoxy group, an ethoxy group, or a propoxy group.

For example, the compound represented by Formula 20A or 20B may be the cyano group-containing compound included in the layer 6 of the OLED 10. In Formulae 20A and 20B, R₁₀₃ and R₁₀₉ may both be -F.

The cyano group-containing compound included in the layer 6 improves the hole injecting ability of the first electrode 5. Thus, the OLED 10 has a reduced driving voltage and higher emission and power efficiencies.

The layer 6 includes a hole transporting compound in addition to the cyano group-containing compound described above. The cyano group-containing compound may form a charge transfer complex with the hole transporting compound, so that the concentration of free carriers in the layer 6 may be increased. Thus, the cyano group-containing compound may contribute to a reduction in interfacial resistance between the first electrode 5 and the organic layer 7.

A compound represented by Formulae 42, below, may be used for the hole transporting compound:

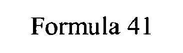

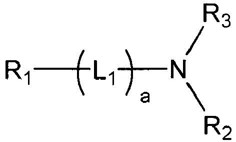

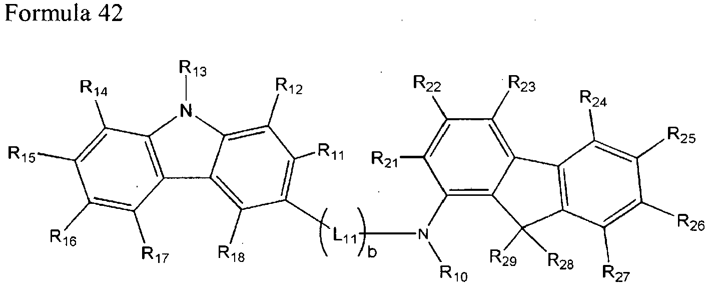

In Formulae 41 and 42, R₁₀ may be represented by -(Ar₁)ₙ-Ar₂; R₁₆ may be represented by -(Ar₁₁)ₘ-Ar₁₂; Ar₁, Ar₁₁, L₁ and L₁₁ may each independently be a substituted or unsubstituted C₁-C₃₀ alkylene group, a substituted or unsubstituted C₂-C₃₀ alkenylene group, a substituted or unsubstituted C₅-C₃₀ arylene group, a substituted or unsubstituted C₄-C₃₀ heteroarylene group, or a group represented by -N(Q₁)-; n, m, a, and b may each independently be an integer from 0 to 10; R₁ through R₃, R₁₁ through R₁₅, R₁₇, R₁₈, R₂₁ through R₂₉, Ar₂, Ar₁₂, and Q₁ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, a substituted or unsubstituted C₄-C₃₀ heteroaryl group, or a group represented by -N(Q₂)(Q₃); and Q₂ and Q₃ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, or a substituted or unsubstituted C₄-C₃₀ heteroaryl group, wherein n groups of Ar₁ in -(Ar₁)ₙ- may be identical to or different from each other, m groups of Ar₁₁ in -(Ar₁₁)ₘ- may be identical to or different from each other, a groups of L₁ in -(L₁)ₐ- may be identical to or different from each other, and b groups of L₁₁ in -(L₁₁)_{b}- may be identical to or different from each other. In an implementation, L₁ and L₁₁ may each independently be a substituted or unsubstituted C₁-C₃₀ alkylene group, a substituted or unsubstituted C₂-C₃₀ alkenylene group, a substituted or unsubstituted C₆-C₃₀ arylene group, a substituted or unsubstituted C₄-C₃₀ heteroarylene group, or a group represented by -N(Q₁)-; R₁ through R₃, R₁₁ through R₁₅, R₁₇, R₁₈, R₂₁ through R₂₉, Ar₂, Ar₁₂ and Q₁ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₆-C₃₀ aryl group, a substituted or unsubstituted C₄-C₃₀ heteroaryl group, or a group represented by -N(Q₂)(Q₃); and Q₂ and Q₃ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₆-C₃₀ aryl group, or a substituted or unsubstituted C₄-C₃₀ heteroaryl group.

Examples of Ar₁ in the formula -(Ar₁)ₙ-Ar₂- for R₁₀ and Ar₁₁ in the formula -(Ar₁₁)ₘ-Ar₁₂- for R₁₆ may each independently be a substituted or unsubstituted C₁-C₁₀ alkylene group, a substituted or unsubstituted C₂-C₁₀ alkenylene group, a substituted or unsubstituted phenylene group, a substituted or unsubstituted pentalenylene group, a substituted or unsubstituted indenylene group, a substituted or unsubstituted naphthylene group, a substituted or unsubstituted azulenylene group, a substituted or unsubstituted heptalenylene group, a substituted or unsubstituted indacenylene group, a substituted or unsubstituted acenaphthylene group, a substituted or unsubstituted fluorenylene group, a substituted or unsubstituted phenalenylene group, a substituted or unsubstituted phenanthrenylene group, a substituted or unsubstituted anthracenylene group, a substituted or unsubstituted fluoranthenylene group, a substituted or unsubstituted triphenylenylene group, a substituted or unsubstituted pyrenylenylene group, a substituted or unsubstituted chrysenylene group, a substituted or unsubstituted perylenylene group, a substituted or unsubstituted pyrrolylene group, a substituted or unsubstituted pyrazolylene group, a substituted or unsubstituted imidazolylene group, a substituted or unsubstituted imidazolinylene group, a substituted or unsubstituted imidazopyridinylene group, a substituted or unsubstituted imidazopyrimidinylene group, a substituted or unsubstituted pyridinylene group, a substituted or unsubstituted pyrazinylene group, a substituted or unsubstituted pyrimidinylene group, a substituted or unsubstituted indolylene group, a substituted or unsubstituted purinylene group, a substituted or unsubstituted quinolinylene group, a substituted or unsubstituted phthalazinylene group, a substituted or unsubstituted indolizinylene group, a substituted or unsubstituted naphthyridinylene group, a substituted or unsubstituted quinazolinylene group, a substituted or unsubstituted cinnolinylene group, a substituted or unsubstituted indazolylene group, a substituted or unsubstituted carbazolylene group, a substituted or unsubstituted phenazinylene group, a substituted or unsubstituted phenanthridinylene group, a substituted or unsubstituted pyranylene group, a substituted or unsubstituted chromenylene group, a substituted or unsubstituted benzofuranylene group, a substituted or unsubstituted thiophenylene group, a substituted or unsubstituted benzothiophenylene group, a substituted or unsubstituted isothiazolylene group, a substituted or unsubstituted benzoimidazolylene group, a substituted or unsubstituted isoxazolylene group, a substituted or unsubstituted triazinylene group, or a group represented by -N(Q₁)-, but are limited thereto. In this regard, Q₁ may be hydrogen, a halogen atom, a hydroxyl group, a cyano group, a substituted or unsubstituted C₁-C₁₀ alkyl group, a substituted or unsubstituted C₂-C₁₀ alkenyl group, a substituted or unsubstituted C₂-C₁₀ alkynyl group, a substituted or unsubstituted C₁-C₁₀ alkoxy group, a substituted or unsubstituted C₁-C₁₀ alkylthiol group, a substituted or unsubstituted C₅-C₁₄ aryl group, a substituted or unsubstituted C₄-C₁₄ heteroaryl group, or -N(Q₂)(Q₃). In an implementation, Q₁ may be hydrogen, a halogen atom, a hydroxyl group, a cyano group, a substituted or unsubstituted C₁-C₁₀ alkyl group, a substituted or unsubstituted C₂-C₁₀ alkenyl group, a substituted or unsubstituted C₂-C₁₀ alkynyl group, a substituted or unsubstituted C₁-C₁₀ alkoxy group, a substituted or unsubstituted C₁-C₁₀ alkylthiol group, a substituted or unsubstituted C₆-C₁₄ aryl group, a substituted or unsubstituted C₄-C₁₄ heteroaryl group, or -N(Q₂)(Q₃).

For example, Ar₁ and Ar₁₁ may each independently be a C₁-C₁₀ alkylene group; a phenylene group; a naphthylene group; an anthrylene group; a fluorenylene group; a carbazolylene group; a pyrazolylene group; a pyridinylene group; a triazinylene group; -N(Q₁)-; or a substituted C₁-C₁₀ alkylene group, a substituted phenylene group, a substituted naphthylene group, a substituted anthrylene group, a substituted fluorenylene group, a substituted carbazolylene group, a substituted pyrazolylene group, a substituted pyridinylene group, or a substituted triazinylene group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group. In this regard, Q₁ may be hydrogen; a C₁-C₁₀ alkyl group; a phenyl group; a naphthyl group; a carbazolyl group; a fluorenyl group; a pyrenyl group; a substituted C₁-C₁₀ alkyl group, a substituted C₁-C₁₀ alkoxy group, a substituted phenyl group, a substituted naphthyl group, a substituted carbazolyl group, a substituted fluorenyl group, or a substituted pyrenyl group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group; or -N(Q₂)(Q₃). In addition, Q₂ and Q₃ may be a methyl group, a phenyl group, a naphthyl group, or an anthryl group.

Ar₂ in the formula -(Ar₁)ₙ-Ar₂- and Ar₁₂ in the formula -(Ar₁₁)ₘ-Ar₁₂- are as defined above in connection with Q₁.

Also, n in the formula -(Ar₁)n-Ar₂- and m in the formula -(Ar₁₁)ₘ-Ar₁₂- may each independently be an integer from 0 to 10. For example, n and m may each independently be 0, 1, 2, 3, 4, or 5.

Also, n groups of Ar₁ in the formula -(Ar₁)ₙ-Ar₂- may be identical to or different from each other. For example, when n is 2, the two groups of Ar₁ in -(Ar₁)ₙ- may both be phenylene groups, or one of the two may be -N(Q₁)- and the other may be a phenylene group. The descriptions of -(Ar₁₁)ₘ-Ar₁₂- may be the same as those of -(Ar₁)ₙ-Ar₂- above.

R₁ through R₃, R₁₁ through R₁₅, R₁₇, R₁₈, and R₂₁ through R₂₉ in Formulae 41 and 42 may be defined as described above in connection with Q₁.

For example, R₁₃ may be a phenyl group, a naphthyl group, or an anthryl group.

For example, R₂₈ and R₂₉ may each independently be a hydrogen atom, a methyl group, an ethyl group, a methoxy group, an ethoxy group, a phenyl group, a naphthyl group, or an anthryl group.

L₁ and L₂ in Formulae 41 and 42 may be defined as described above in connection with Ar₁ and Ar₁₁.

For example, L₁ and L₂ may each independently be a phenylene group, a carbazolylene group, or a phenylcarbazolylene group.

In Formulae 41 and 42, a and b may each independently be an integer from 0 to 10. For example, a and b may each independently be 0, 1, 2, or 3.

For example, in Formula 42, Ar₁ in the formula -(Ar₁)ₙ-Ar₂- for R₁₀ and Ar₁₁ in the formula -(Ar₁₁)ₘ-Ar₁₂- for R₁₆ may each independently be a phenylene group; a carbazolylene group; a fluorenylene group; a methylfluorenylene group; a pyrazolylene group; a phenylpyrazolylene group; -N(Q₁)-, wherein Q₁ is hydrogen, a phenyl group, a fluorenyl group, a dimethylfluorenyl group, a diphenylfluorenyl group, a carbazolyl group, or a phenylcarbazolyl group; a diphenylfluorenylene group; a triazinylene group; a methyltriazinylene group; a phenyltriazinylene group; a tetrafluorophenylene group; an ethylene group; or a methylphenylene group, wherein n and m may each independently be 0, 1, 2, 3, 4, 5 or 6, and Ar₂ and Ar₁₂ may each independently be hydrogen, a cyano group, a fluoro group, a phenyl group, a cyanophenyl group, a naphthyl group, an anthryl group, a methyl group, a pyridinyl group, a carbazolyl group, a phenylcarbazolyl group, a fluorenyl group, a dimethylfluorenyl group, or a diphenylfluorenyl group. R₁₁, R₁₂, R₁₄, R₁₅, R₁₇, R₁₈, R₂₁ through R₂₇ may be hydrogen; R₁₃ may be a phenyl group, a naphthyl group, or an anthryl group; R₂₈ and R₂₉ may each independently be hydrogen, a methyl group, an ethyl group, a methoxy group, an ethoxy group, a phenyl group, a naphthyl group, or an anthryl group; L₁₁ may be a phenylene group; and b may be 0 or 1.

In an embodiment, one or more of Compounds 1 through 37 below may be used for the hole transporting compound:

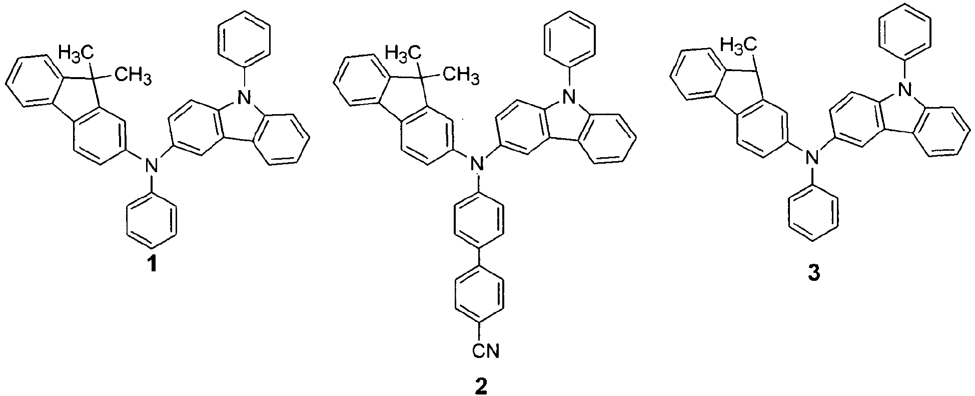

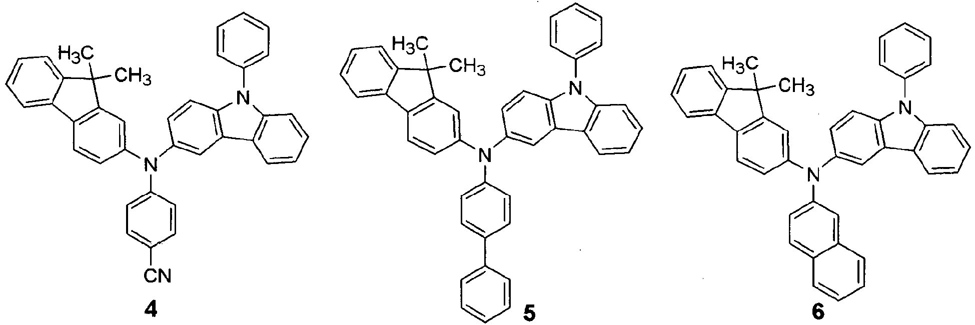

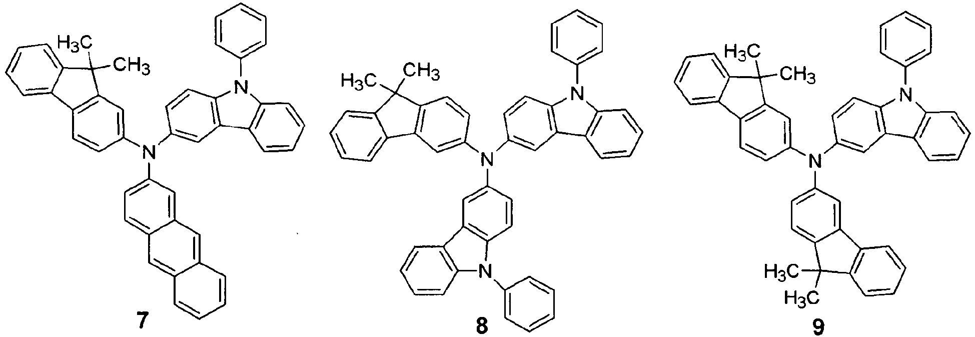

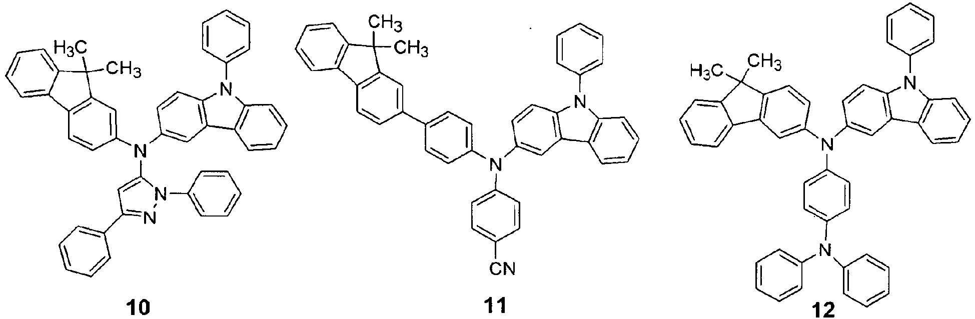

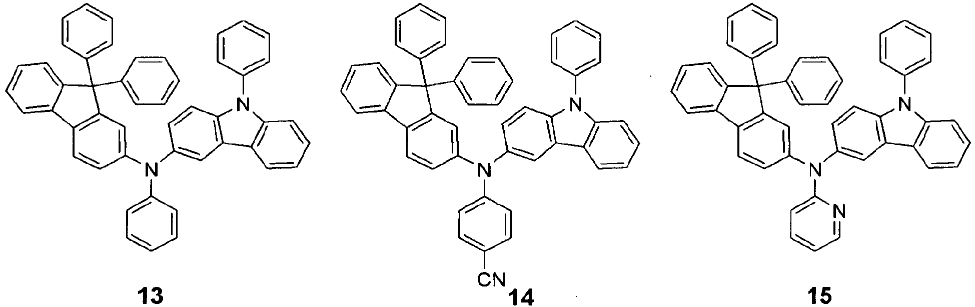

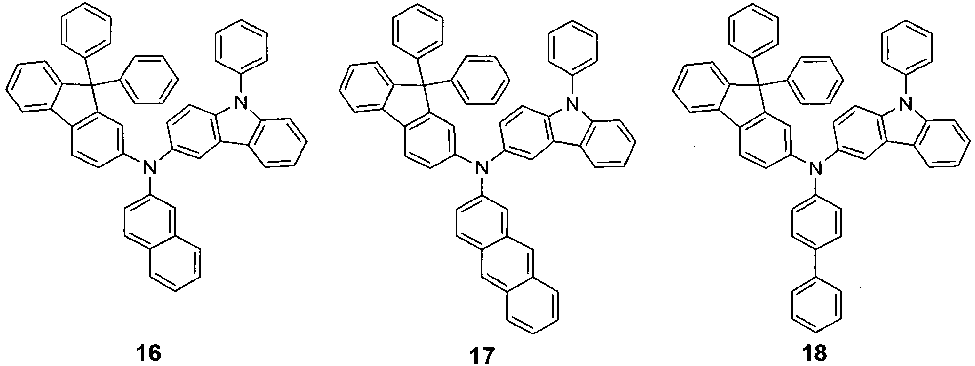

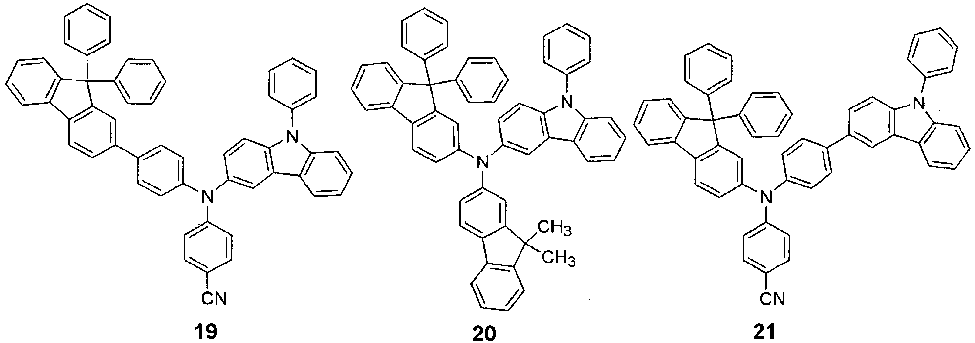

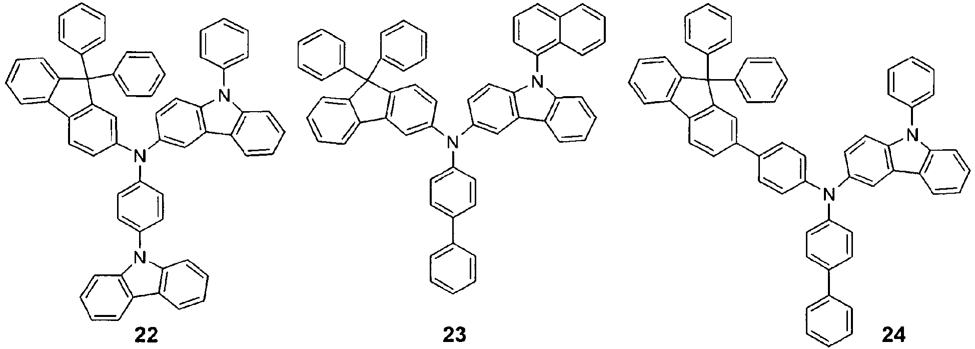

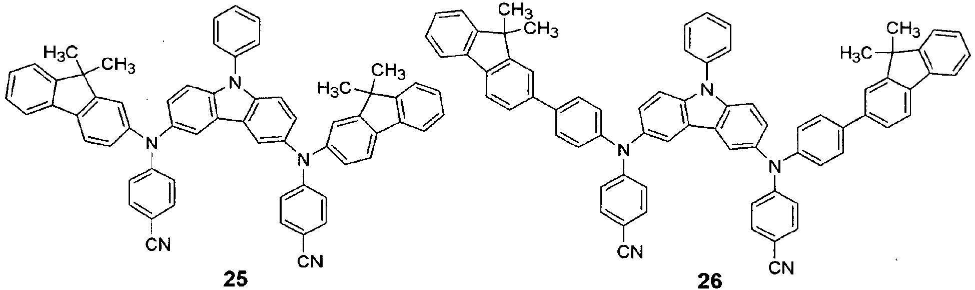

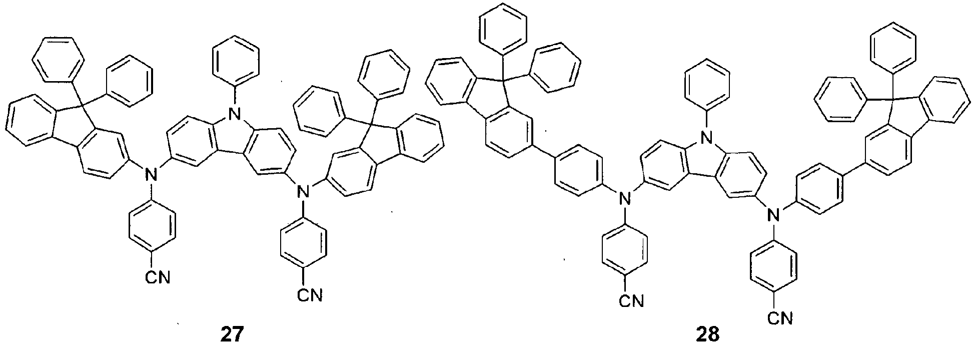

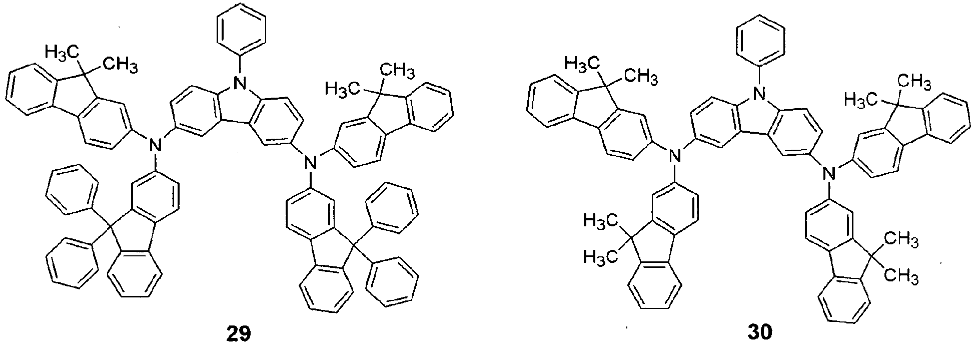

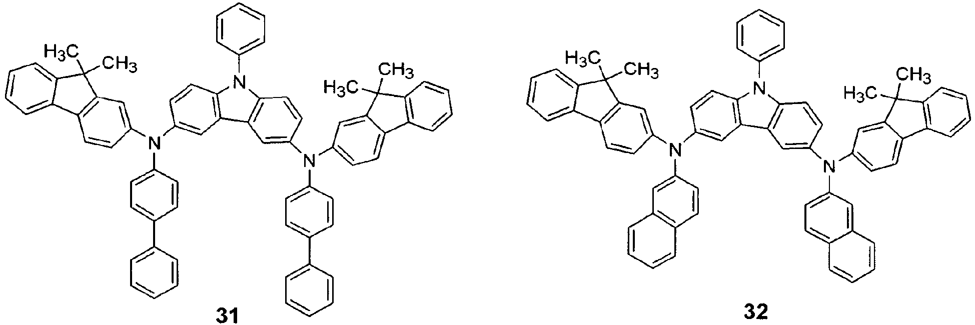

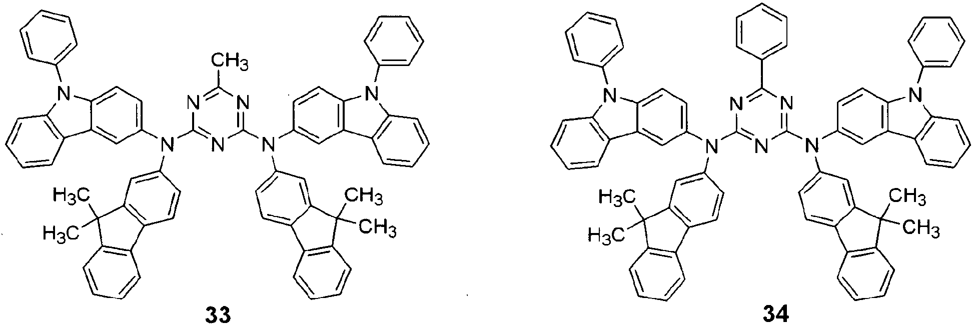

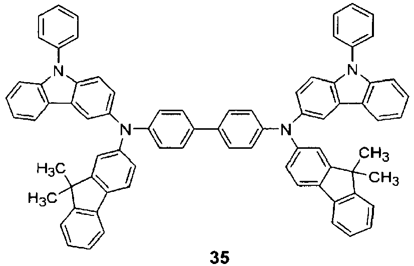

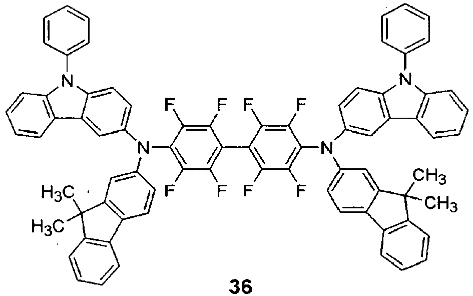

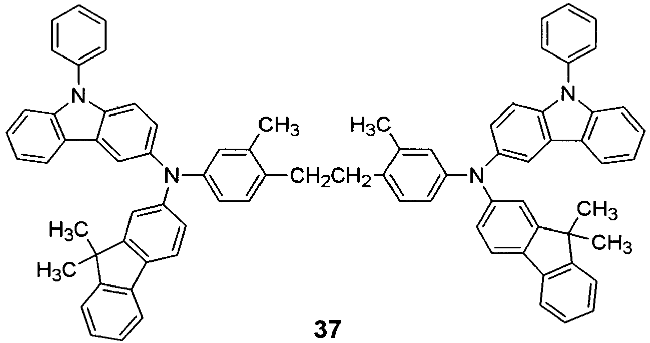

The amount of the cyano group-containing compound in the layer 6 may be 0.1 to 20 parts by weight, for example, 0.5 to 15 parts by weight, or 0.5 to 10 parts by weight, based on 100 parts by weight of the layer 6. With such an amount of the cyano group-containing compound, the driving voltage may be satisfactorily decreased, and the emission and power efficiencies can be satisfactorily improved.

The thickness of the layer 6 may be 10 Å to 2100 Å, for example, 10 Å to 500 Å, or 20 Å to 200 Å. With such a thickness of the layer 6, the driving voltage may be satisfactorily decreased, and the emission and power efficiencies can be satisfactorily improved.

The organic layer 7 is disposed on the layer 6. The term "organic layer" used throughout the specification refers to any intervening layer between the first electrode 5 and the second electrode 9 (but excluding the layer 6 described above). The organic layer 7 is formed of organic materials, and may further include a metal complex.

The organic layer 7 includes a hole transport layer (HTL), an emission layer (EML) and an electron transport layer (ETL)

A distance between the layer 6 and the EML may be 50 Å or greater, for example, 100 Å or greater, or 100 Å to 2500 Å. With such a distance between the layer 6 and the EML, quenching of excitons in the emission layer caused by the cyano group-containing compound included in the layer 6 can be substantially prevented. Thus, the OLED has excellent quality.

The organic layer 7 may further include at least one of a hole injection layer (HIL), a hole blocking layer (HBL), and an electron injection layer (EIL), in addition to the EML and the ETL.

The HIL may be further disposed between the layer 6 and the EML.

The HIL may be formed on the layer 6 by vacuum deposition, spin coating, casting, Langmuir-Blodgett (LB) deposition, or the like.

When the HIL is formed using vacuum deposition, the deposition conditions may vary according to a compound that is used to form the HIL, and the structure and thermal properties of the HIL to be formed. In general, however, conditions for vacuum deposition may include a deposition temperature of 100 to 500 °C, a pressure of 10⁻⁸ to 10⁻³ torr, and a deposition rate of 0.01 to 100 Å/sec.

When the HIL is formed using spin coating, the coating conditions may vary according to a compound that is used to form the HIL, and the structure and thermal properties of the HIL to be formed. In general, however, the coating rate may be in the range of 2,000 to 5,000 rpm, and a temperature for heat treatment which is performed to remove a solvent after coating may be in the range of 80 to 200 °C.

Examples of the material that can be used to form the HIL include a phthalocyanine compound such as copper phthalocyanine, 4,4',4"-tris(3-methylphenylphenylamino) triphenylamine (m-MTDATA), N,N'-di(1-naphthyl)-N,N'-diphenylbenzidine (NPB), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

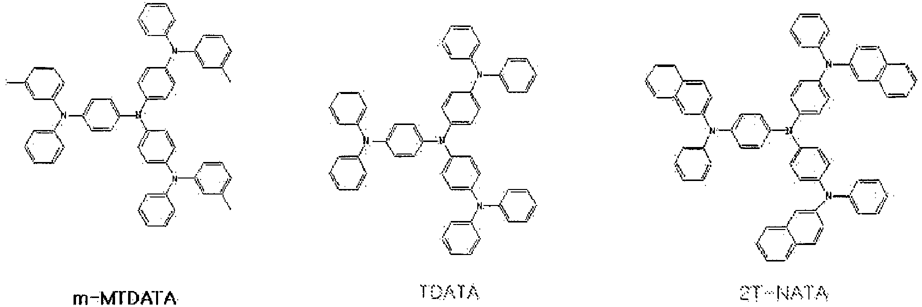

The thickness of the HIL may be about 50 to 1000 Å, for example, about 100 to about 2500 Å. With such a thickness of the HIL, the HIL may have excellent hole injecting ability without a substantial increase in driving voltage.

Then, the HTL may be formed directly on the HIL or directly on the layer 6 by vacuum deposition, spin coating, casting, Langmuir-Blodgett (LB) deposition, or the like.

When the HTL is formed using vacuum deposition or spin coating, the conditions for deposition and coating may be similar to those for the formation of the HIL, although the conditions for the deposition and coating may vary according to the material that is used to form the HTL.

One or more of the compounds represented by Formula 41 or 42 described above may be used to form the HTL.

The thickness of the HTL may be about 50 to 1000 Å, for example, about 100 to about 2500 Å. With such a thickness of the HTL, the HTL may have a satisfactory hole transporting ability without a substantial increase in driving voltage.

Then, the EML may be formed on the HTL by using vacuum deposition, spin coating, casting, LB deposition, or the like. When the EML is formed using vacuum deposition or spin coating, the conditions for deposition and coating may be similar to those for the formation of the HIL, although the conditions for deposition and coating may vary according to the material that is used to form the EML.

The EML may include a blue dopant and a blue host.

The blue host may be a compound represented by Formula 202 below. Examples of the blue host may include 9,10-di-(2-naphthyl) anthracene (ADN), 2-methyl-9,10-di-(2-naphthyl) anthracene (MADN), 2-tert-butyl-9,10-bis(β-naphthyl)-anthracene (TBADN), and 9,10,10-tetraphenyl-2,2-bianthracene (TPBA).

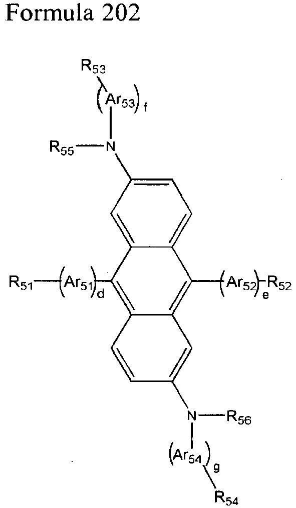

In Formula 202, Ar₅₁, A₅₂, Ar₅₃ and Ar₅₄ may each independently be a phenylene group, a naphthylene group, an anthrylene group, or a phenyl-substituted anthrylene group.

R₅₁ through R₅₆ may each independently be a hydrogen atom, a methyl group, an ethyl group, a propyl group, a butyl group, a phenyl group, a naphthyl group, an anthryl group, a pyrenyl group, a carbazolyl group, or -N(Q₂)(Q₃), wherein Q₂ and Q₃ are each independently a methyl group, a phenyl group, a naphthyl group, or an anthryl group.

In Formula 202, d, e, f, and g may each independently be an integer from 0 to 10. For example, d, e, f, and g may each independently be 0, 1, or 2.

The blue dopant may be a compound represented by Formula 201. For example, the blue dopant may be a compound represented by Formula 203 or 204.

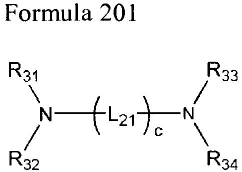

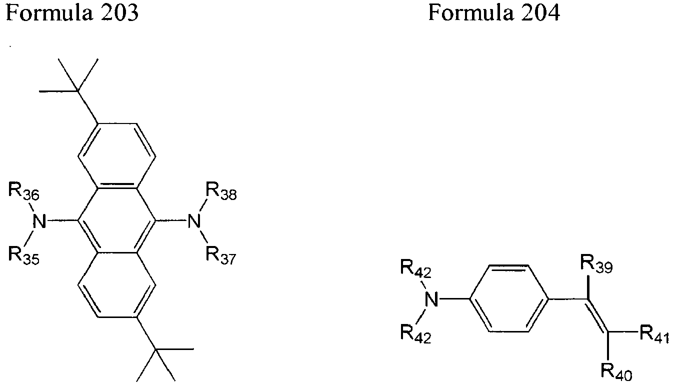

R₃₅ and R₄₂ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, or a substituted or unsubstituted C₄-C₃₀ heteroaryl group. In an implementation, R₃₅ and R₄₂ may each independently be hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₆-C₃₀ aryl group, or a substituted or unsubstituted C₄-C₃₀ heteroaryl group.

In Formula 201, L₂₁ may be a substituted or unsubstituted C₁-C₃₀ alkylene group, a substituted or unsubstituted C₂-C₃₀ alkenylene group, a substituted or unsubstituted C₅-C₃₀ arylene group, or a substituted or unsubstituted C₄-C₃₀ heteroarylene group; c may be an integer from 1 to 20; c groups of L₂₁ in -(L₂₁)_{c}- may be identical to or different from each other; and R³¹ through R₃₄ may each independently be a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₅-C₃₀ aryl group, or a substituted or unsubstituted C₄-C₃₀ heteroaryl group. In an implementation, L₂₁ may be a substituted or unsubstituted C₁-C₃₀ alkylene group, a substituted or unsubstituted C₂-C₃₀ alkenylene group, a substituted or unsubstituted C₆-C₃₀ arylene group, or a substituted or unsubstituted C₄-C₃₀ heteroarylene group; and R₃₁ through R₃₄ may each independently be a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₆-C₃₀ aryl group, or a substituted or unsubstituted C₄-C₃₀ heteroaryl group.

In Formula 201, L₂₁ may be an ethenylene group, a propenylene group, or a phenylene group.

In Formula 201, c may be 1, 2, 3, 4, 5, or 6.

In Formula 201, R₃₁ through R₃₄ may each independently be a hydrogen atom, a methyl group, an ethyl group, a propyl group, a butyl group, a methoxy group, an ethoxy group, a propoxy group, a butoxy group, a phenyl group, a naphthyl group, or an anthryl group.

In Formula 201, c groups of L₂₁ in -(L₂₁)_{c}- may be identical to or different from each other. For example, when c is 2, the two groups of L₂₁ may both be phenylene groups, or one of the two may be a phenylene group, and the other may be an ethenylene group.

The compound represented by Formula 201 may be Compound 40 below.

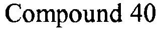

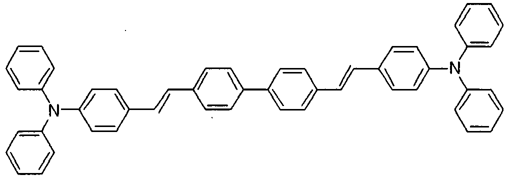

When a dopant and a host are used together as materials for the EML, the amount of the dopant may be about 0.01 to about 15 parts by weight, based on 100 parts by weight of the host.

The thickness of the EML may be about 100 to about 1000 Å, for example, about 200 to about 600 Å. With such a thickness of the EML, the EML may have excellent light emitting ability without a substantial increase in driving voltage.

When a phosphorescent dopant is also used to form the EML, a HBL may be formed between the HTL and the EML by using vacuum deposition, spin coating, casting, Langmuir-Blodgett (LB) deposition, or the like, in order to prevent diffusion of triplet excitons or holes into an ETL. When the HBL is formed using vacuum deposition or spin coating, the conditions for deposition and coating may be similar to those for the formation of the HIL, although the conditions for deposition and coating may vary according to the material that is used to form the HBL. Examples of materials for forming the HBL include an oxadiazole derivative, a triazole derivative, and a phenanthroline derivative.

The thickness of the HBL may be about 50 to 1000 Å, for example, about 100 to about 400 A. With such a thickness of the HBL, the HBL may have an excellent hole blocking ability without a substantial increase in driving voltage.

Then, an ETL may be formed on the HBL or EML by vacuum deposition, spin coating, casting, or the like. When the ETL is formed using vacuum deposition or spin coating, the deposition and coating conditions may be similar to those for formation of the HIL, although the deposition and coating conditions may vary according to a material that is used to form the ETL.

A material for forming the ETL includes an anthracene-based compound and a quinolate-based compound that can stably transport electrons injected from an electron injecting electrode (cathode).

The anthracene-based compound may be one represented by Formula 101 and Formula 102 below:

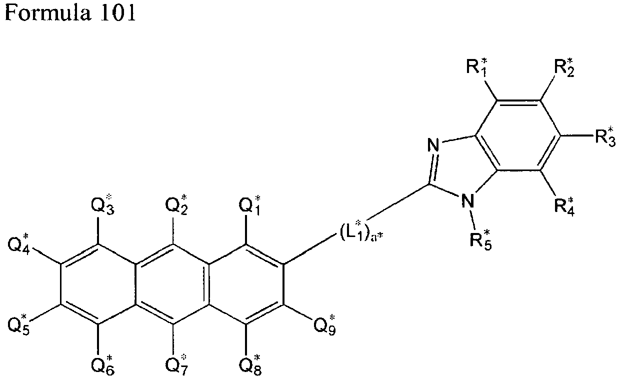

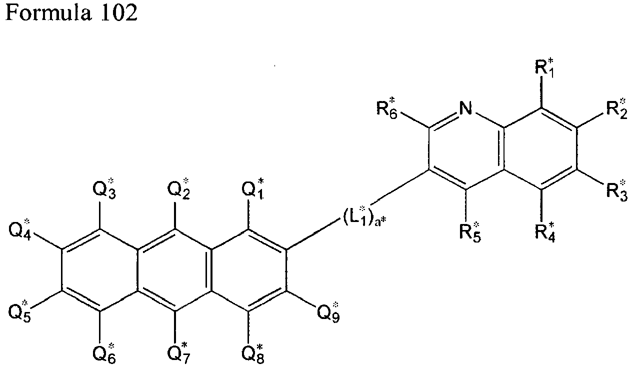

In Formulae 101 and 102, R^{*}₁ through R^{*}₆ may each independently be a hydrogen atom, a halogen atom, a hydroxyl group, a cyano group, a substituted or unsubstituted C₁-C₃₀ alkyl group, a substituted or unsubstituted C₁-C₃₀ alkoxy group, a substituted or unsubstituted C₁-C₃₀ acyl group, a substituted or unsubstituted C₂-C₃₀ alkenyl group, a substituted or unsubstituted C₂-C₃₀ alkynyl group, a substituted or unsubstituted C₆-C₃₀ aryl group, or a substituted or unsubstituted C₃-C₃₀ heteroaryl group, wherein at least two adjacent groups of R^{*}₁ through R^{*}₆ may be linked together to form a saturated or unsaturated ring; L^{*}₁ may be a single bond, a substituted or unsubstituted C₁-C₃₀ alkylene group, a substituted or unsubstituted C₆-C₃₀ arylene group, or a substituted or unsubstituted C₃-C₃₀ heteroarylene group; Q^{*}₁ through Q^{*}₉ may each independently be a hydrogen atom, a substituted or unsubstituted C₆-C₃₀ aryl group, or a substituted or unsubstituted C₃-C₃₀ heteroaryl group; and a^{*} may be an integer from 1 to 10.

For example, the anthracene-based compound may be at least one of Formula 103 and Formula 104 below.

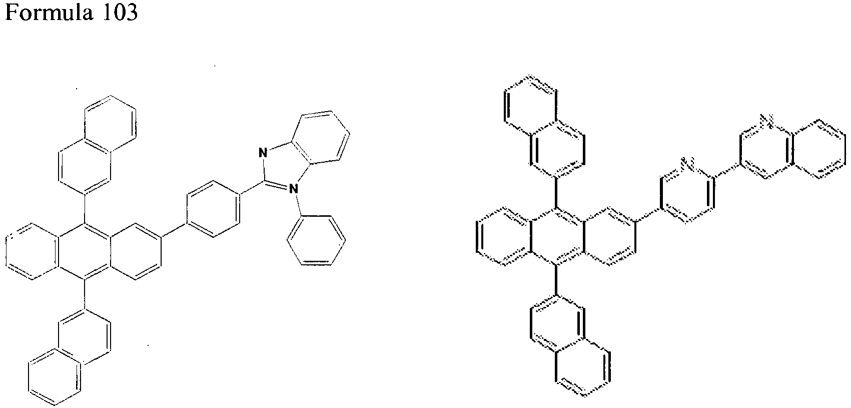

The quinolate-based compound may be lithium quinolate (LiQ).

The amounts of the anthracene-based compound and the quinolate-based compound may vary depending on the amount of holes injected from an anode to achieve optimum balance between carriers, and a ratio of the amount of the anthracene-based compound to the amount of the quinolate-based compound may be 10:5 to 10:15, for example, 10:10 taking into consideration a deposition process. As the amount of the quinolate-based compound increases, a hole blocking ability of the HBL may increase, but an electron mobility of the ETL may decrease, thereby increasing driving voltage of the OLED and reducing efficiency of the OLED. As the amount of the quinolate-based compound decreases, the ETL may exhibit dominant physical properties by the effect of the anthracene-based compound on the electron mobility of the ETL, thereby increasing driving voltage of the OLED, and reducing efficiency and lifetime of the OLED.

The thickness of the ETL may be about 100 to about 1,000 A, for example, about 150 to about 500 Å. With such a thickness of the ETL, the ETL may have satisfactory electron transporting ability without a substantial increase in driving voltage.

Then, an EIL may be formed on the ETL. The EIL may be formed of a suitable material facilitating injection of electrons from a cathode.

Examples of materials for forming the EIL include LiF, NaCl, CsF, Li₂O, and BaO, which are known in the art. Deposition and coating conditions for forming the EIL may be similar to those for the formation of the HIL, although the deposition and coating conditions may vary according to a material that is used to form the EIL.

The thickness of the EIL may be about 1 to about 100 Å, for example, about 5 to about 90 Å. With such a thickness of the EIL, the EIL may have satisfactory electron injecting ability without a substantial increase in driving voltage.

The second electrode 9 is disposed on the organic layer 7. The second electrode 9 may be a cathode, which is an electron injecting electrode. The second electrode 9 may be formed by a metal, an alloy, or an electrically conductive compound, which have a low-work function, or a mixture thereof In this regard, the second electrode 9 may be formed of lithium (Li), magnesium (Mg), aluminum (Al), aluminum (Al)-lithium (Li), calcium (Ca), magnesium (Mg)-indium (In), magnesium (Mg)-silver (Ag), or the like, and may be formed as a thin film type transmissive electrode. In addition, the transmissive electrode may be formed of indium tin oxide (ITO) or indium zinc oxide (IZO) to manufacture a top-emission type light-emitting device.

For example, the OLED may have a structure including: the first electrode; a layer including one or more cyano group-containing compounds represented by Formulae 1A through 20B, wherein the layer may further include the hole transporting compound represented by Formula 42; a HTL including the compound represented by Formula 42; an EML including a blue host (the compound represented by Formula 202) and a blue dopant (the compound represented by Formula 202); an ETL including the anthracene-based compound represented by Formula 101 and LiQ; an EIL; and a second electrode, which are sequentially stacked in this order. Thus, the OLED may emit excellent blue light due to the structure.

The OLED 10 may further include multiple HTLs between the first electrode 5 and the EML. For example, an OLED according to an embodiment may have a structure including: a substrate, a first electrode, a first HTL, a layer containing the cyano group containing compound, a second HTL, an EML, an ETL, an EIL, and a second electrode, which are sequentially stacked in this order.

In another embodiment, the OLED may include multiple layers including the cyano group-containing compound. For example, an OLED according to an embodiment may have a structure including: a substrate, a first electrode, a layer including the cyano group-containing compound, a HTL, another layer including the cyano group-containing compound, another HTL, an EML, an ETL, an EIL, and a second electrode, which are sequentially stacked in this order.

The following Examples and Comparative Examples are provided in order to set forth particular details of one or more embodiments. The Comparative Examples are set forth to highlight certain characteristics of certain embodiments.

### Comparative Example 1

A 15 Ω/cm² (1,200 Å) ITO glass substrate (available from Coming Co.) was cut to a size of 50 mm x 50 mm x 0.7 mm, ultrasonically washed with isopropyl alcohol for 5 minutes and then with pure water for 5 minutes, and washed again with UV ozone for 30 minutes. NPB was vacuum-deposited on the ITO glass substrate to form a HTL having a thickness of 750 Å.

97 wt% of Compound 56 and 3 wt% of Compound 58 were deposited on the HTL to form an EML having a thickness of 200 Å.

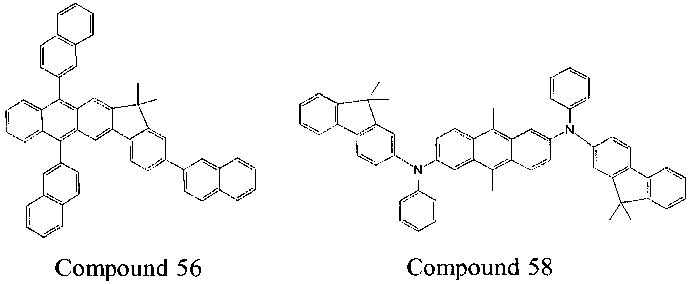

Alq₃ was vacuum-deposited on the EML to form an ETL having a thickness of 300 . LiQ was vacuum-deposited on the ETL to form an EIL having a thickness of 5 Å and Mg and Ag were vacuum-deposited on the EIL to form a cathode having a thickness of 160 Å. Next, Alq₃ was deposited on the cathode to form a protection layer having a thickness of 600 Å, thereby completing the manufacture of an OLED.

### Comparative Example 2

A 15 Ω/cm² 1200 Å) ITO glass substrate (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes.

A layer, instead of the HIL, was formed on the ITO glass substrate to a thickness of 100 Å, wherein the layer contained Compound 5 above and 1 part by weight of the compound represented by Formula 20A (R₁₀₉ is -F) based on 100 parts by weight of the layer.

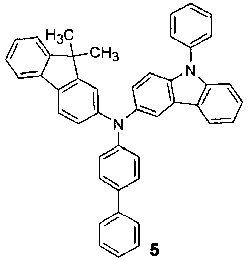

NPB was vacuum-deposited on the layer to form a HTL having a thickness of 750 Å. 97 wt% of Compound 56 above and 3 wt% of Compound 58 above were deposited on the HTL to form an EML having a thickness of 200 Å.

Alq₃ was vacuum-deposited on the EML to form an ETL having a thickness of 300 Å.

LiQ was vacuum-deposited on the ETL to form an EIL having a thickness of 5 Å and Mg and Ag were vacuum-deposited on the EIL to form a cathode having a thickness of 160 Å. Next, Alq₃ was deposited on the cathode to form a protection layer having a thickness of 600 Å, thereby completing the manufacture of an OLED.

### Comparative Example 3

A 15 Ω/cm² 1200 Å) ITO glass substrate (available from Corning Co.) was cut to a size of 50 mm x 50 mm x 0.7 mm, ultrasonically washed with isopropyl alcohol for 5 minutes and then with pure water for 5 minutes, and washed again with UV ozone for 30 minutes.

A layer, instead of the HIL, was formed on the ITO glass substrate to a thickness of 100 Å, wherein the layer contained Compound 5 above and 1 part by weight of the compound represented by Formula 20A (R₁₀₉ is -F) based on 100 parts by weight of the layer.

NPB was vacuum-deposited on the layer to form a HTL having a thickness of 750 Å. 97 wt% of 9,10-di(naphthalene-2-yl)anthracene (ADN) and 3 wt% of Compound 40 above were deposited on the HTL to form an EML having a thickness of 200 Å.

Alq₃ was vacuum-deposited on the EML to form an ETL having a thickness of 300 Å.

LiQ was vacuum-deposited on the ETL to form an EIL having a thickness of 5 Å and Mg and Ag were vacuum-deposited on the EIL to form a cathode having a thickness of 160 Å. Next, Alq₃ was deposited on the cathode to form a protection layer having a thickness of 600 Å, thereby completing the manufacture of an OLED.

### Example 1

A 15 Ω/cm² (1,200 Å) ITO glass substrate (available from Coming Co.) was cut to a size of 50 mm x 50 mm x 0.7 mm, ultrasonically washed with isopropyl alcohol for 5 minutes and then with pure water for 5 minutes, and washed again with UV ozone for 30 minutes.

A layer, instead of the HIL, was formed on the ITO glass substrate to a thickness of 100 Å, wherein the layer contained Compound 5 above and 1 part by weight of the compound represented by Formula 20A (R₁₀₉ is -F) based on 100 parts by weight of the layer.

NPB was vacuum-deposited on the layer to form a HTL having a thickness of 750 Å. 97 wt% of 9,10-di(naphthalene-2-yl)anthracene (ADN) and 3 wt% of Compound 40 above were deposited on the HTL to form an EML having a thickness of 200 Å.

ADN and LiQ were vacuum-deposited on the EML to form an ETL having a thickness of 300 Å.

LiQ was vacuum-deposited on the ETL to form an EIL having a thickness of 5 Å, and Mg and Ag were vacuum-deposited on the EIL to form a cathode having a thickness of 160 Å. Next, Alq₃ was deposited on the cathode to form a protection layer having a thickness of 600 Å, thereby completing the manufacture of an OLED.

### Example 2

An OLED was manufactured in the same manner as in Example 1, except that 3 parts by weight of the compound represented by Formula 20A was used based on 100 parts by weight of the layer.

### Evaluation example

Driving voltages of the OLEDs manufactured according to Comparative Examples 1 through 3 and Examples 1 and 2 were measured using a 238 High-Current Source-Measure unit (available from Keithley Instruments Inc.), and current efficiency and power efficiency thereof were measured using a PR650 Spectroscan Source Measurement Unit (available from PhotoResearch, Inc.). The results are shown in Table 1 below.

**Table 1**

| | Driving voltage (V) | current efficiency (Cd/A) | Color coordinate weight-calculated efficiency (Cd/Ay) |
|---|---|---|---|
| Comparative Example 1 | 3.8 | 2.9 | 58 |
| Comparative Example 2 | 3.8 | 3.5 | 76 |
| Comparative Example 3 | 3.9 | 3.7 | 81 |
| Example 1 | 4.1 | 5.4 | 102 |
| Example 2 | 3.8 | 7.15 | 130 |

Referring to Table 1, the OLEDs of Examples 1 and 2 were found to have lower driving voltages, and higher current efficiency and power efficiency, as compared to the OLEDs of Comparative Examples 1 through 3.

As described above, an OLED according to the present invention has an excellent driving voltage characteristics, emission efficiency characteristics and power efficiency characteristics.

## Claims

1. An organic light-emitting device (10), comprising:
a substrate (1);
a first electrode (5) disposed on the substrate (1);
a second electrode (9);
an organic layer (7) disposed between the first electrode (5) and the second electrode (9), the organic layer (7) including a hole transport layer (HTL), an emission layer (EML) and an electron transport layer (ETL); and
a layer (6) disposed between the first electrode (5) and the hole transport layer (HTL), the layer (6) including at least one cyano group-containing compound, **characterized in that** the electron transport layer (ETL) includes an anthracene-based compound and a quinolate-based compound,
wherein the layer (6) further includes a hole transporting compound and the hole transporting compound is one of Formula 42 and Compounds 1 through 37: 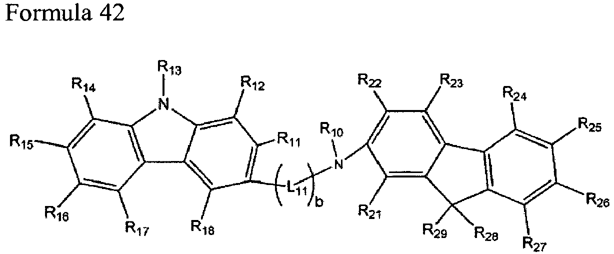 wherein, in Formula 42,
R₁₀ is represented by -(Ar₁)ₙ-Ar₂;
R₁₆ is represented by -(Ar₁₁)ₘ-Ar₁₂;
Ar₁, Ar₁₁, and L₁₁ are each independently a substituted or unsubstituted C₁-C₃₀ alkylene group, a substituted or unsubstituted C₂-C₃₀ alkenylene group, a substituted or unsubstituted C₅-C₃₀ arylene group, a substituted or unsubstituted C₄-C₃₀ heteroarylene group, or -N(Q₁)-;
n, m, and b are each independently an integer from 0 to 10;
R₁₁ through R₁₅, R₁₇, R₁₈, R₂₁ through R₂₉, Ar₂, Ar₁₂, and Q₁ are each independently hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, a C₄-_{C30} heteroaryl group, or -N(Q₂)(Q₃);
Q₂ and Q₃ are each independently hydrogen, a halogen atom, a hydroxyl group, a cyano group, a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₁-C₃₀ alkylthiol group, a substituted or unsubstituted C₅-C₃₀ aryl group, or a substituted or unsubstituted C₄-C₃₀ heteroaryl group; and
n groups of Ar₁ in -(Ar₁)ₙ- are identical to or different from each other, m groups of Ar₁₁ in -(Ar₁₁)ₘ- are identical to or different from each other, and b groups of L₁₁ in -(L₁₁)_{b}- are identical to or different from each other;

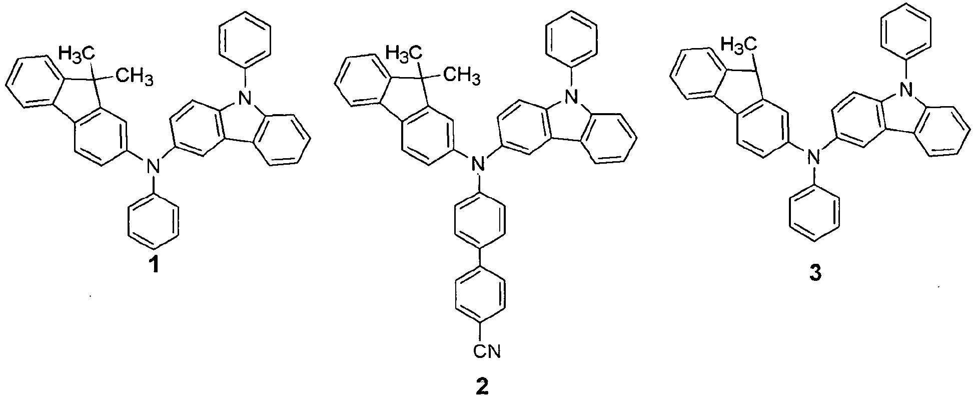

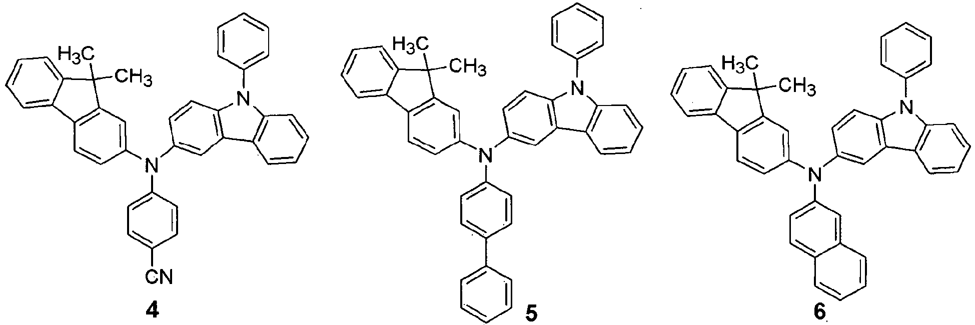

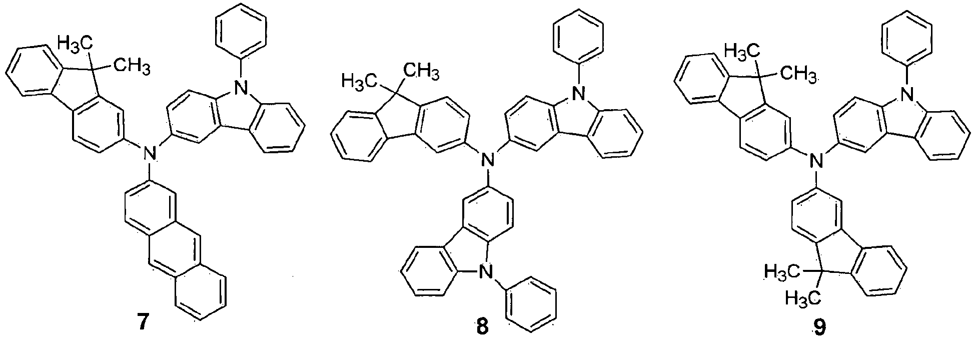

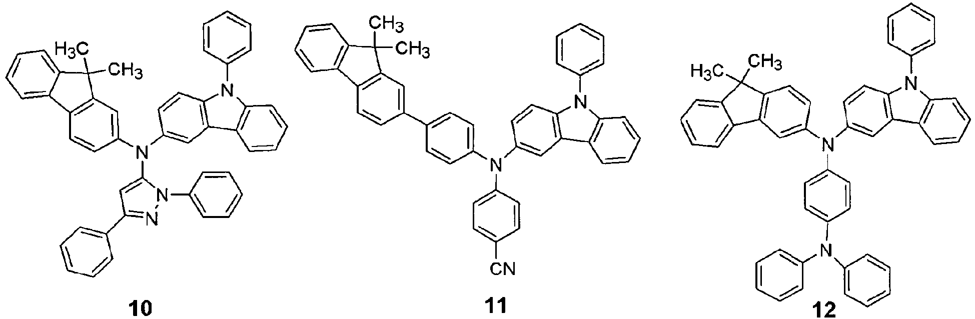

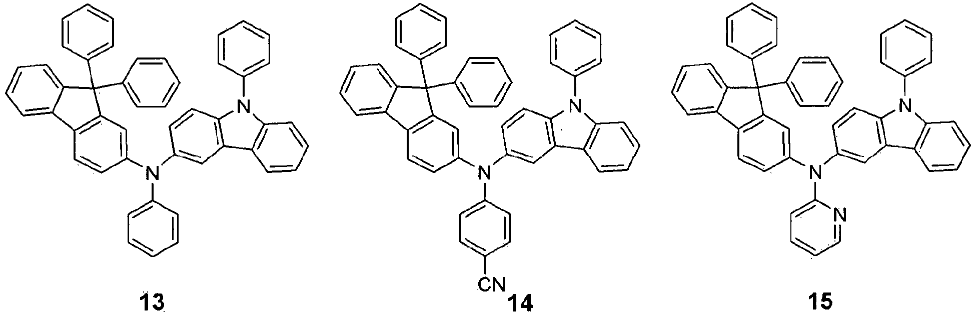

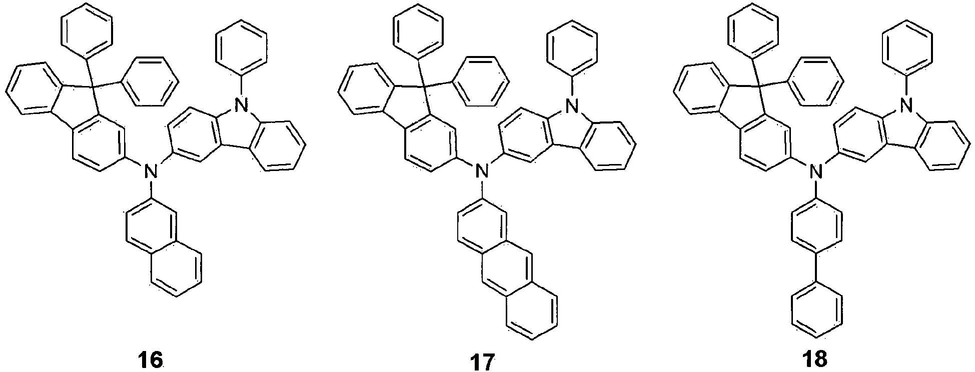

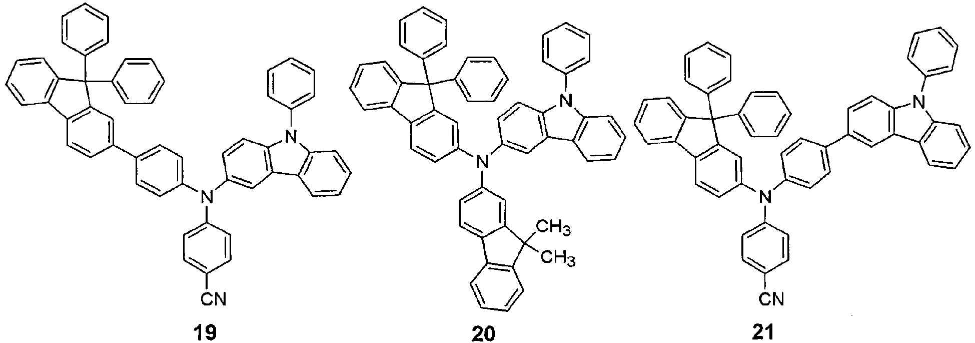

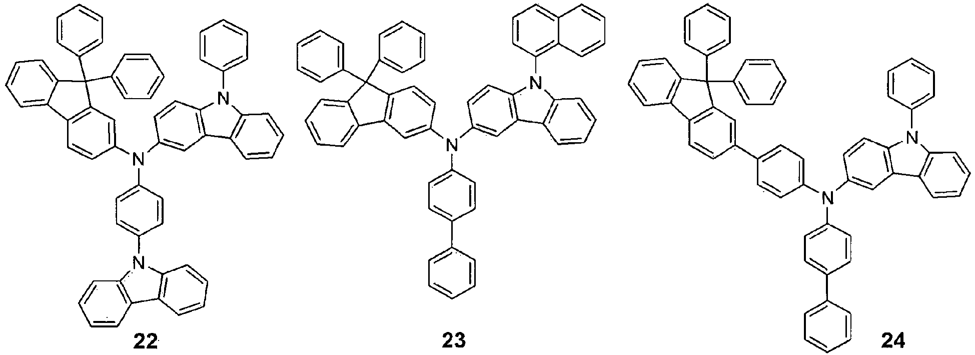

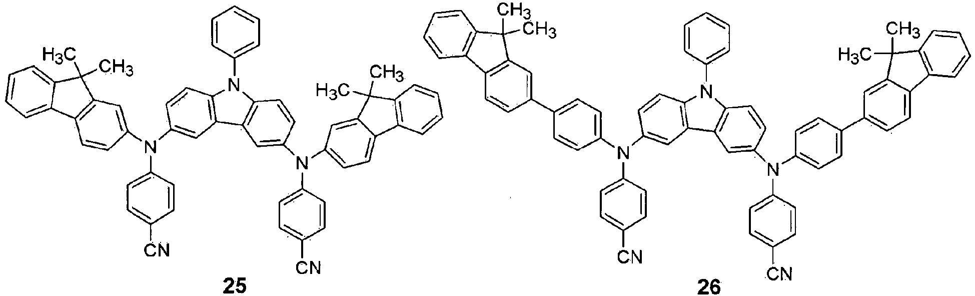

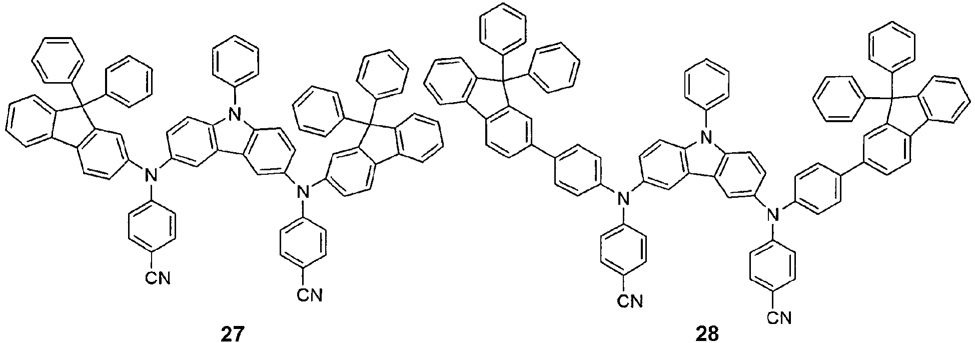

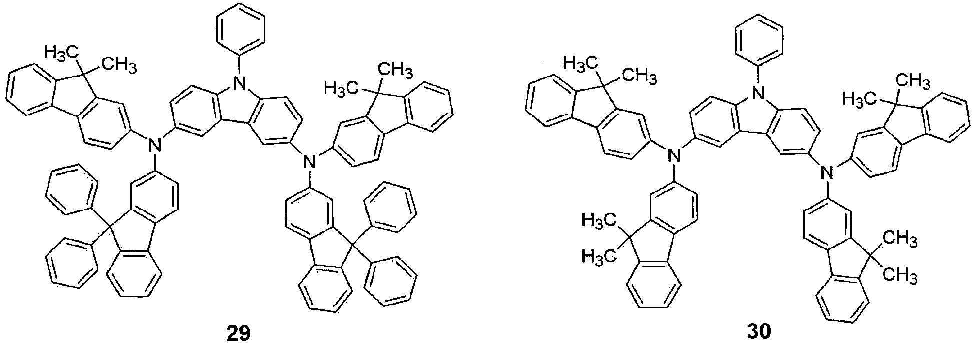

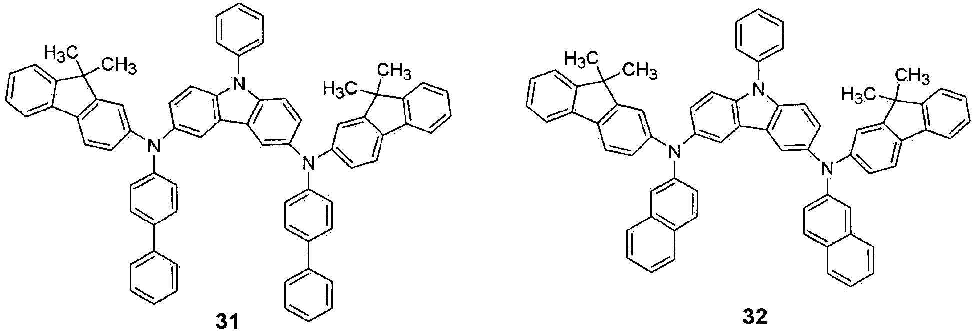

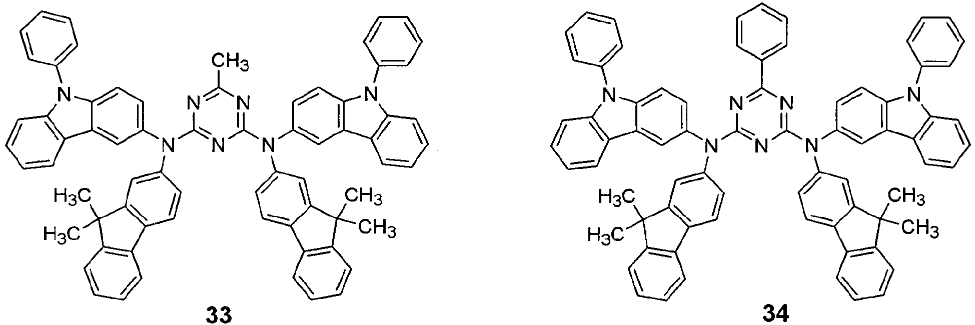

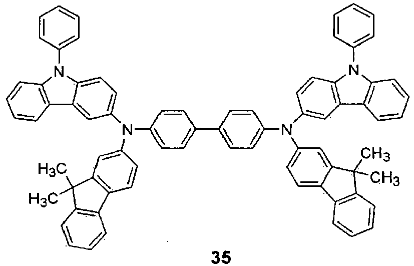

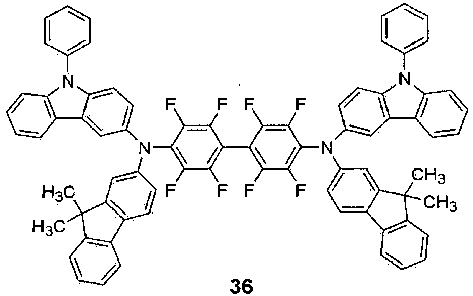

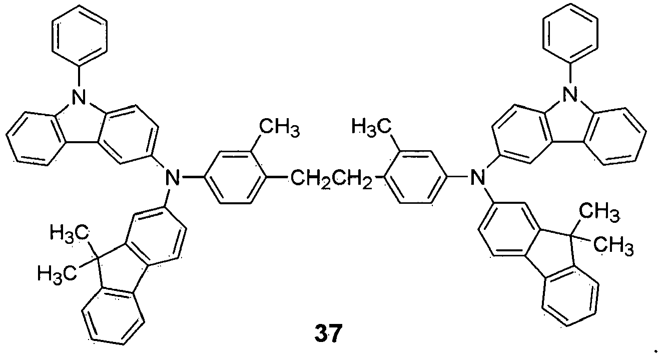

2. The organic light-emitting device as claimed in claim 1, wherein the cyano group-containing compound is one of Formulae 1 through 20: 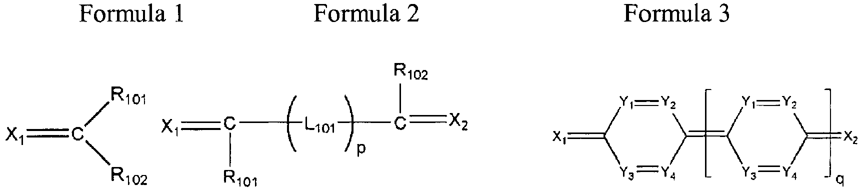 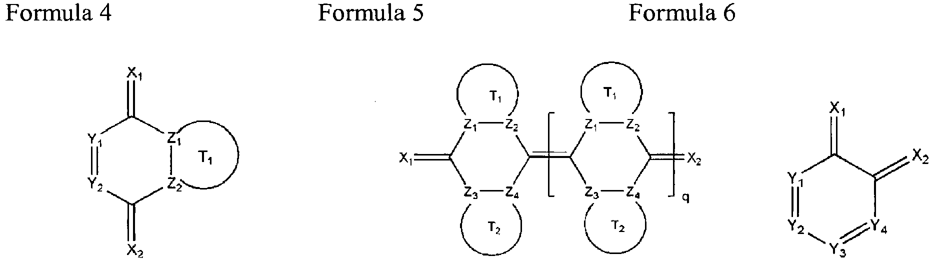 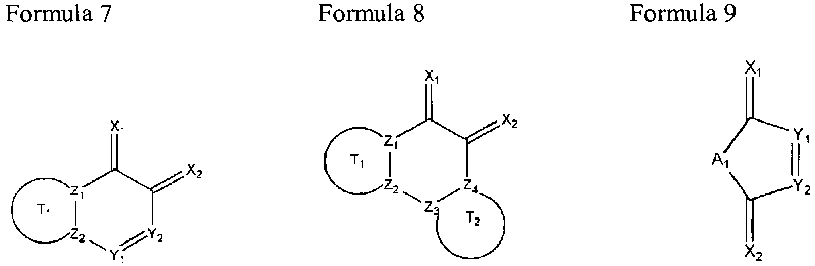 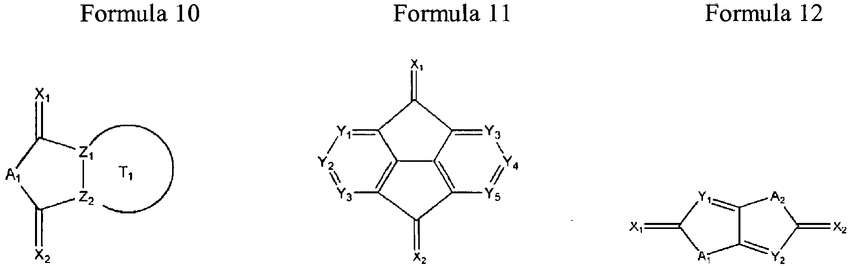 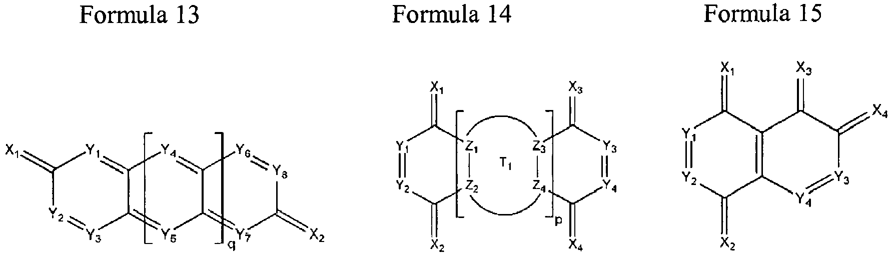 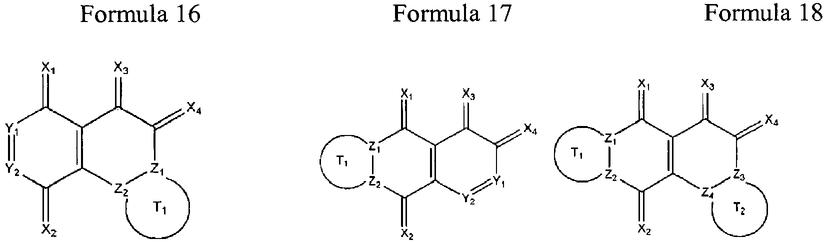 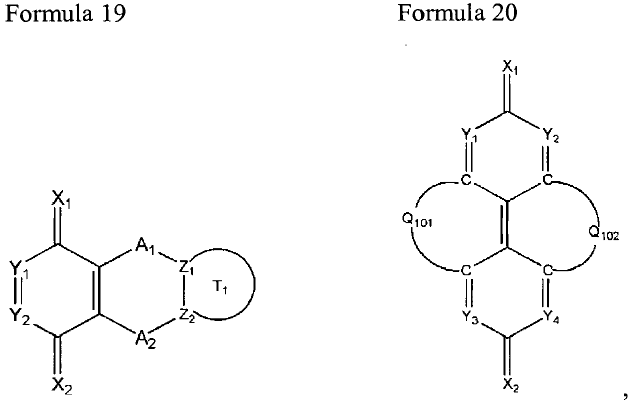 and wherein, in Formulae 1 through 20,
X₁ through X₄ are each independently compounds represented by Formulae 30A through 30D below;
Y₁ through Y₈ are each independently N or C(R₁₀₃);
Z₁ through Z₄ are each independently C or N;
A₁ and A₂ are each independently -O-, -S-, -N(R₁₀₄), or -C(R₁₀₅)(R₁₀₆)-;
Q₁₀₁ and Q₁₀₂ are each independently a C₂-C₁₀ alkylene group; a C₂-C₁₀ alkenylene group; or a substituted C₂-C₁₀ alkylene group or a substituted C₂-C₁₀ alkenylene group which have at least one substituent that is a halogen atom, a cyano group, a hydroxyl group, a C₁-C₁₀ alkyl group, or a C₁-C₁₀ alkoxy group;
T₁ and T₂ are each independently a C₅-C₃₀ aromatic ring system; a C₂-C₃₀ heteroaromatic ring system; or a substituted C₅-C₃₀ aromatic ring system or a substituted C₂-C₃₀ heteroaromatic ring system which have at least one substituent that is a halogen atom, a cyano group, a hydroxyl group, a C₁-C₁₀ alkyl group, or a C₁-C₁₀ alkoxy group;
p is an integer from 1 to 10;
q is an integer from 0 to 10;
R₁₀₁ through R₁₀₆ are each independently hydrogen; a halogen atom; a cyano group; a hydroxyl group; a C₁-C₁₀ alkyl group; a C₁-C₁₀ alkoxy group; a substituted C₁-C₁₀ alkyl group or a substituted C₁-C₁₀ alkoxy group which have at least one substituent that is a halogen atom, a cyano group, a hydroxyl group, a C₅-C₁₄ aryl group, or a C₂-C₁₄ heteroaryl group; 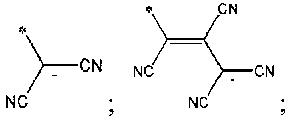 or -N(R₁₀₇)(R₁₀₈), wherein R₁₀₇ and R₁₀₈ are each independently hydrogen, a C₁-C₁₀ alkyl group, a phenyl group, or a biphenyl group;
L₁₀₁ is a C₅-C₁₄ arylene group; a C₅-C₁₄ heteroarylene group; or a substituted C₂-C₁₀ alkenylene group, a substituted C₅-C₁₄ arylene group, or a substituted C₅-C₁₄ heteroarylene group which have at least one substituent that is a halogen atom, a cyano group, a hydroxyl group, a C₁-C₁₀ alkyl group, or a C₁-C₁₀ alkoxy group,

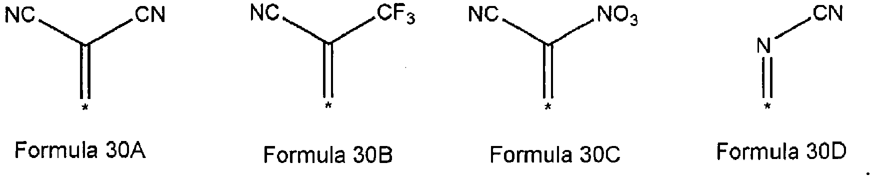

3. The organic light-emitting device as claimed in claim 2, wherein X₁ through X₄ are each independently the compound represented by Formula 30A or the compound represented by Formula 30D.

4. The organic light-emitting device as claimed in claim 2, wherein in Formulae 3, 4, 6, 7, 9, 11 - 17, 19 and 20 R₁₀₃ is hydrogen; a halogen atom; a cyano group; a C₁-C₁₀ alkyl group; a C₁-C₁₀ alkoxy group; a substituted C₁-C₁₀ alkyl group or a substituted C₁-C₁₀ alkoxy group which have at least one substituent that is a halogen atom, a cyano group, a phenyl group, a naphthyl group, an anthryl group, a pyridinyl group, a thiophenyl group, or a benzothiophenyl group; or -N(R₁₀₇)(R₁₀₈), wherein R₁₀₇ and R₁₀₈ are each independently hydrogen, a C₁-C₁₀ alkyl group, a phenyl group, or a biphenyl group.

5. The organic light-emitting device as claimed in claim 2, wherein in Formulae 4, 5, 7, 8, 10, 14 and 16 - 19 T₁ and T₂ are each independently benzene; naphthalene; anthracene; thiophene; thiadiazole; oxadiazole; or a substituted benzene, a substituted naphthalene, a substituted anthracene, a substituted thiophene, a substituted thiadiazole, or a substituted oxadiazole which have at least one substituent that is a halogen atom, a cyano group, a C₁-C₁₀ alkyl group, or a C₁-C₁₀ alkoxy group.

6. The organic light-emitting device as claimed in claim 2, wherein in Formula 2 L₁₀₁ is a thiophenylene group; a benzothiophenylene group; or a substituted thiophenylene group or a substituted benzothiophenylene group which have at least one substituent that is a halogen atom, a cyano group, or a C₁-C₁₀ alkyl group.

7. The organic light-emitting device as claimed in claim 2, wherein the cyano group-containing compound is one of Formulae 1A through 20B: 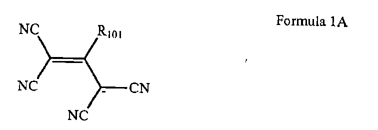 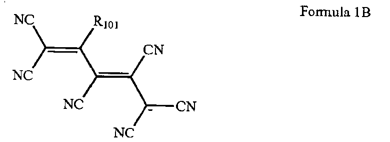 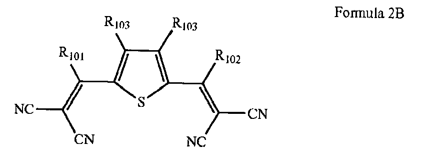 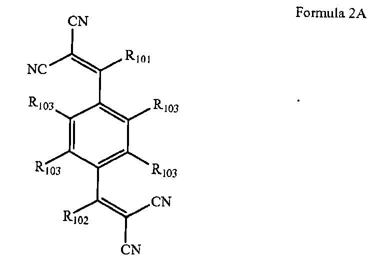 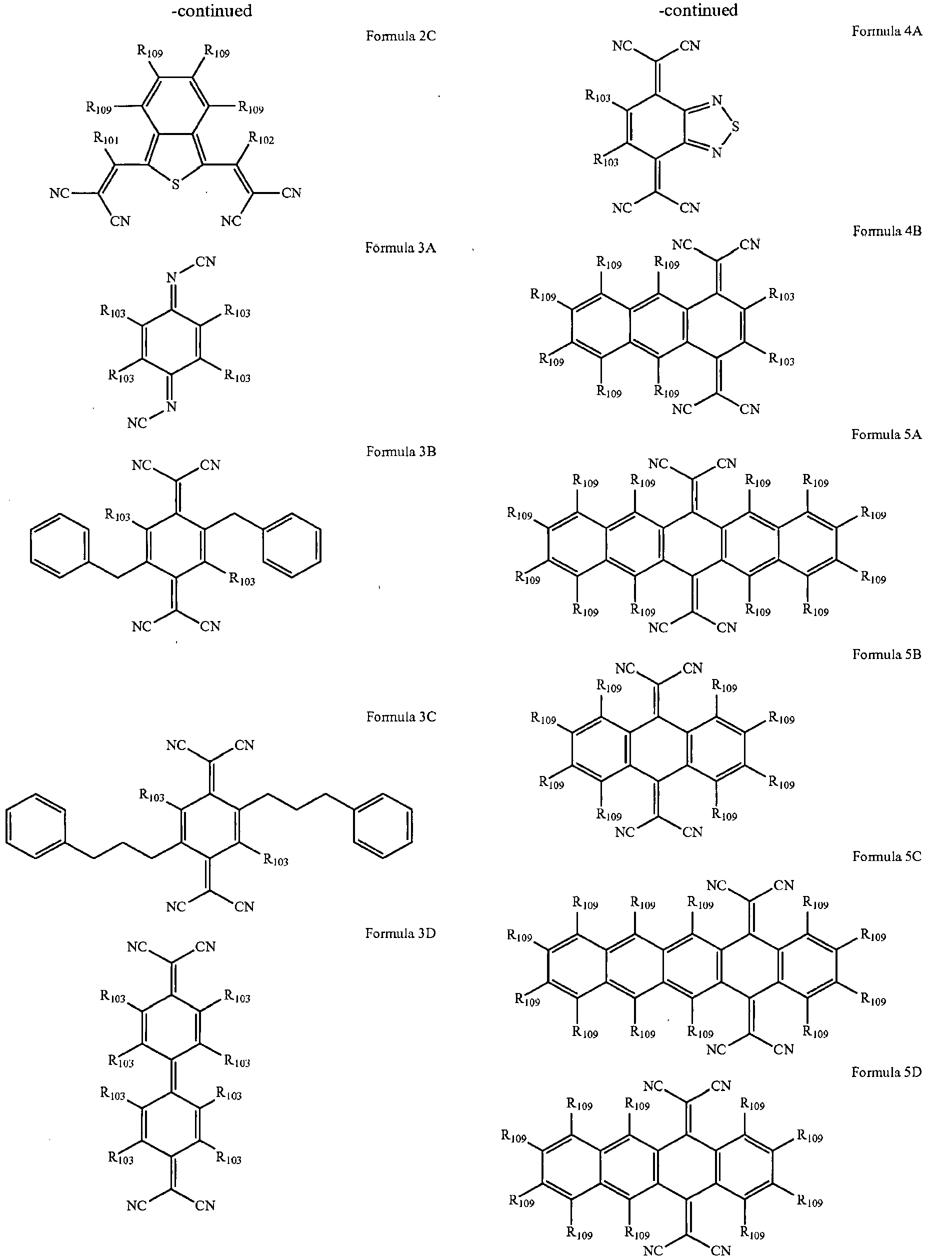 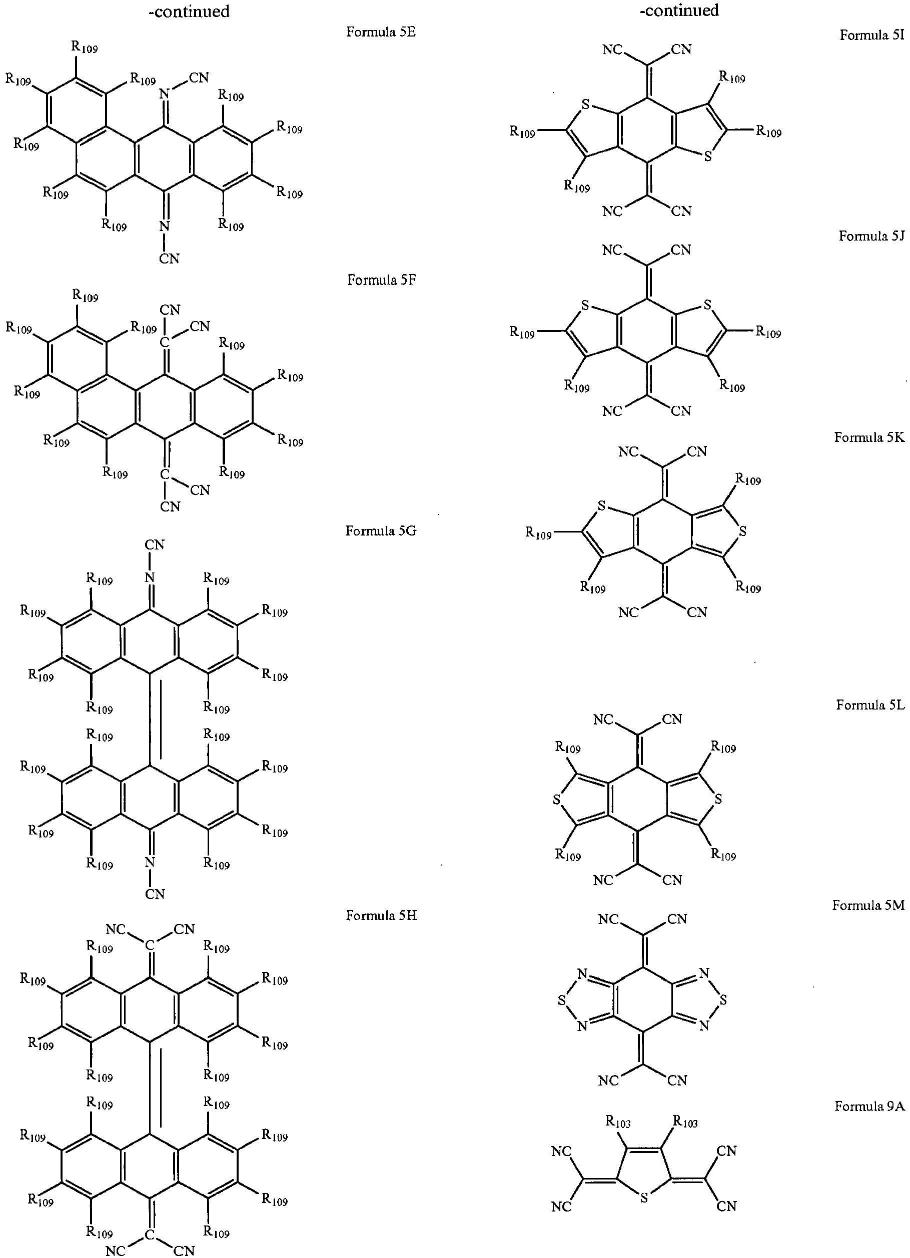 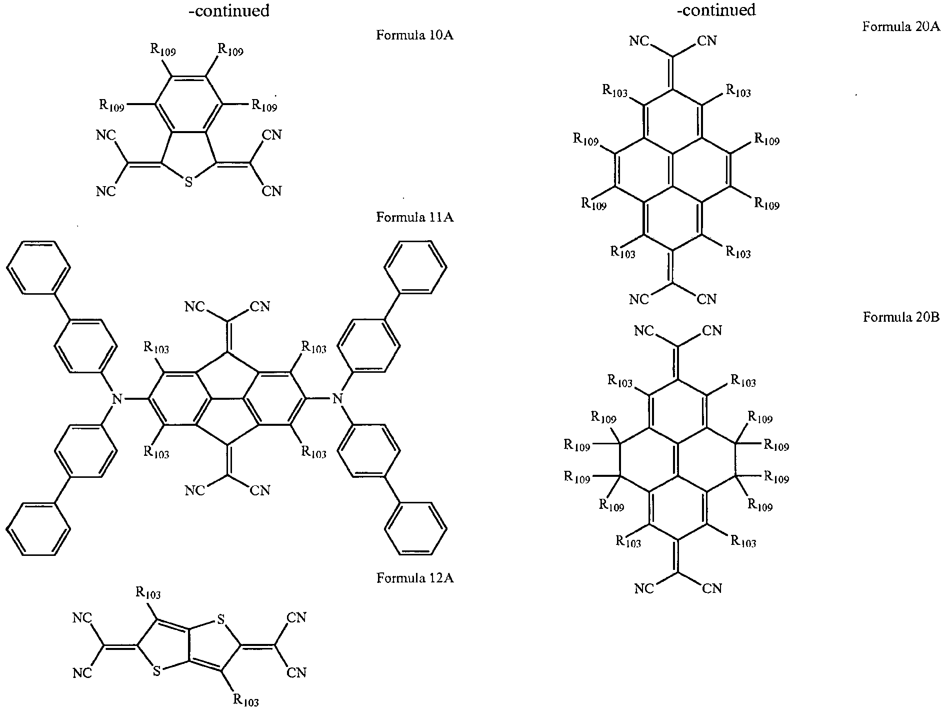 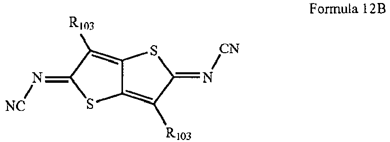 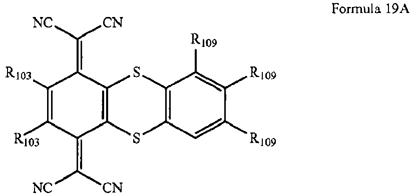 wherein, in Formulae 1A through 20B, R₁₀₃ and R₁₀₉ are each independently a hydrogen atom, -F, a cyano group, a methyl group, an ethyl group, a propyl group, a ethenyl group, a methoxy group, an ethoxy group, or a propoxy group.

8. The organic light-emitting device as claimed in claim 1, wherein in Formula 42 Ar₁ and Ar₁₁ are each independently a C₁-C₁₀ alkylene group; a phenylene group; a naphthylene group; an anthrylene group; a fluorenylene group; a carbazolylene group; a pyrazolylene group; a pyridinylene group; a triazinylene group; -N(Q₁)-; or a substituted C₁-C₁₀ alkylene group, a substituted phenylene group, a substituted naphthylene group, a substituted anthrylene group, a substituted fluorenylene group, a substituted carbazolylene group, a substituted pyrazolylene group, a substituted pyridinylene group, or a substituted triazinylene group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group; and
Q₁ is hydrogen; a C₁-C₁₀ alkyl group; a phenyl group; a naphthyl group; a carbazolyl group; a fluorenyl group; or a substituted C₁-C₁₀ alkyl group, a substituted C₁-C₁₀ alkoxy group, a substituted phenyl group, a substituted naphthyl group, a substituted carbazolyl group, or a substituted fluorenyl group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group.

9. The organic light-emitting device as claimed in claim 1, wherein Ar₂ and Ar₁₂ are each independently hydrogen; a C₁-C₁₀ alkyl group; a phenyl group; a naphthyl group; a carbazolyl group; a fluorenyl group; a pyrenyl group; a substituted C₁-C₁₀ alkyl group, a substituted C₁-C₁₀ alkoxy group, a substituted phenyl group, a substituted naphthyl group, a substituted carbazolyl group, a substituted fluorenyl group, or a substituted pyrenyl group which have at least one substituent that is a halogen atom, a cyano group, a hydroxyl group, a C₁-C₁₀ alkyl group, a C₁-C₁₀ alkoxy group, a phenyl group, a naphthyl group, or an anthryl group; or -N(Q₂)(Q₃), wherein Q₂ and Q₃ are each independently hydrogen, a methyl group, an ethyl group, a phenyl group, a methylphenyl group, a biphenyl group, a naphthyl group, or a methylnaphthyl group.

10. The organic light-emitting device of any of the preceding claims, wherein the amount of the cyano group-containing compound in the layer (6) is 0.1 to 20 parts by weight, based on 100 parts by weight of the layer (6).

11. The organic light-emitting device of any of the preceding claims, wherein the layer (6) has a thickness of 10 Å to 2100 Å.

12. The organic light-emitting device of any of the preceding claims, wherein a distance between the layer (6) and the emission layer is 50 Å or greater.

13. The organic light-emitting device as claimed in claim 1, wherein the anthracene-based compound is one of Formula 101 and Formula 102 below, and the quinolate-based compound is lithium quinolate (LiQ), 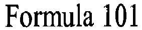 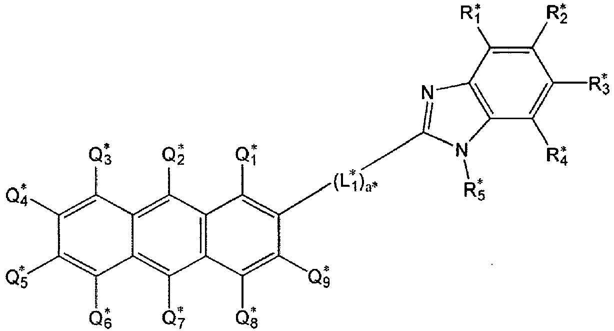 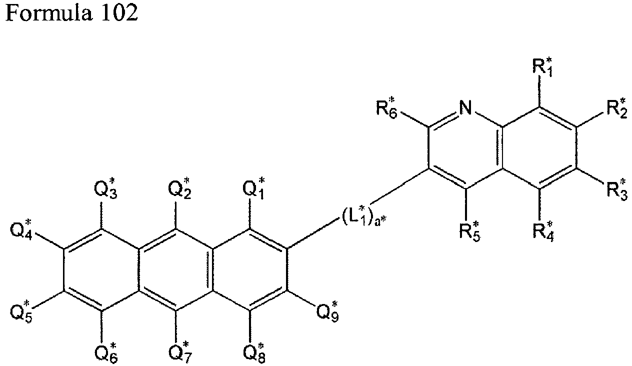 wherein, in Formulae 101 and 102,
R^{*}₁ through R^{*}₆ are each independently a hydrogen atom, a halogen atom, a hydroxy group, a cyano group, a substituted or unsubstituted C₁-C₃₀ alkyl group, a substituted or unsubstituted C₁-C₃₀ alkoxy group, a substituted or unsubstituted C₁-C₃₀ acyl group, a substituted or unsubstituted C₂-C₃₀ alkenyl group, a substituted or unsubstituted C₂-C₃₀ alkynyl group, a substituted or unsubstituted C₆-C₃₀ aryl group, or a substituted or unsubstituted C₃-C₃₀ heteroaryl group, wherein at least two adjacent groups of R^{*}₁ through R^{*}₆ are linked to form a saturated or unsaturated ring;
L^{*}₁ is a single bond, a substituted or unsubstituted C₁-C₃₀ alkylene group, a substituted or unsubstituted C₆-C₃₀ arylene group, or a substituted or unsubstituted C₃-C₃₀ hetero arylene group;
Q^{*}₁ through Q^{*}₉ are each independently a hydrogen atom, a substituted or unsubstituted C₆-C₃₀ aryl group, or a substituted or unsubstituted C₃-C₃₀ heteroaryl group; and
a^{*} is an integer from 1 to 10.

14. The organic light-emitting device as claimed in claim 1, wherein the anthracene-based compound is one of Formula 103 and Formula 104 below, and the quinolate-based compound is lithium quinolate (LiQ),

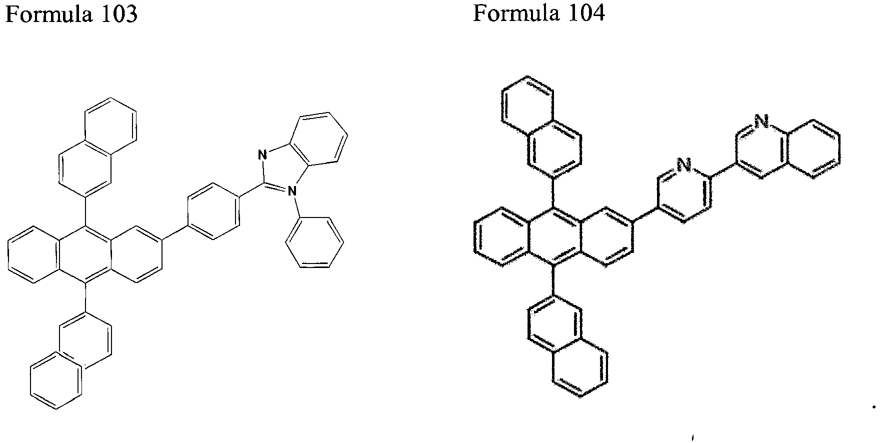

15. The organic light-emitting device of one of claim 1, wherein the amount of the anthracene-based compound is 50 to 150 parts by weight, based on 100 parts by weight of the quinolate-based compound.

16. The organic light-emitting device of any of the preceding claims, wherein the emission layer (EML) includes a blue dopant and a blue host.

17. The organic light-emitting device as claimed in claim 16, wherein the emission layer includes a blue dopant falling under Formula 201 below and a blue host falling under Formula 202 below, 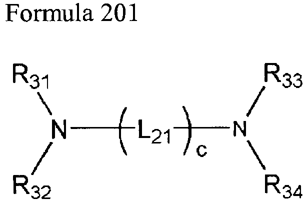 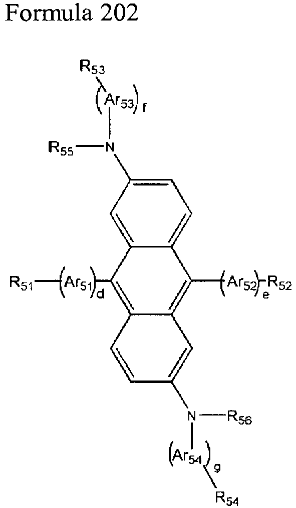 wherein, in Formulae 201 and 202,
L₂₁ is a substituted or unsubstituted C₁-C₃₀ alkylene group, a substituted or unsubstituted C₂-C₃₀ alkenylene group, a substituted or unsubstituted C₅-C₃₀ arylene group, or a substituted or unsubstituted C₄-C₃₀ heteroarylene group;
c is an integer from 1 to 20;
R₃₁ through R₃₄ are each independently a substituted or unsubstituted C₁-C₃₀ alkyl group, a substituted or unsubstituted C₂-C₃₀ alkenyl group, a substituted or unsubstituted C₂-C₃₀ alkynyl group, a substituted or unsubstituted C₁-C₃₀ alkoxy group, a substituted or unsubstituted C₅-C₃₀ aryl group, or a substituted or unsubstituted C₄-C₃₀ heteroaryl group.
c groups of L₂₁ in -(L₂₁)_{c}- are identical to or different from each other;
Ar₅₁, A₅₂, Ar₅₃, and Ar₅₄ are each independently a phenylene group, a naphthylene group, an anthrylene group, or a phenyl-substituted anthrylene group,
R₅₁ through R₅₆ are each independently a hydrogen atom, a methyl group, an ethyl group, a propyl group, a butyl group, a phenyl group, a naphthyl group, an anthryl group, a pyrenyl group, a carbazolyl group, or -N(Q₂)(Q₃), wherein Q₂ and Q₃ are each independently a methyl group, a phenyl group, a naphthyl group, or an anthryl group; and
d, e, f, and g are each independently an integer from 0 to 10.

## Patentansprüche

1. Organische lichtemittierende Vorrichtung (10), aufweisend:
ein Substrat (1);
eine erste Elektrode (5), die auf dem Substrat (1) angeordnet ist;
eine zweite Elektrode (9);
eine organische Schicht (7), die zwischen der ersten Elektrode (5) und der zweiten Elektrode (9) angeordnet ist, wobei die organische Schicht (7) eine Lochtransportschicht (HTL), eine Emissionsschicht (EML) und eine Elektronentransportschicht (ETL) aufweist; und
eine Schicht (6), die zwischen der ersten Elektrode (5) und der Lochtransportschicht (HTL) angeordnet ist, wobei die Schicht (6) zumindest eine Cyanogruppen enthaltende Verbindung aufweist, **dadurch gekennzeichnet, dass** die Elektronentransportschicht (ETL) eine Verbindung auf Anthracenbasis und eine Verbindung auf Chinolatbasis aufweist,
wobei die Schicht (6) ferner eine Lochtransportverbindung aufweist und die Lochtransportverbindung eine der Formel 42 und der Verbindungen 1 bis 37 ist: 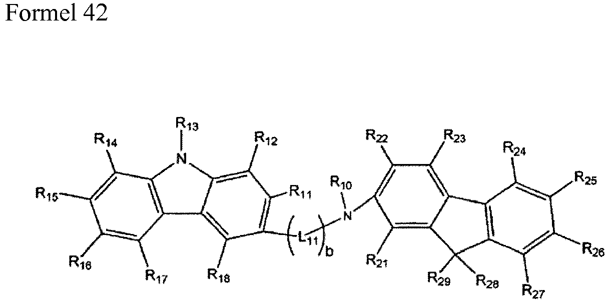 wobei in Formel 42
R₁₀ durch -(Ar₁)ₙ-Ar₂ dargestellt ist;
R₁₆ durch -(Ar₁₁)ₘ-Ar₁₂ dargestellt ist;
Ar₁, Ar₁₁ und L₁₁ jeweils unabhängig voneinander eine substituierte oder unsubstituierte C₁-C₃₀-Alkylengruppe, eine substituierte oder unsubstituierte C₂-C₃₀-Alkenylengruppe, eine subsituierte oder unsubstituierte C₅-C₃₀-Arylengruppe, eine substituierte oder unsubstituierte C₄-C₃₀-Heteroarylengruppe oder -N(Q₁)- sind;
n, m und b jeweils unabhängig voneinander eine Ganzzahl von 0 bis 10 sind;
R₁₁ bis R₁₅, R₁₇, R₁₈, R₂₁ bis R₂₉, Ar₂, Ar₁₂ und Q₁ jeweils unabhängig voneinander Wasserstoff, ein Halogenatom, eine Hydroxylgruppe, eine Cyanogruppe, eine substituierte oder unsubstituierte C₁-C₃₀-Alkylgruppe, eine substituierte oder unsubstituierte C₂-C₃₀-Alkenylgruppe, eine substituierte oder unsubstituierte C₂-C₃₀-Alkynylgruppe, eine substituierte oder unsubstituierte C₁-C₃₀-Alkoxygruppe, eine substituierte oder unsubstituierte C₁-C₃₀-Alkylthiolgruppe, eine substituierte oder unsubstituierte C₅-C₃₀-Arylgruppe, eine C₄-C₃₀-Heteroarylgruppe oder -N(Q₂)(Q₃) sind
Q₂ und Q₃ jeweils unabhängig voneinander Wasserstoff, ein Halogenatom, eine Hydroxylgruppe, eine Cyanogruppe, eine substituierte oder unsubstituierte C₁-C₃₀-Alkylgruppe, eine substituierte oder unsubstituierte C₂-C₃₀-Alkenylgruppe, eine substituierte oder unsubstituierte C₂-C₃₀-Alkynylgruppe, eine substituierte oder unsubstituierte C₁-C₃₀-Alkoxygruppe, eine substituierte oder unsubstituierte C₁-C₃₀-Alkylthiolgruppe, eine substituierte oder unsubstituierte C₅-C₃₀-Arylgruppe oder eine substituierte oder unsubstituierte C₄-C₃₀-Heteroarylgruppe sind; und
n Gruppen von Ar₁ in -(Ar₁)ₙ identisch oder voneinander verschieden sind, m Gruppen von Ar₁₁ in -(Ar₁₁)ₘ- identisch oder voneinander verschieden sind und b Gruppen von L₁₁ in -(L₁₁)_{b}- identisch oder voneinander verschieden sind;

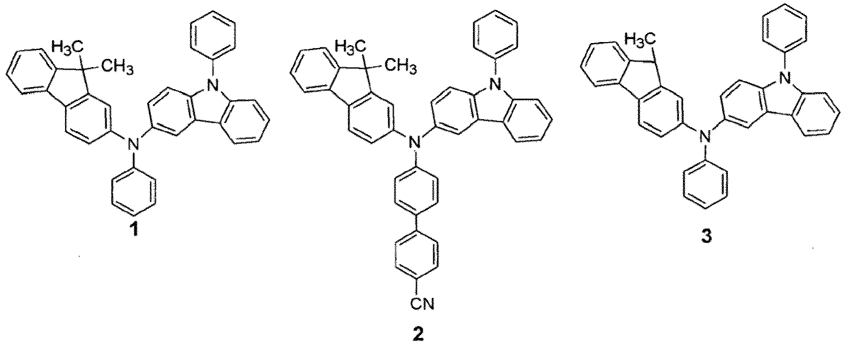

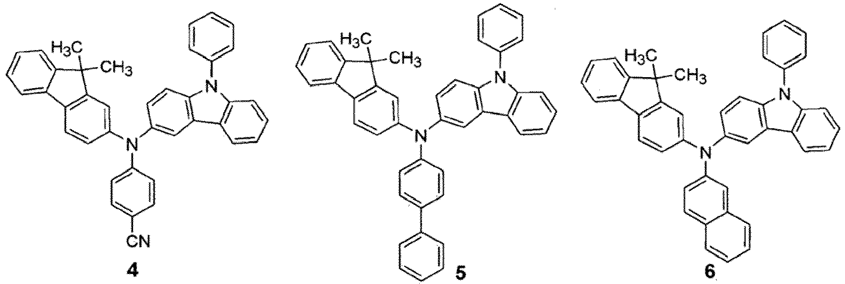

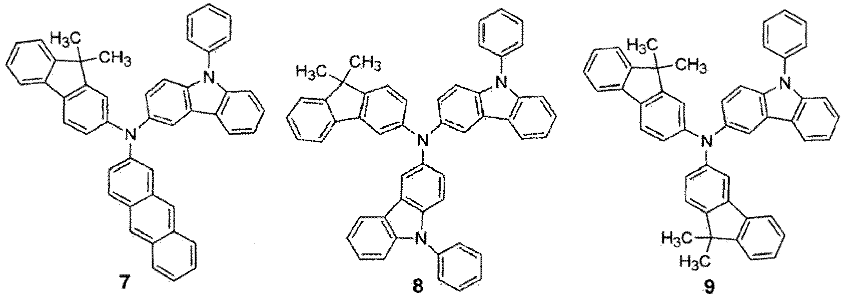

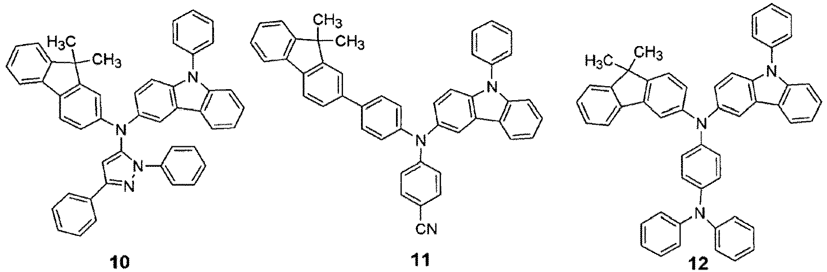

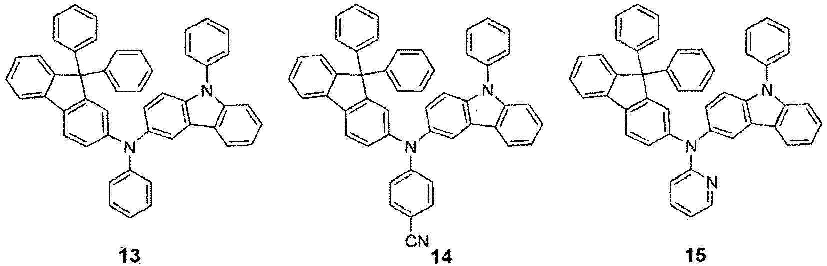

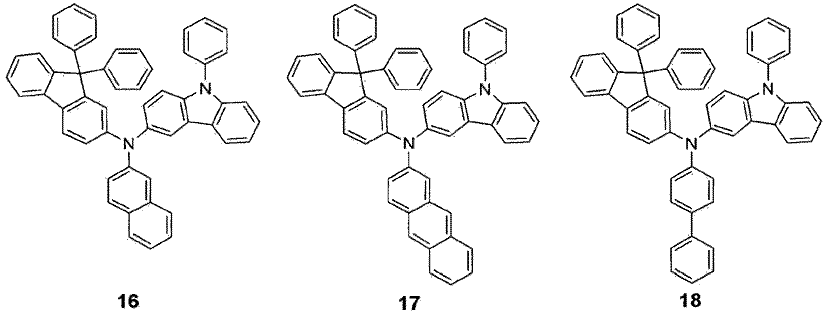

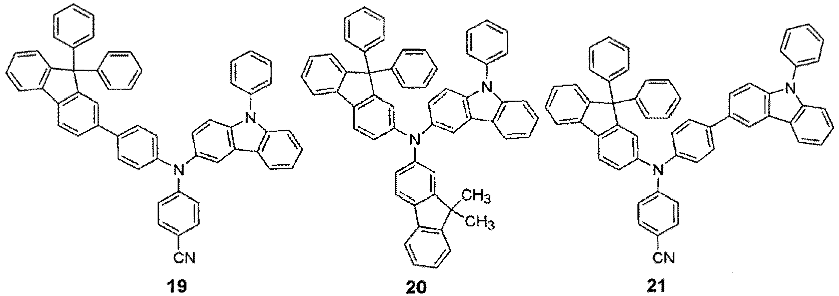

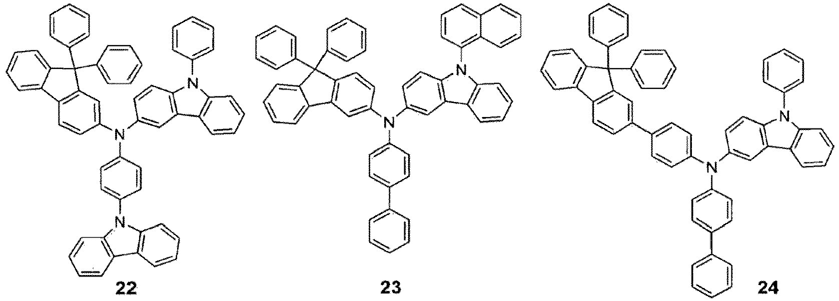

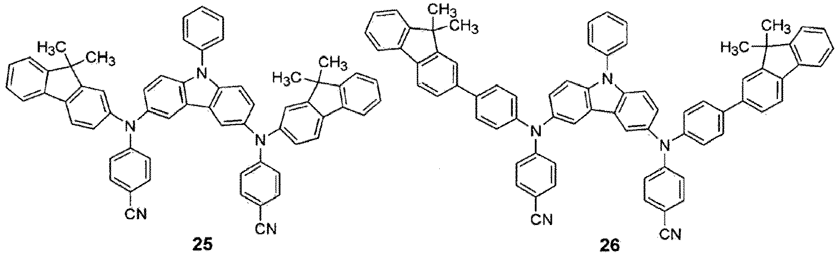

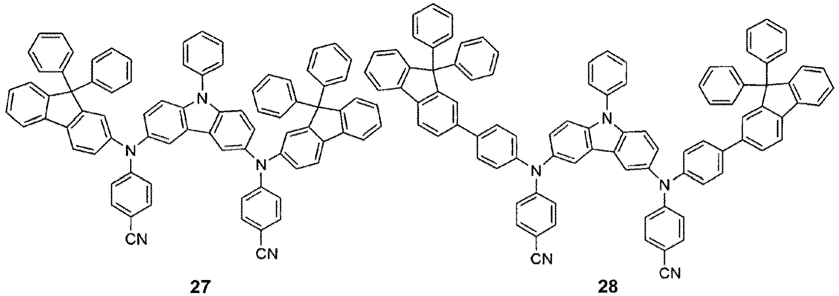

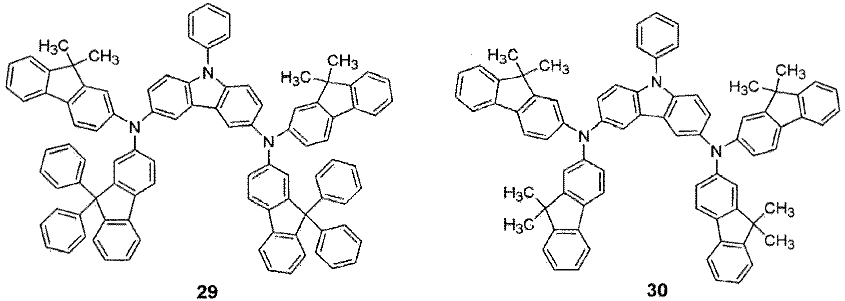

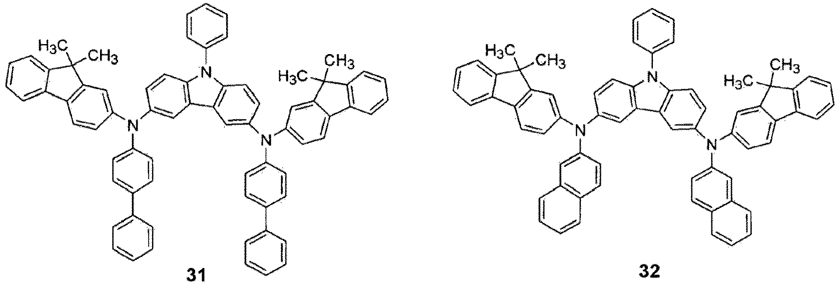

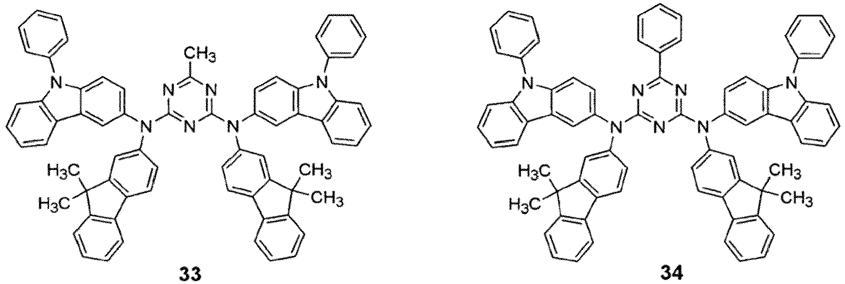

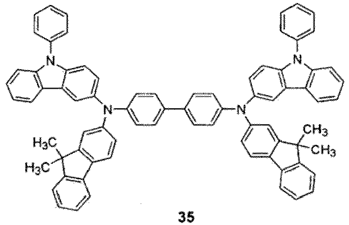

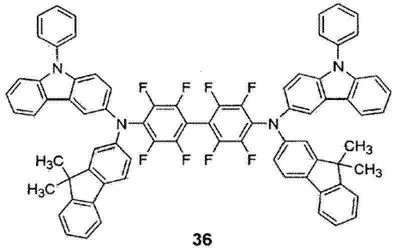

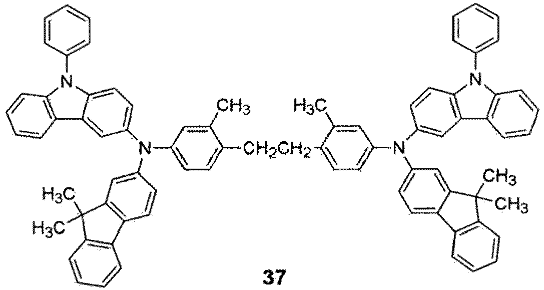

2. Organische lichtemittierende Vorrichtung nach Anspruch 1, wobei die Cyanogruppen enthaltende Verbindung einer der Formeln 1 bis 20 ist: 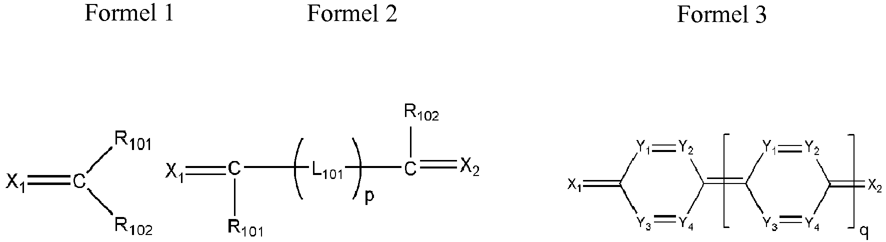 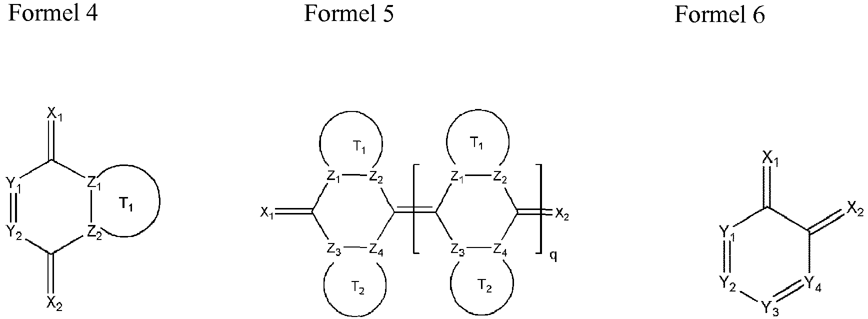 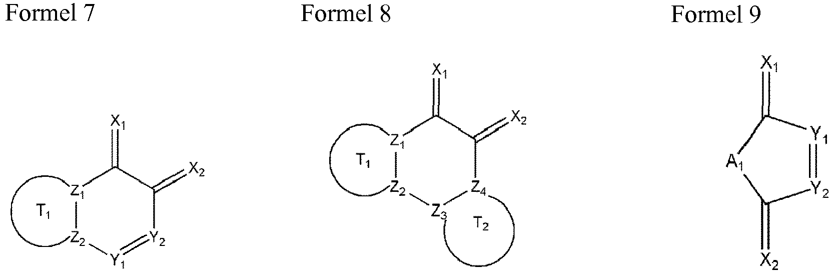 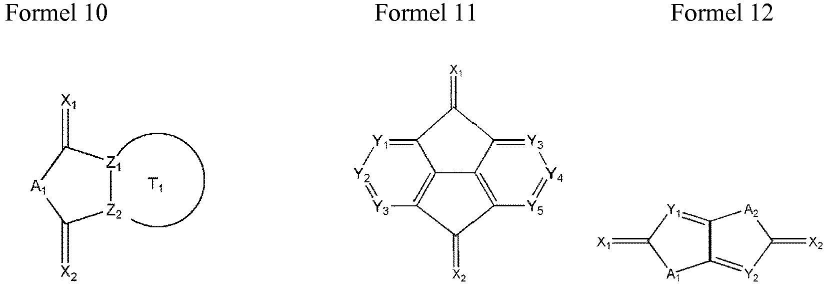 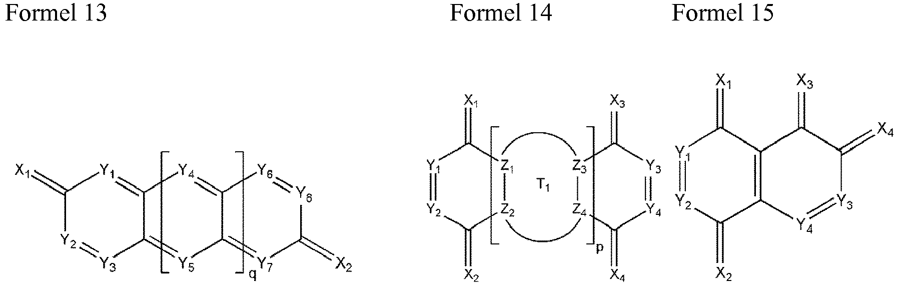 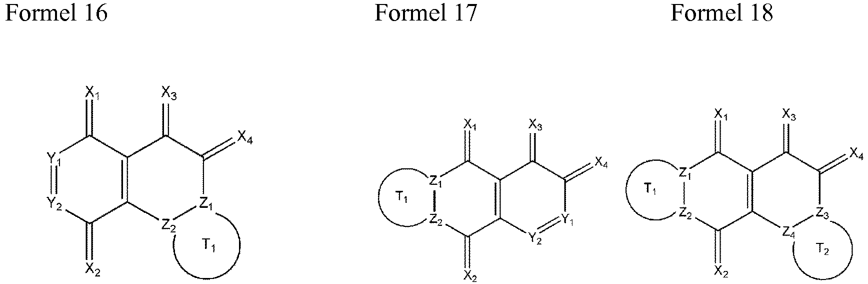 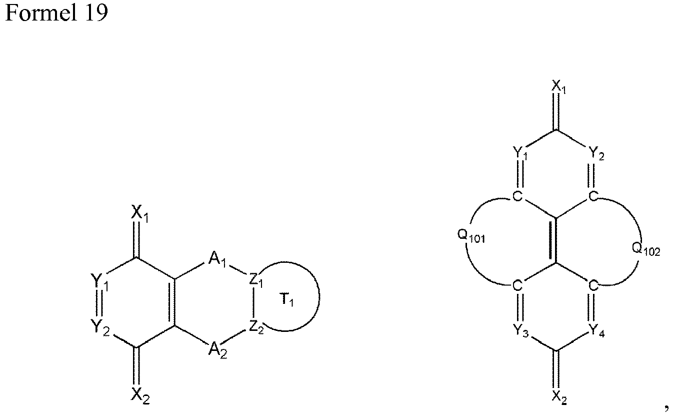 und
wobei in den Formeln 1 bis 20
X₁ bis X₄ jeweils unabhängig voneinander Verbindungen, die durch die unten stehenden Formeln 30A bis 30D dargestellt sind, sind;
Y₁ bis Y₈ jeweils unabhängig voneinander N oder C(R₁₀₃) sind;
Z₁ bis Z₄ jeweils unabhängig voneinander C oder N sind;
A₁ und A₂ jeweils unabhängig voneinander -O-, -S-, -N(R₁₀₄) oder -C(R₁₀₅)(R₁₀₆)- sind;
Q₁₀₁ und Q₁₀₂ jeweils unabhängig voneinander eine C₂₀-C₁₀-Alkylengruppe; eine C₂-C₁₀-Alkenylengruppe; oder eine substituierte C₂-C₁₀-Alkylengruppe oder eine subsituierte C₂-C₁₀-Alkenylengruppe, die zumindest einen Substituenten, der ein Halogenatom, eine Cyanogruppe, eine Hydroxylgruppe, eine C₁-C₁₀-Alkylgruppe oder eine C₁-C₁₀-Alkoxygruppe ist, aufweisen, sind;
T₁ und T₂ jeweils unabhängig voneinander ein aromatisches C₅-C₃₀-Ringsystem; ein heteroaromatisches C₂-C₃₀-Ringsystem; oder ein substituiertes aromatisches C₅-C₃₀-Ringsystem oder ein substituiertes heteroaromatisches C₂-C₃₀-Ringsystem, die zumindest einen Substituenten, der ein Halogenatom, eine Cyanogruppe, eine Hydroxylgruppe, eine C₁-C₁₀-Alkylgruppe oder eine C₁-C₁₀-Alkoxygruppe ist, aufweisen, sind;
p eine Ganzzahl von 1 bis 10 ist;
q eine Ganzzahl von 0 bis 10 ist;
R₁₀₁ bis R₁₀₆ jeweils unabhängig voneinander Wasserstoff; ein Halogenatom; eine Cyanogruppe; eine Hydroxylgruppe; eine C₁-C₁₀-Alkylgruppe; eine C₁-C₁₀-Alkoxygruppe; eine substituierte C₁-C₁₀-Alkylgruppe oder eine substituierte C₁-C₁₀-Alkoxygruppe, die zumindest einen Substituenten, der ein Halogenatom, eine Cyanogruppe, eine Hydroxylgruppe, eine C₅-C₁₄-Arylgruppe oder eine C₂-C₁₄-Heteroarylgruppe ist, aufweisen; 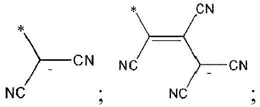 oder -N(R₁₀₇)(R₁₀₈) sind, wobei R₁₀₇ und R₁₀₈ jeweils unabhängig voneinander Wasserstoff, eine C₁-C₁₀-Alkylgruppe, eine Phenylgruppe oder eine Biphenylgruppe sind;
L₁₀₁ eine C₅-C₁₄-Arylengruppe; eine C₅-C₁₄-Heteroarylengruppe; oder eine substituierte C₂-C₁₀-Alkenylengruppe, eine substituierte C₅-C₁₄-Arylengruppe oder eine substituierte C₅-C₁₄-Heteroarylengruppe, die zumindest einen Substituenten, der ein Halogenatom, eine Cyanogruppe, eine Hydroxylgruppe, eine C₁-C₁₀-Alkylgruppe oder eine C₁-C₁₀-Alkoxygruppe ist, aufweisen, ist;

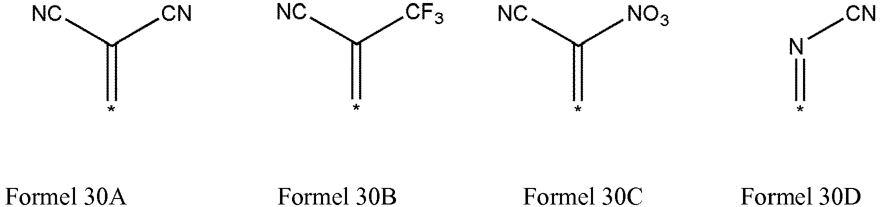

3. Organische lichtemittierende Vorrichtung nach Anspruch 2, wobei X₁ bis X₄ jeweils unabhängig voneinander die Verbindung, die durch die Formel 30A dargestellt ist, oder die Verbindung, die durch die Formel 30D dargestellt ist, sind.

4. Organische lichtemittierende Vorrichtung nach Anspruch 2, wobei in den Formeln 3, 4, 6, 7, 9, 11 - 17, 19 und 20 R₁₀₃ Wasserstoff; ein Halogenatom; eine Cyanogrupp; eine C₁-C₁₀-Alkylgruppe; eine C₁-C₁₀-Alkoxygruppe; eine substituierte C₁-C₁₀-Alkylgruppe oder eine substituierte C₁-C₁₀-Alkoxygruppe, die zumindest einen Substituenten, der ein Halogenatom, eine Cyanogruppe, eine Phenylgruppe, eine Naphthylgruppe, eine Anthrylgruppe, eine Pyridinylgruppe, eine Thiophenylgruppe oder eine Benziothiophenylgruppe ist, aufweisen; oder -N(R₁₀₇)(R₁₀₈), ist, wobei R₁₀₇ und R₁₀₈ jeweils unabhängig voneinander Wasserstoff, eine C₁-C₁₀-Alkylgruppe, eine Phenylgruppe oder eine Biphenylgruppe sind.

5. Organische lichtemittierende Vorrichtung nach Anspruch 2, wobei in den Formeln 4, 5, 7, 8, 10, 14 und 16 - 19 T₁ und T₂ jeweils unabhängig voneinander Benzol; Naphthalin; Anthracen; Thiophen; Thiadiazol; Oxadiazol; oder ein substituiertes Benzol, ein substituiertes Naphthalin, ein substituiertes Anthracen, ein substituiertes Thiophen, ein substituiertes Thiadiazol oder ein substituiertes Oxadiazol, die zumindest einen Substituenten, der ein Halogenatom, eine Cyanogruppe, eine C₁-C₁₀-Alkylgruppe oder eine C₁-C₁₀-Alkoxygruppe ist, aufweisen, sind.

6. Organische lichtemittierende Vorrichtung nach Anspruch 2, wobei in Formel 1 L₁₀₁ eine Thiophenylengruppe; eine Benzothiophenylengruppe; oder eine substituierte Thiophenylengruppe oder eine substituierte Benzothiophenylengruppe, die zumindest einen Substituenten, der ein Halogenatom, eine Cyanogruppe oder eine C₁-C₁₀-Alkylgruppe ist, aufweisen, ist.

7. Organische lichtemittierende Vorrichtung nach Anspruch 2, wobei die Cyanogruppen enthaltende Verbindung eine der Formeln 1A bis 20B ist: 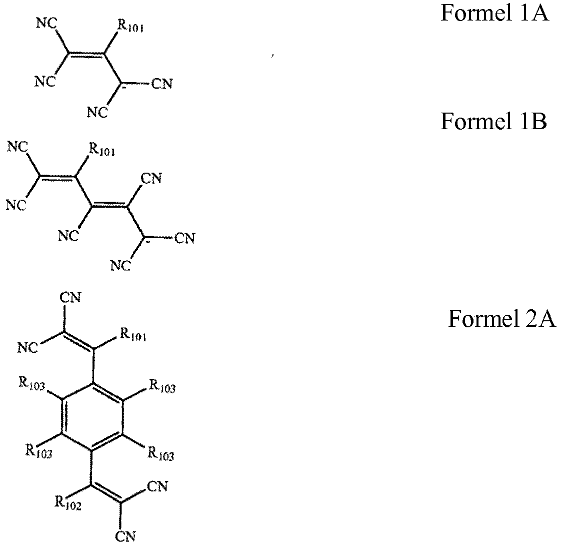 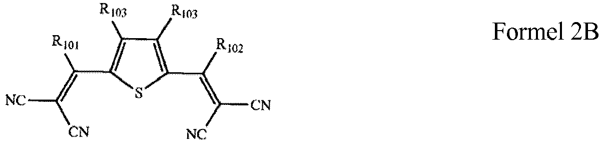 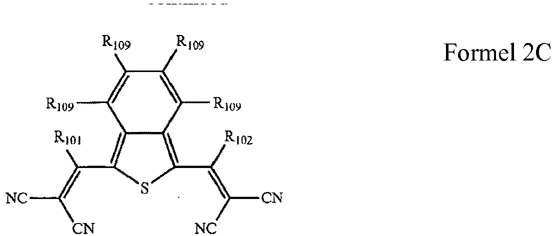 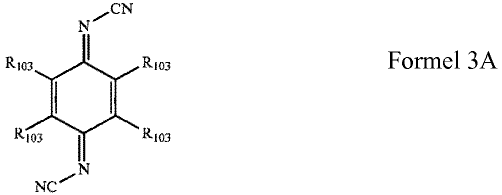 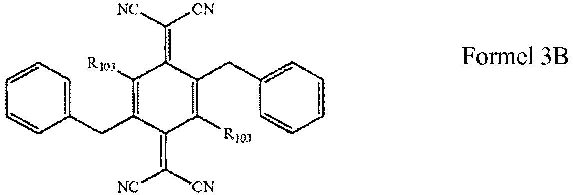 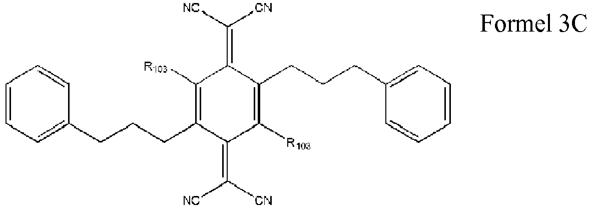 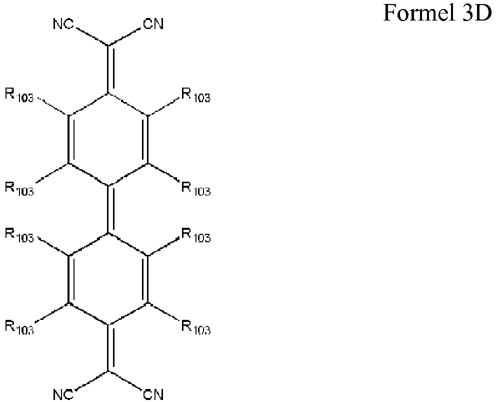 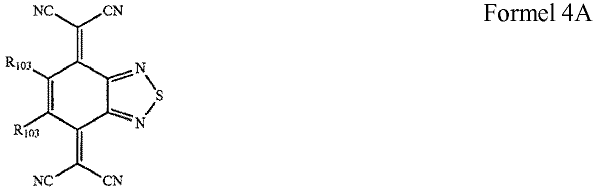 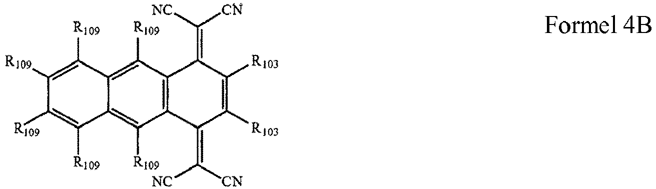 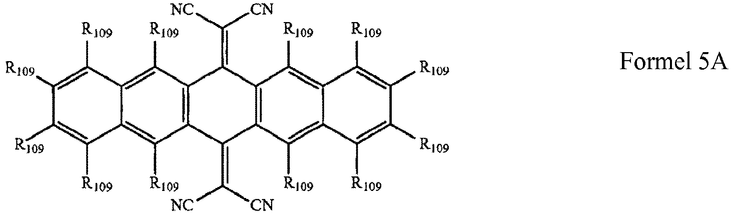 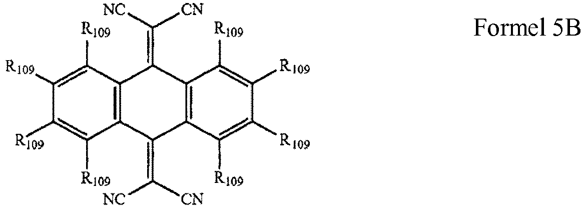 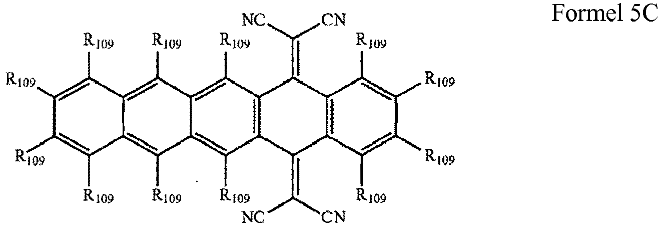 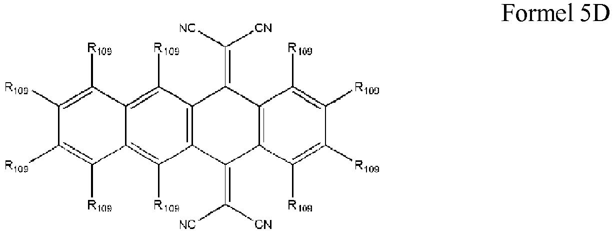 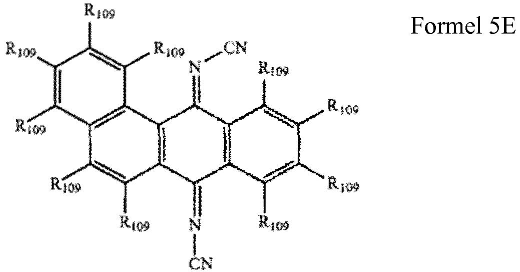 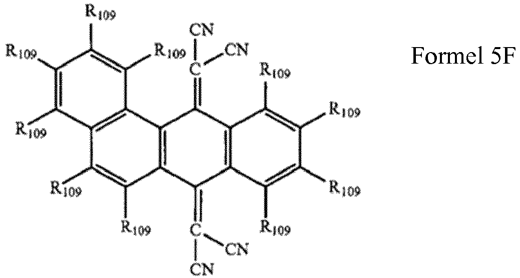 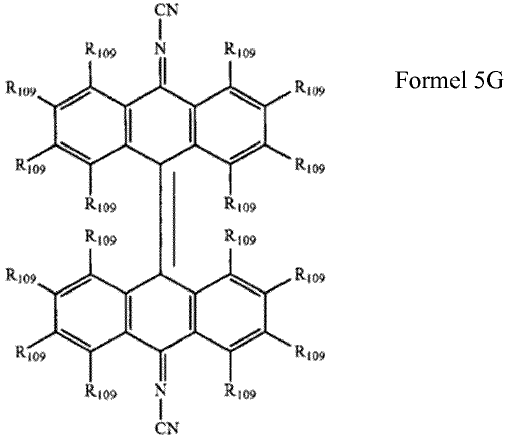 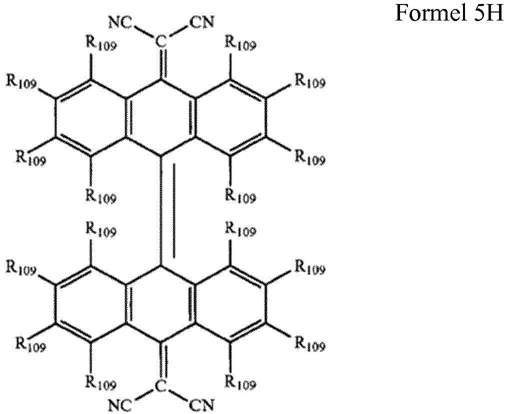 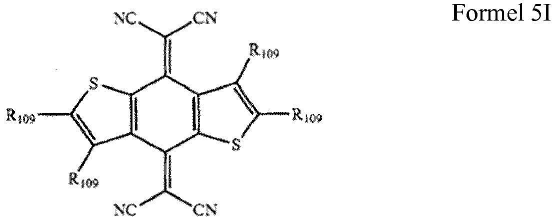 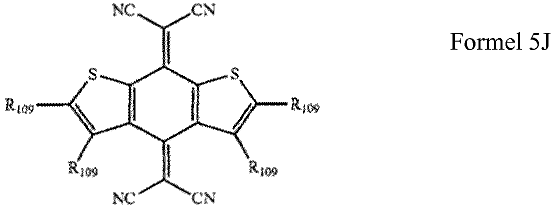 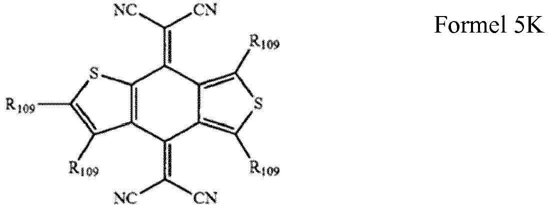 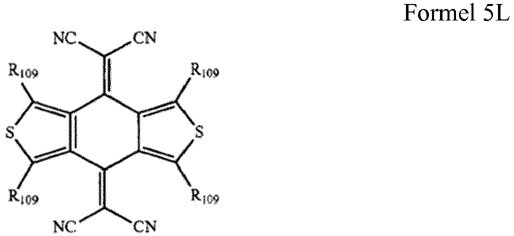 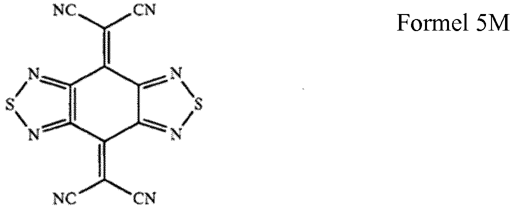 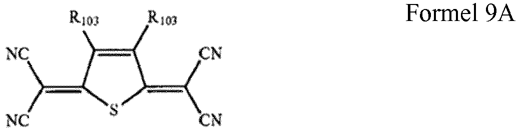 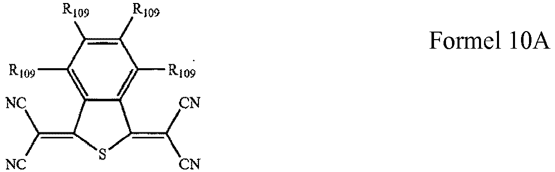 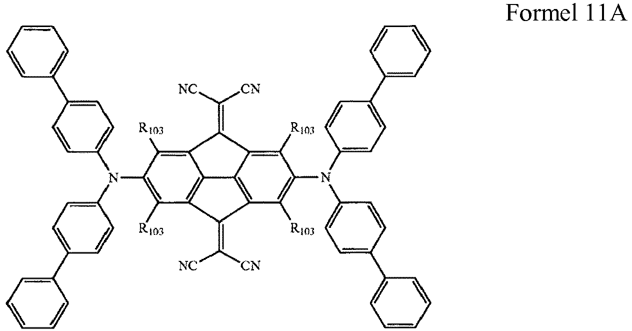 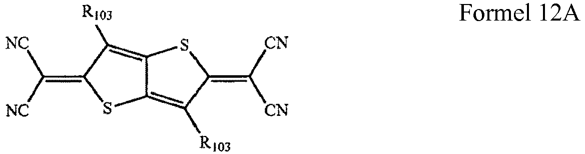 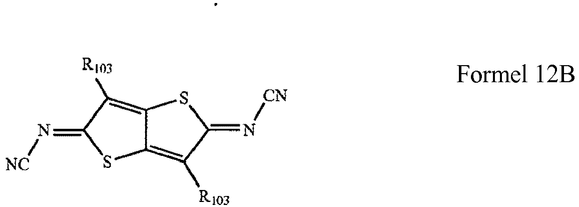 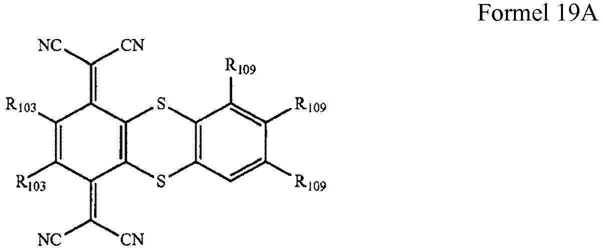 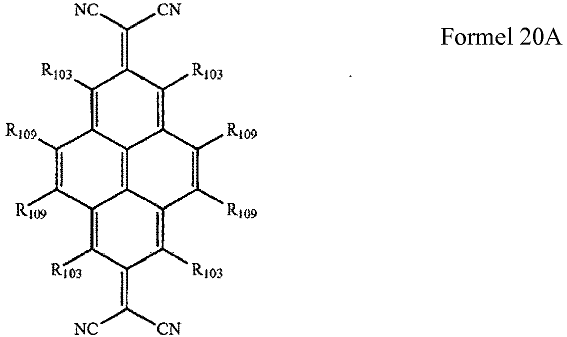 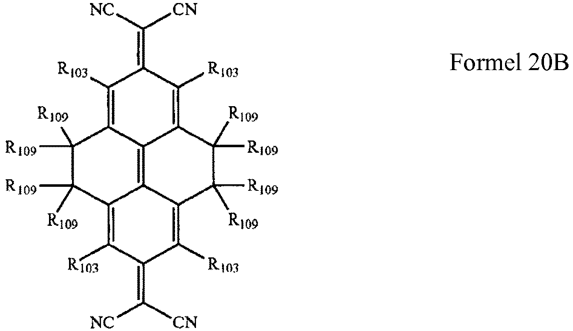 wobei in den Formeln 1A bis 20B R₁₀₃ und R₁₀₉ jeweils unabhängig voneinander ein Wasserstoffatom, -F, eine Cyanogruppe, eine Methylgruppe, eine Ethylgruppe, eine Propylgruppe, eine Ethenylgruppe, eine Methoxygruppe, eine Ethoxygruppe oder eine Propoxygruppe sind.

8. Organische lichtemittierende Vorrichtung nach Anspruch 1, wobei in Formel 42 Ar₁ und Ar₁₁ jeweils unabhängig voneinander eine C₁-C₁₀-Alkylengruppe; eine Phenylengrupe; eine Naphthylengruppe; eine Anthrylengruppe; eine Fluorenylengruppe; eine Carbazolylengruppe; eine Pyrazolylengruppe; eine Pyridinylengruppe; eine Triazinylengruppe; -N(Q₁)-; oder eine substituierte C₁-C₁₀-Alkylengruppe, eine substituierte Phenylengruppe, eine substituierte Naphthylengruppe, eine substituierte Anthrylengruppe, eine substituierte Fluorenylengruppe, eine substituierte Carbazolylengruppe, eine substituierte Pyrazolylengruppe, eine substituierte Pyridinylengruppe oder eine substituierte Triazinylengruppe, die zumindest einen Substituenten, der ein Halogenatom, eine Cyanogruppe, eine Hydroxylgruppe, eine C₁-C₁₀-Alkylgruppe, eine C₁-C₁₀-Alkoxygruppe, eine Phenylgruppe, eine Naphthylgruppe oder eine Anthrylgruppe ist, aufweisen, sind; und
Q₁ ein Wasserstoff; eine C₁-C₁₀-Alkylgruppe; eine Phenylgruppe; eine Naphthylgruppe; eine Carbazolylgruppe; eine Fluorenylgruppe; oder eine substituierte C₁-C₁₀-Alkylgruppe, eine substituierte C₁-C₁₀-Alkoxygruppe, eine substituierte Phenylgruppe, eine substituierte Naphthylgruppe, eine substituierte Carbazolylgruppe oder eine substituierte Fluorenylgruppe, die zumindest einen Substituenten, der ein Halogenatom, eine Cyanogruppe, eine Hydroxylgruppe, eine C₁-C₁₀-Alkylgruppe, eine C₁-C₁₀-Alkoxygruppe, eine Phenylgruppe, eine Naphthylgruppe oder eine Anthrylgruppe ist, aufweisen, ist.

9. Organische lichtemittierende Vorrichtung nach Anspruch 1, wobei Ar₂ und Ar₁₂ jeweils unabhängig voneinander Wasserstoff; eine C₁-C₁₀-Alkylgruppe; eine Phenylgruppe; eine Naphthylgruppe; eine Carbazolylgruppe; eine Fluorenylgruppe; eine Pyrenylgruppe; eine substituierte C₁-C₁₀-Alkylgruppe, eine substituierte C₁-C₁₀-Alkoxygruppe, eine substituierte Phenylgruppe, eine substituierte Naphthylgruppe, eine substituierte Carbazolylgruppe, eine substituierte Fluorenylgruppe oder eine substituierte Pyrenylgruppe, die zumindest einen Substituenten, der ein Halogenatom, eine Cyanogruppe, eine Hydroxylgruppe, eine C₁-C₁₀-Alkylgruppe, eine C₁-C₁₀-Alkoxygruppe, eine Phenylgruppe, eine Naphthylgruppe oder eine Anthrylgruppe ist, aufweisen, oder -N(Q₂)(Q₃), sind, wobei Q₂ und Q₃ jeweils unabhängig voneinander Wasserstoff, eine Methylgruppe, eine Ethylgruppe, eine Phenylgruppe, eine Methylphenylgruppe, eine Biphenylgruppe, eine Napththylgruppe oder eine Methylnaphthylgruppe sind.

10. Organische lichtemittierende Vorrichtung nach einem der vorhergehenden Ansprüche, wobei die Menge der Cyanogruppen enthaltenden Verbindung in der Schicht (6) 0,1 bis 20 Gewichtsteile, bezogen auf 100 Gewichtsteile der Schicht (6), beträgt.

11. Organische lichtemittierende Vorrichtung nach einem der vorhergehenden Ansprüche, wobei die Schicht (6) eine Dicke von 10 Å bis 2100 Å aufweist.

12. Organische lichtemittierende Vorrichtung nach einem der vorhergehenden Ansprüche, wobei ein Abstand zwischen der Schicht (6) und der Emissionsschicht 50 Å oder mehr beträgt.

13. Organische lichtemittierende Vorrichtung nach Anspruch 1, wobei die Verbindung auf Anthracenbasis eine der unten stehenden Formeln 101 und 102 ist und die Verbindung auf Chinolatbasis Lithiumchinolat (LiQ) ist, 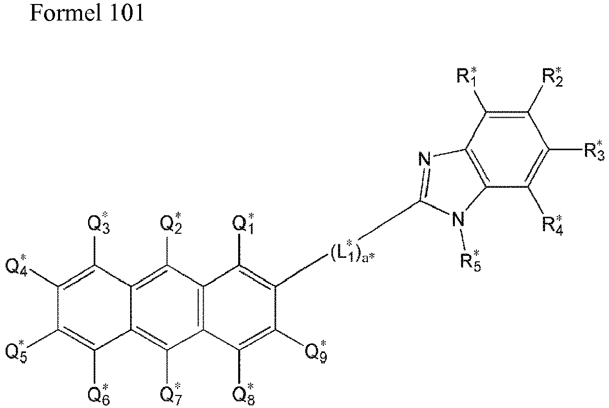 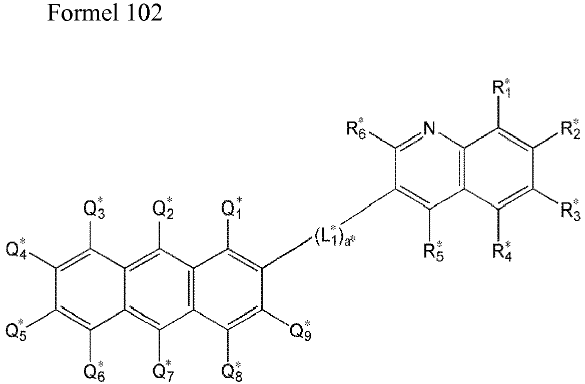 wobei in den Formeln 101 und 102
R*₁ bis R*₆ jeweils unabhängig voneinander ein Wasserstoffatom, ein Halogenatom, eine Hydroxygruppe, eine Cyanogruppe, eine substituierte oder unsubstituierte C₁-C₃₀-Alkylgruppe, eine substituierte oder unsubstituierte C₁-C₃₀-Alkoxygruppe, eine substituierte oder unsubstituierte C₁-C₃₀-Acylgruppe, eine substituierte oder unsubstituierte C₂-C₃₀-Alkenylgruppe, eine substituierte oder unsubstituierte C₂-C₃₀-Alkynylgruppe, eine substituierte oder unsubstituierte C₆-C₃₀-Arylgruppe oder eine substituierte oder unsubstituierte C₃-C₃₀-Heteroarylgruppe sind, wobei zumindest zwei benachbarte Gruppen von R*₁ bis R*₆ miteinander verknüpft sind, um einen gesättigten oder ungesättigten Ring zu bilden;
L*₁ eine Einfachbindung, eine substituierte oder unsubstituierte C₁-C₃₀-Alkylengruppe, eine substituierte oder unsubstituierte C₆-C₃₀-Arylengruppe oder eine substituierte oder unsubstituierte C₃-C₃₀-Heteroarylengruppe ist;
Q*₁ bis Q*₉ jeweils unabhängig voneinander ein Wasserstoffatom, eine substituierte oder unsubstituierte C₆-C₃₀-Arylgruppe oder eine substituierte oder unsubstituierte C₃-C₃₀-Heteroarylgruppe sind; und
a* eine Ganzzahl von 1 bis 10 ist.

14. Organische lichtemittierende Vorrichtung nach Anspruch 1, wobei die Verbindung auf Anthracenbasis eine der unten stehenden Formeln 103 und 104 ist und die Verbindung auf Chinolatbasis Lithiumchinolat (LiQ) ist,

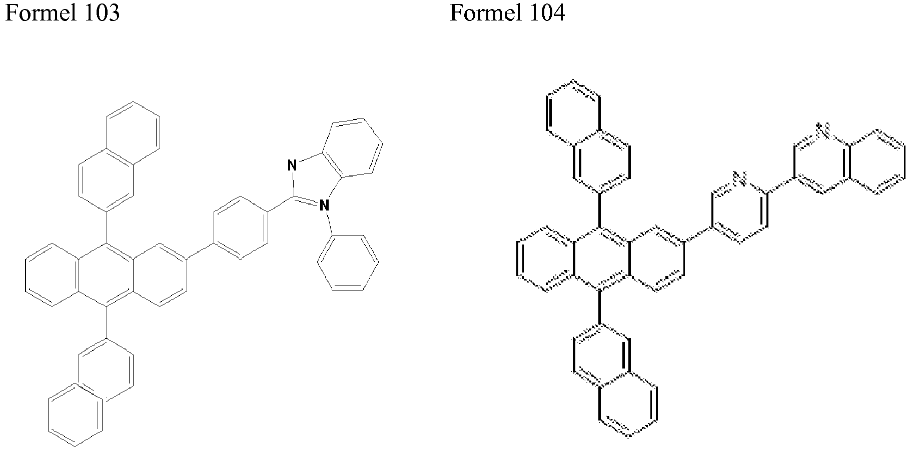

15. Organische lichtemittierende Vorrichtung nach einem des Anspruchs 1, wobei die Menge der Verbindung auf Anthracenbasis 50 bis 150 Gewichtsteile, bezogen auf 100 Gewichtsteile der Verbindung auf Chinolatbasis, beträgt.

16. Organische lichtemittierende Vorrichtung nach einem der vorhergehenden Ansprüche, wobei die Emissionsschicht (EML) einen blauen Dotand und einen blauen Wirt aufweist.

17. Organische lichtemittierende Vorrichtung nach Anspruch 16, wobei die Emissionsschicht einen blauen Dotand, der unter die unten stehende Formel 201 fällt, und einen blauen Wirt, der unter die unten stehende Formel 202 fällt, aufweist, 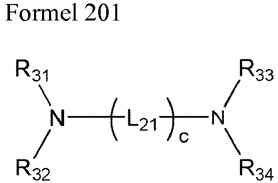 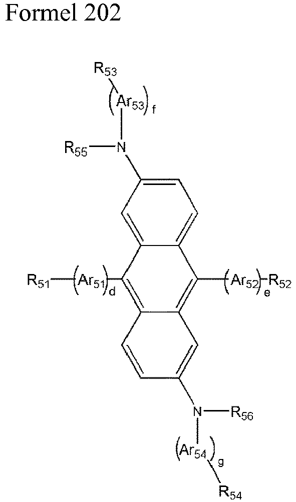 wobei in den Formeln 201 und 202
L₂₁ eine substituierte oder unsubstituierte C₁-C₃₀-Alkylengruppe, eine substituierte oder unsubstituierte C₂-C₃₀-Alkenylengruppe, eine substituierte oder unsubstituierte C₅-C₃₀-Arylengruppe oder eine substituierte oder unsubstituierte C₄-C₃₀-Heteroarylengruppe ist;
c eine Ganzzahl von 1 bis 20 ist;
R₃₁ bis R₃₄ jeweils unabhängig voneinander eine substituierte oder unsubstituierte C₁-C₃₀-Alkylgruppe, eine substituierte oder unsubstituierte C₂-C₃₀-Alkenylgruppe, eine substituierte oder unsubstituierte C₂-C₃₀-Alkynylgruppe, eine substituierte oder unsubstituierte C₁-C₃₀-Alkoxygruppe, eine substituierte oder unsubstituierte C₅-C₃₀-Arylgruppe oder eine substituierte oder unsubstituierte C₄-C₃₀-Heteroarylgruppe sind;
c Gruppen von L₂₁ in -(L₂₁)_{c}- identisch oder voneinander verschieden sind;
Ar₅₁, Ar₅₂, Ar₅₃ und Ar₅₄ jeweils unabhängig voneinander eine Phenylengruppe, eine Naphthylengruppe, eine Anthrylengruppe oder eine mit Phenyl substituierte Anthrylengruppe sind;
R₅₁ bis R₅₆ jeweils unabhängig voneinander ein Wasserstoffatom, eine Methylgruppe, eine Ethylgruppe, eine Propylgruppe, eine Butylgruppe, eine Phenylgruppe, eine Naphthylgruppe, eine Anthrylgruppe, eine Pyrenylgruppe, eine Carbazolylgruppe oder -N(Q₂)(Q₃) sind, wobei Q₂ und Q₃ jeweils unabhängig voneinander eine Methylgruppe, eine Phenylgruppe, eine Naphthylgruppe oder eine Anthrylgruppe sind; und
d, e, f und g jeweils unabhängig voneinander eine Ganzzahl von 0 bis 10 sind.

## Revendications

1. Dispositif électroluminescent organique (10) comprenant :
un substrat (1) ;
une première électrode (5) disposée sur le substrat (1) ;
une seconde électrode (9) ;
une couche organique (7) disposée entre la première électrode (5) et la seconde électrode (9), la couche organique (7) comprenant une couche de transport de trous (HTL), une couche d'émission (EML) et une couche de transport d'électrons (ETL) ; et
une couche (6) disposée entre la première électrode (5) et la couche de transport de trous (HTL), la couche (6) comprenant au moins un composé contenant un groupe cyano, **caractérisé en ce que** la couche de transport d'électrons (ETL) comprend un composé à base d'anthracène et un composé à base de quinolate,
où la couche (6) comprend en outre un composé de transport de trous et le composé de transport de trous est un de la formule 42 et des composés 1 à 37 : 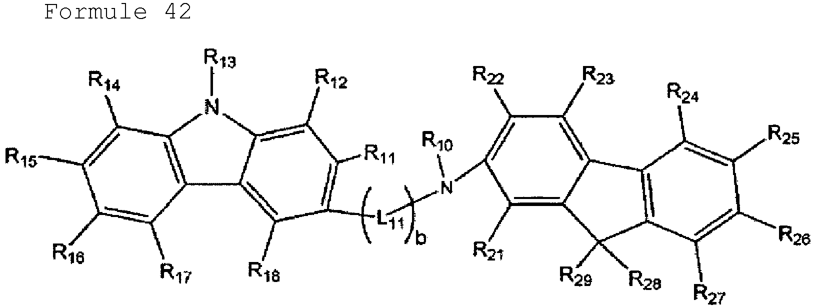 où, dans la formule 42,
R₁₀ est représenté par -(Ar₁)ₙ-Ar₂ ;
R₁₆ est représenté par -(Ar₁₁)ₘ-Ar₁₂ ;
Ar₁, Ar₁₁ et L₁₁ sont chacun indépendamment un groupe alkylène en C₁ à C₃₀ substitué ou non substitué, un groupe alcénylène en C₂ à C₃₀ substitué ou non substitué, un groupe arylène en C₅ à C₃₀ substitué ou non substitué, un groupe hétéroarylène en C₄ à C₃₀ substitué ou non substitué, ou -N(Q₁)- ;
n, m et b sont chacun indépendamment un nombre entier de 0 à 10 ;
R₁₁ à R₁₅, R₁₇, R₁₈, R₂₁ à R₂₉, Ar₂, Ar₁₂ et Q₁ sont chacun indépendamment un hydrogène, un atome d'halogène, un groupe hydroxyle, un groupe cyano, un groupe alkyle en C₁ à C₃₀ substitué ou non substitué, un groupe alcényle en C₂ à C₃₀ substitué ou non substitué, un groupe alcynyle en C₂ à C₃₀ substitué ou non substitué, un groupe alkoxy en C₁ à C₃₀ substitué ou non substitué, un groupe alkylthiol en C₁ à C₃₀ substitué ou non substitué, un groupe aryle en C₅ à C₃₀ substitué ou non substitué, un groupe hétéroaryle en C₄ à C₃₀, ou -N(Q₂) (Q₃) ;
Q₂ et Q₃ sont chacun indépendamment un hydrogène, un atome d'halogène, un groupe hydroxyle, un groupe cyano, un groupe alkyle en C₁ à C₃₀ substitué ou non substitué, un groupe alcényle en C₂ à C₃₀ substitué ou non substitué, un groupe alcynyle en C₂ à C₃₀ substitué ou non substitué, un groupe alkoxy en C₁ à C₃₀ substitué ou non substitué, un groupe alkylthiol en C₁ à C₃₀ substitué ou non substitué, un groupe aryle en C₅ à C₃₀ substitué ou non substitué, ou un groupe hétéroaryle en C₄ à C₃₀ substitué ou non substitué ; et
n groupes de Ar₁ dans -(Ar₁)ₙ- sont identiques ou différents l'un de l'autre, m groupes de Ar₁₁ dans -(Ar₁₁)ₘ- sont identiques ou différents l'un de l'autre et b groupes de L₁₁ dans -(L₁₁)_{b}- sont identiques ou différents l'un de l'autre ;

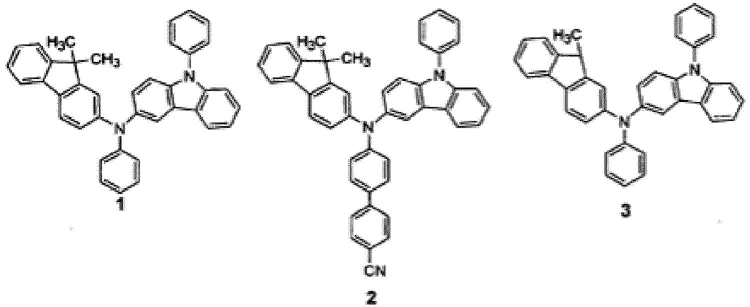

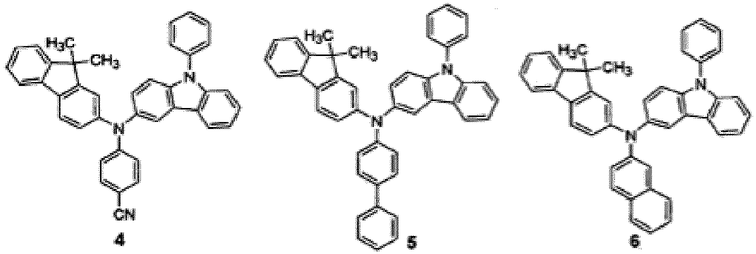

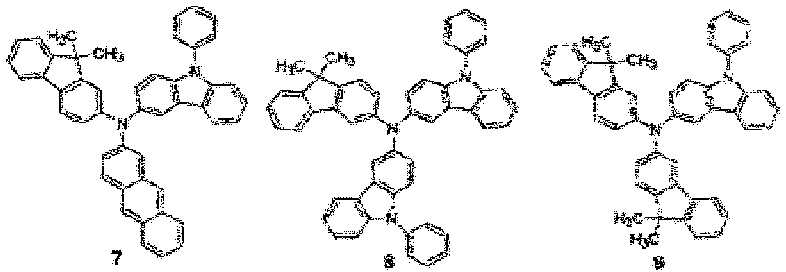

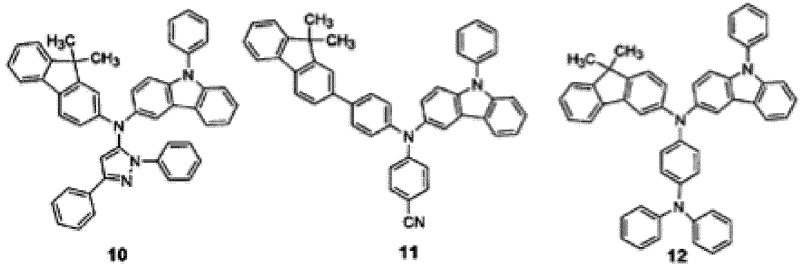

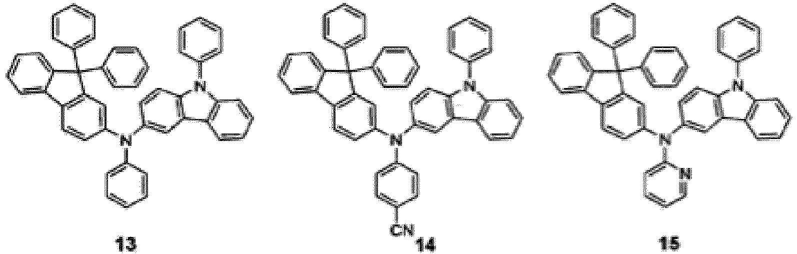

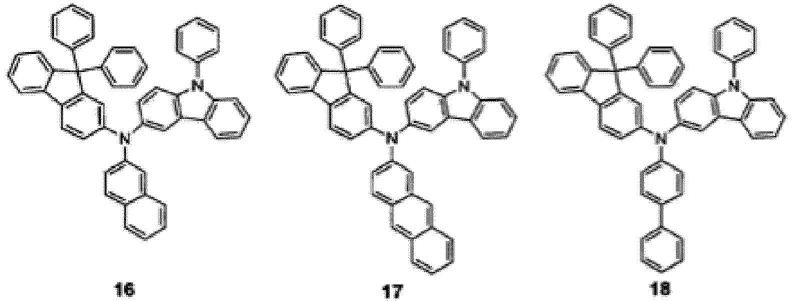

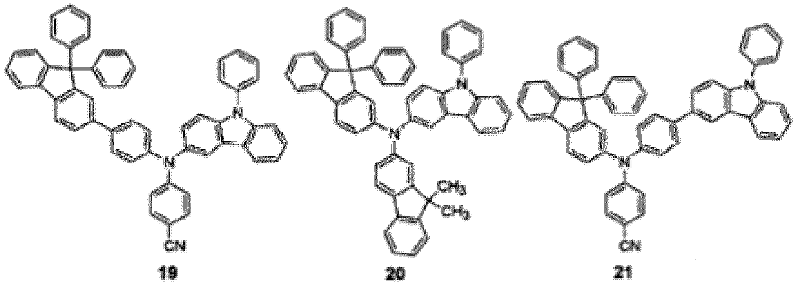

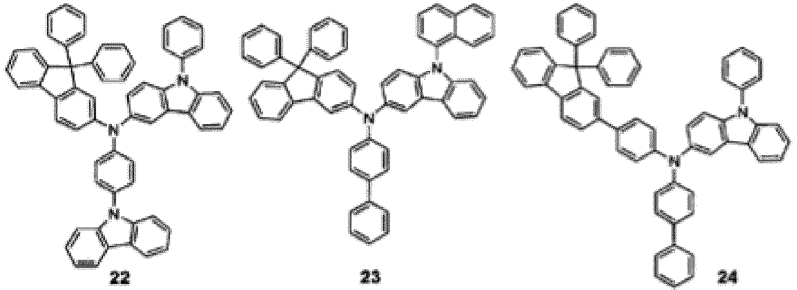

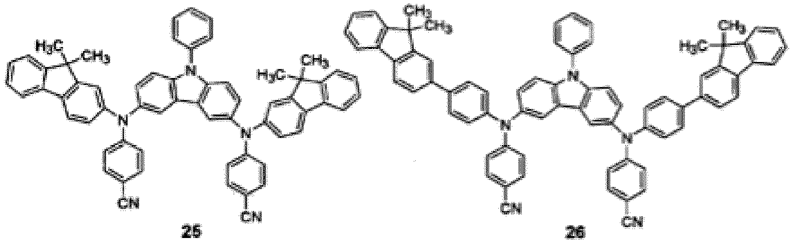

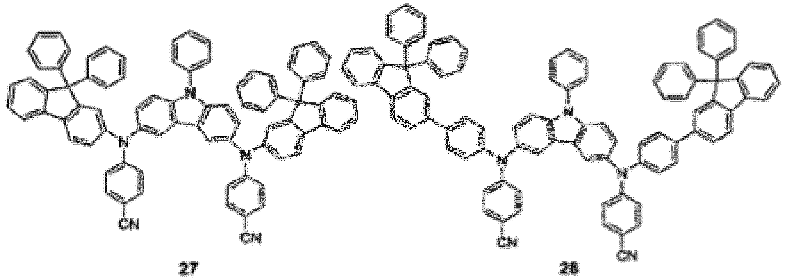

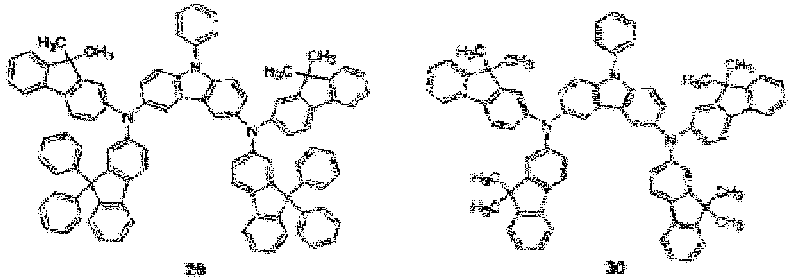

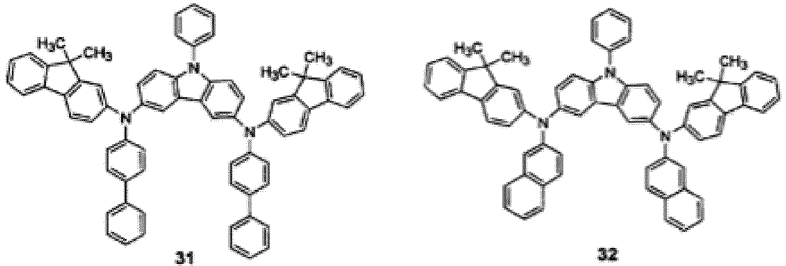

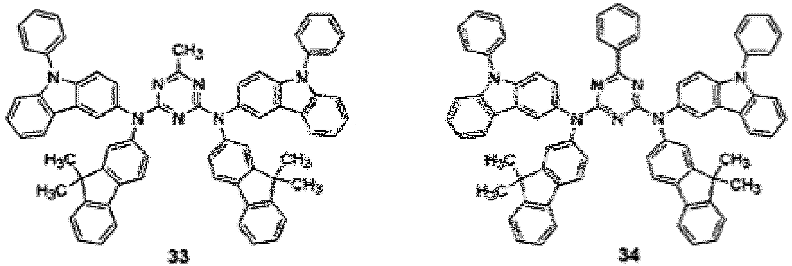

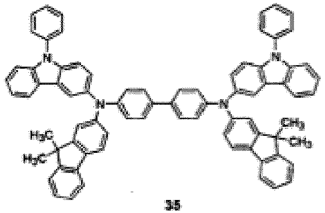

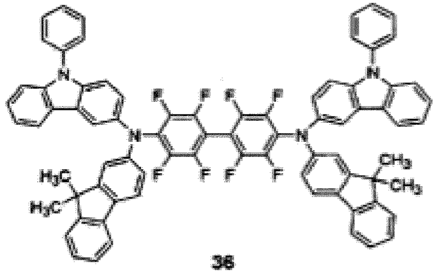

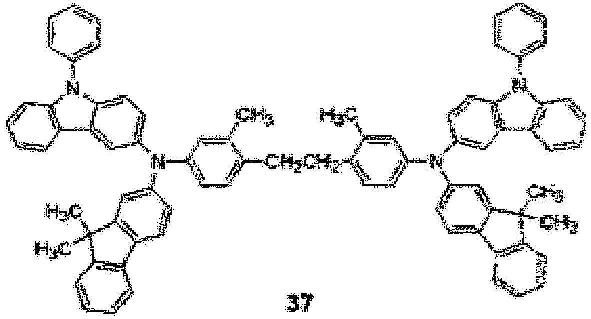

2. Dispositif électroluminescent organique selon la revendication 1, dans lequel le composé contenant un groupe cyano est un des formules 1 à 20 : 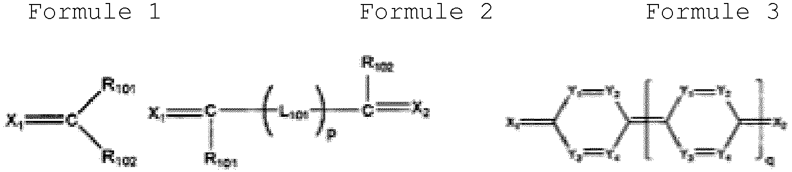 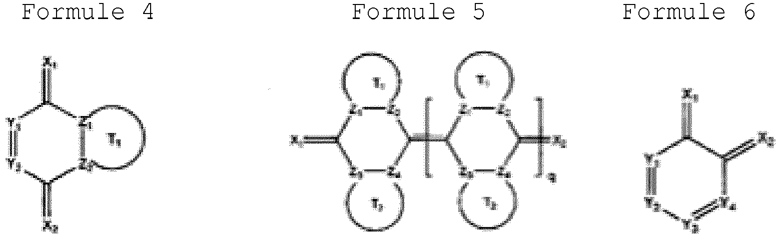 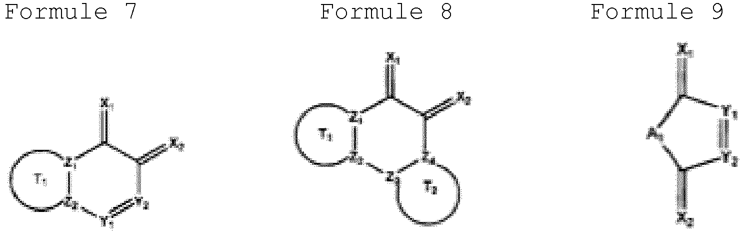 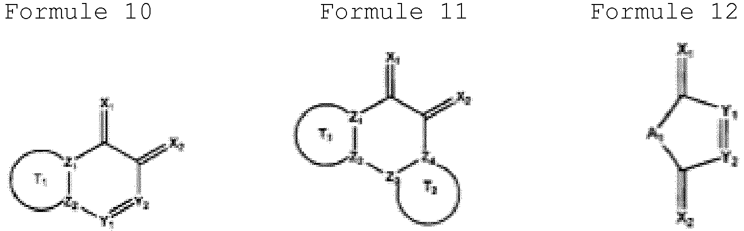 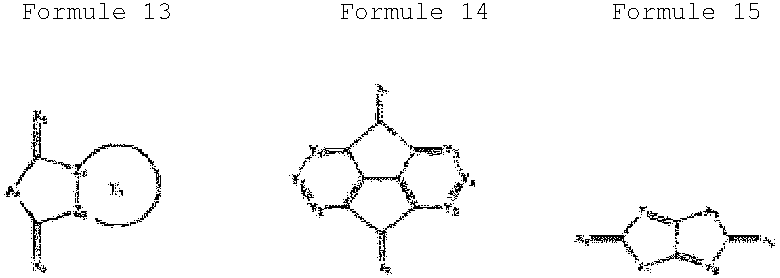 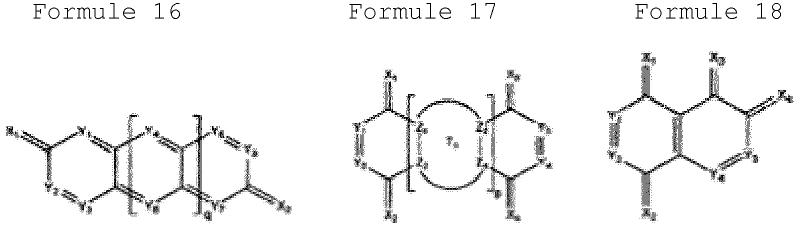 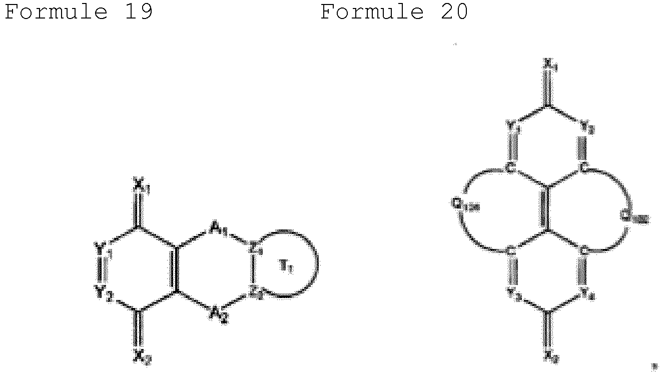 et
où, dans les formules 1 à 20,
X₁ à X₄ sont chacun indépendamment des composés représentés par les formules 30A à 30D ci-dessous ;
Y₁ à Y₈ sont chacun indépendamment N ou C(R₁₀₃) ;
Z₁ à Z₄ sont chacun indépendamment C ou N ;
A₁ et A₂ sont chacun indépendamment -O-, -S-, -N(R₁₀₄) ou -C(R₁₀₅)(R₁₀₆) ;
Q₁₀₁ et Q₁₀₂ sont chacun indépendamment un groupe alkylène en C₂ à C₁₀ ; un groupe alcénylène en C₂ à C₁₀ ; ou un groupe alkylène en C₂ à C₁₀ substitué ou un groupe alcénylène en C₂ à C₁₀ substitué qui ont au moins un substituant qui est un atome d'halogène, un groupe cyano, un groupe hydroxyle, un groupe alkyle en C₁ à C₁₀ ou un groupe alkoxy en C₁ à C₁₀;
T₁ et T₂ sont chacun indépendamment un système de noyau aromatique en C₅ à C₃₀; un système de noyau hétéroaromatique en C₂ à C₃₀ ; ou un système de noyau aromatique en C₅ à C₃₀ substitué ou un système de noyau hétéroaromatique en C₂ à C₃₀ substitué qui ont au moins un substituant qui est un atome d'halogène, un groupe cyano, un groupe hydroxyle, un groupe alkyle en C₁ à C₁₀ ou un groupe alkoxy en C₁ à C₁₀;
p est un nombre entier de 1 à 10 ;
q est un nombre entier de 0 à 10 ;
R₁₀₁ à R₁₀₆ sont chacun indépendamment un hydrogène ; un atome d'halogène ; un groupe cyano ; un groupe hydroxyle ; un groupe alkyle en C₁ à C₁₀; un groupe alkoxy en C₁ à C₁₀; un groupe alkyle en C₁ à C₁₀ substitué ou un groupe alkoxy en C₁ à C₁₀ substitué qui ont au moins un substituant qui est un atome d'halogène, un groupe cyano, un groupe hydroxyle, un groupe aryle en C₅ à C₁₄, ou un groupe hétéroaryle en C₂ à C₁₄ ; 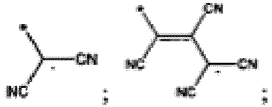
ou -N(R₁₀₇)(R₁₀₈), où R₁₀₇ et R₁₀₈ sont chacun indépendamment un hydrogène, un groupe alkyle en C₁ à C₁₀, un groupe phényle ou un groupe biphényle ;
L₁₀₁ est un groupe arylène en C₅ à C₁₄ ; un groupe hétéroarylène en C₅ à C₁₄ ; ou un groupe alcénylène en C₂ à C₁₀ substitué, un groupe arylène en C₅ à C₁₄ substitué ou un groupe hétéroarylène en C₅ à C₁₄ substitué qui ont au moins un substituant qui est un atome d'halogène, un groupe cyano, un groupe hydroxyle, un groupe alkyle en C₁ à C₁₀ ou un groupe alkoxy en C₁ à C₁₀, 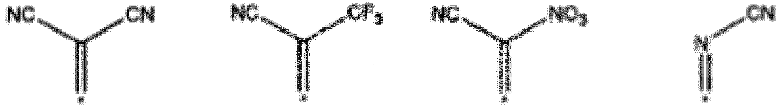 Formule 30A Formule 30B Formule 30C Formule 30D

3. Dispositif électroluminescent organique selon la revendication 2, dans lequel X₁ à X₄ sont chacun indépendamment le composé représenté par la formule 30A ou le composé représenté par la formule 30D.

4. Dispositif électroluminescent organique selon la revendication 2, dans lequel dans les formules 3, 4, 6, 7, 9, 11 à 17, 19 et 20 R₁₀₃ est un hydrogène ; un atome d'halogène ; un groupe cyano ; un groupe alkyle en C₁ à C₁₀; un groupe alkoxy en C₁ à C₁₀; un groupe alkyle en C₁ à C₁₀ substitué ou un groupe alkoxy en C₁ à C₁₀ substitué qui ont au moins un substituant qui est un atome d'halogène, un groupe cyano, un groupe phényle, un groupe naphtyle, un groupe anthryle, un groupe pyridinyle, un groupe thiophényle ou un groupe benzothiophényle ; ou -N(R₁₀₇) (R₁₀₈), où R₁₀₇ et R₁₀₈ sont chacun indépendamment un hydrogène, un groupe alkyle en C₁ à C₁₀, un groupe phényle ou un groupe biphényle.

5. Dispositif électroluminescent organique selon la revendication 2, dans lequel dans les formules 4, 5, 7, 8, 10, 14 et 16 à 19 T₁ et T₂ sont chacun indépendamment un benzène ; un naphtalène ; un anthracène ; un thiophène ; un thiadiazole ; un oxadiazole ; ou un benzène substitué, un naphtalène substitué, un anthracène substitué, un thiophène substitué, un thiadiazole substitué ou un oxadiazole substitué qui ont au moins un substituant qui est un atome d'halogène, un groupe cyano, un groupe alkyle en C₁ à C₁₀ ou un groupe alkoxy en C₁ à C₁₀.

6. Dispositif électroluminescent organique selon la revendication 2, dans lequel dans la formule 2 L₁₀₁ est un groupe thiophénylène ; un groupe benzothiophénylène ; ou un groupe thiophénylène substitué ou un groupe benzothiophénylène substitué qui ont au moins un substituant qui est un atome d'halogène, un groupe cyano ou un groupe alkyle en C₁ à C₁₀.

7. Dispositif électroluminescent organique selon la revendication 2, dans lequel le composé contenant un groupe cyano est l'une des formules 1A à 20B : 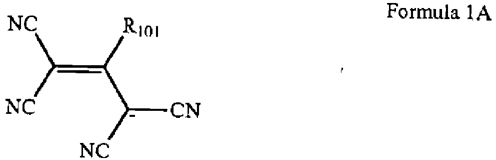 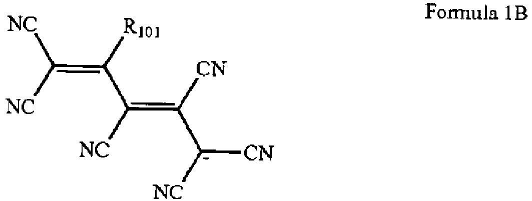 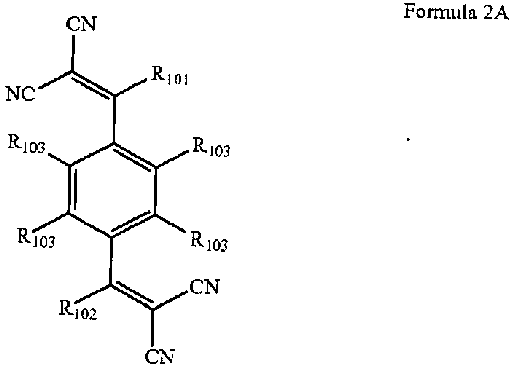 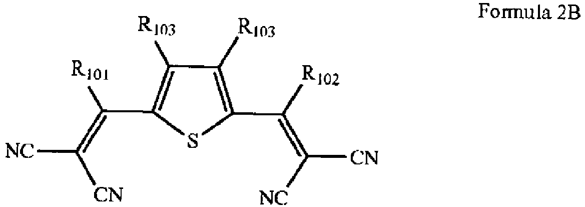 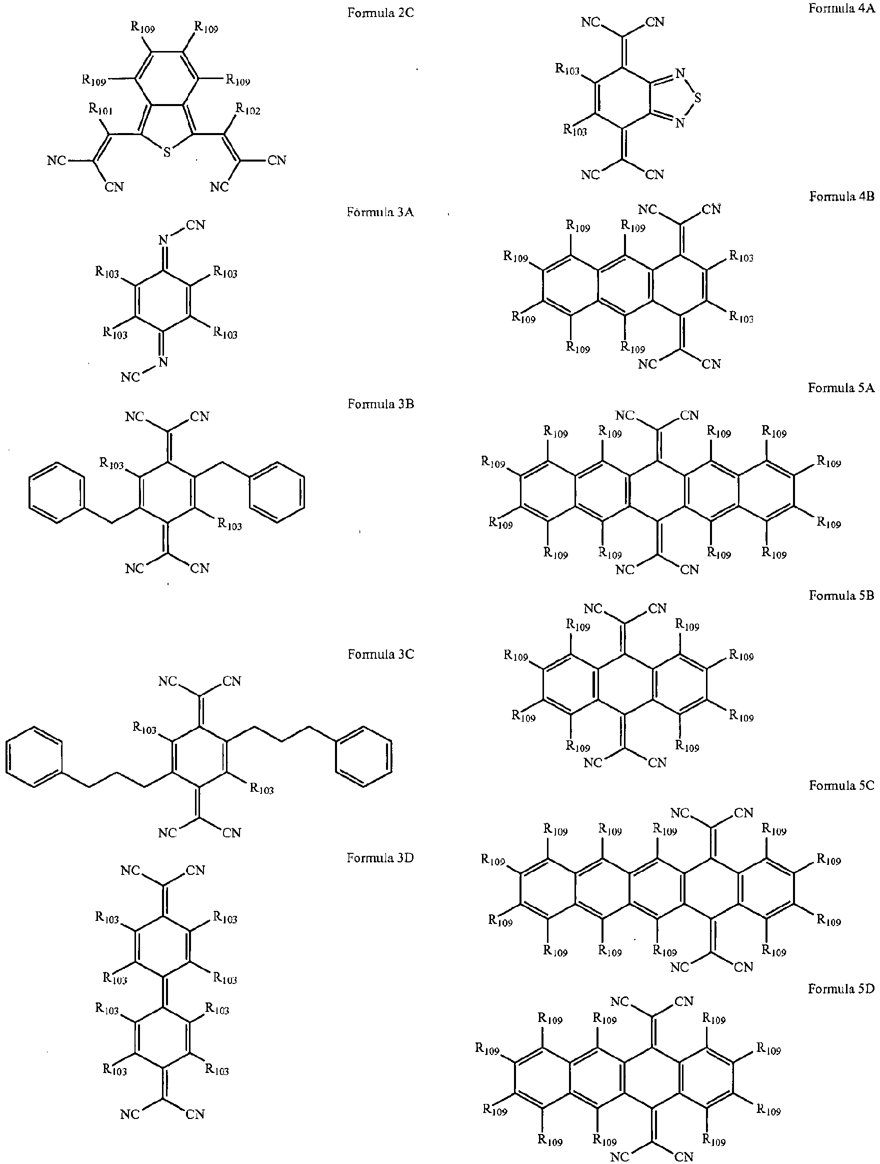 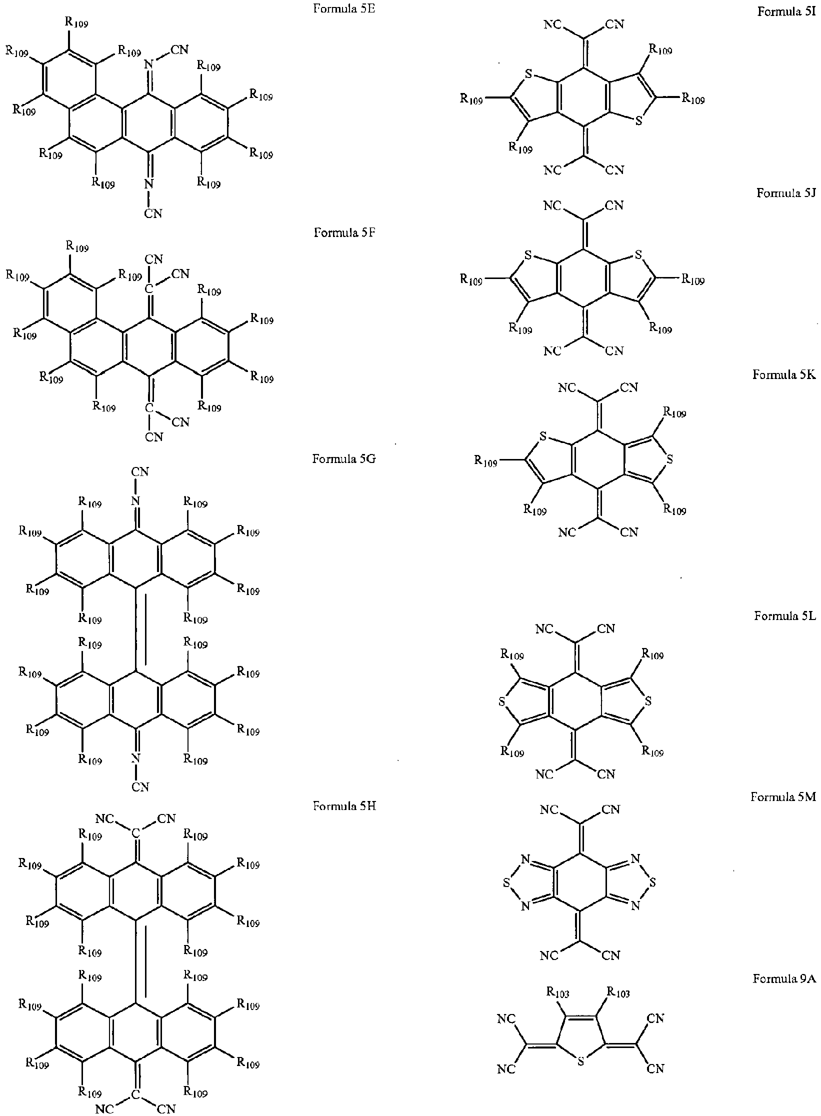 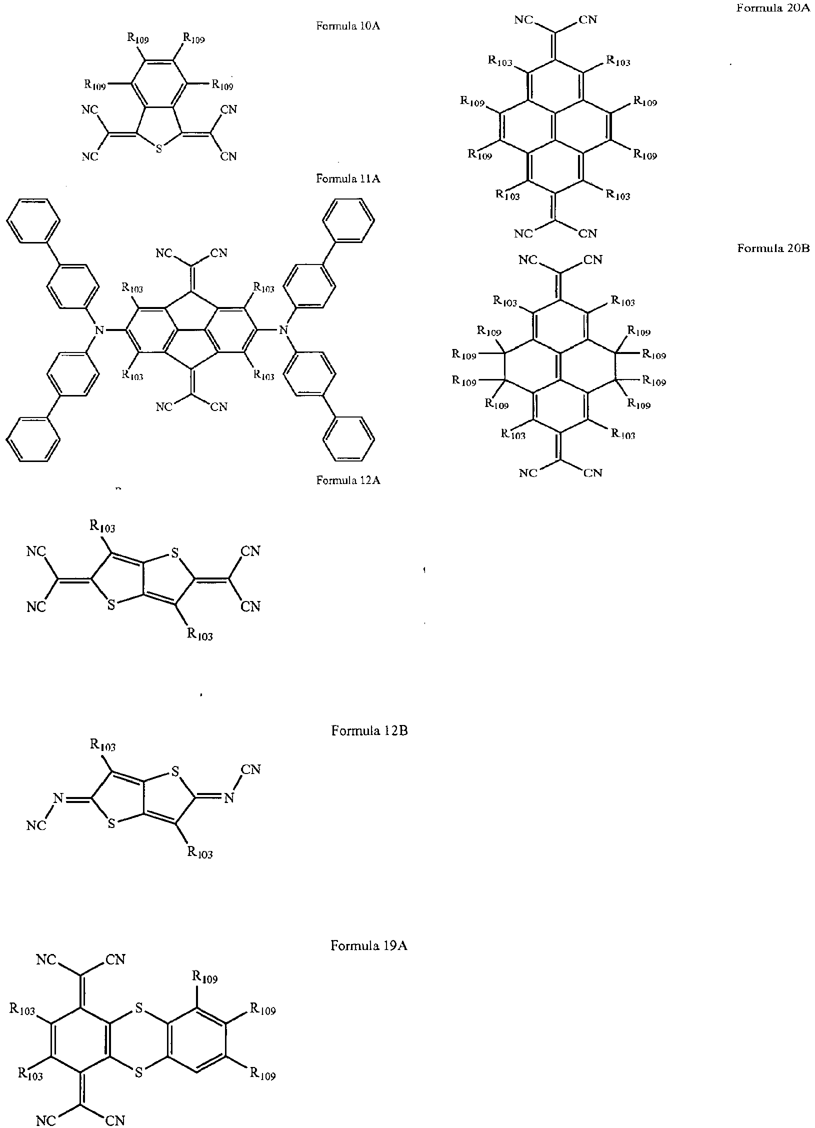 où, dans les formules 1A à 20B, R₁₀₃ et R₁₀₉ sont chacun indépendamment un atome d'hydrogène, -F, un groupe cyano, un groupe méthyle, un groupe éthyle, un groupe propyle, un groupe éthényle, un groupe méthoxy, un groupe éthoxy, ou un groupe propoxy.

8. Dispositif électroluminescent organique selon la revendication 1, dans lequel dans la formule 42 Ar₁ et Ar₁₁ sont chacun indépendamment un groupe alkylène en C₁ à C₁₀; un groupe phénylène ; un groupe naphtylène ; un groupe anthrylène ; un groupe fluorénylène, un groupe carbazolylène ; un groupe pyrazolylène ; un groupe pyridinylène ; un groupe triazinylène ; -N(Q1)- ; ou un groupe alkylène en C₁ à C₁₀ substitué, un groupe phénylène substitué, un groupe naphtylène substitué, un groupe anthrylène substitué, un groupe fluorénylène substitué, un groupe carbazolylène substitué, un groupe pyrazolylène substitué, un groupe pyridinylène substitué, ou un groupe triazinylène substitué qui ont au moins un substituant qui est un atome d'halogène, un groupe cyano, un groupe hydroxyle, un groupe alkyle en C₁ à C₁₀, un groupe alkoxy en C₁ à C₁₀, un groupe phényle, un groupe naphtyle ou un groupe anthryle ; et
Q₁ est un hydrogène ; un groupe alkyle en C₁ à C₁₀ ; un groupe phényle ; un groupe naphtyle ; un groupe carbazolyle ; un groupe fluorényle ; ou un groupe alkyle en C₁ à C₁₀ substitué, un groupe alkoxy en C₁ à C₁₀ substitué, un groupe phényle substitué, un groupe naphtyle substitué, un groupe carbazolyle substitué ou un groupe fluorényle substitué qui ont au moins un substituant qui est un atome d'halogène, un groupe cyano, un groupe hydroxyle, un groupe alkyle en C₁ à C₁₀, un groupe alkoxy en C₁ à C₁₀, un groupe phényle, un groupe naphtyle ou un groupe anthryle.

9. Dispositif électroluminescent organique selon la revendication 1, dans lequel Ar₂ et Ar₁₂ sont chacun indépendamment un hydrogène ; un groupe alkyle en C₁ à C₁₀ ; un groupe phényle ; un groupe naphtyle ; un groupe carbazolyle ; un groupe fluorényle ; un groupe pyrényle ; un groupe alkyle en C₁ à C₁₀ substitué, un groupe alkoxy en C₁ à C₁₀ substitué, un groupe phényle substitué, un groupe naphtyle substitué, un groupe carbazolyle substitué, un groupe fluorényle substitué ou un groupe pyrényle substitué qui ont au moins un substituant qui est un atome d'halogène, un groupe cyano, un groupe hydroxyle, un groupe alkyle en C₁ à C₁₀, un groupe alkoxy en C₁ à C₁₀, un groupe phényle, un groupe naphtyle ou un groupe anthryle ; ou -N(Q₂) (Q₃), où Q₂ et Q₃ sont chacun indépendamment un hydrogène, un groupe méthyle, un groupe éthyle, un groupe phényle, un groupe méthylphényle, un groupe biphényle, un groupe naphtyle ou un groupe méthylnaphtyle.

10. Dispositif électroluminescent organique selon l'une quelconque des revendications précédentes, dans lequel la quantité du composé contenant un groupe cyano dans la couche (6) est de 0,1 à 20 parties en poids, basé sur 100 parties en poids de la couche (6).

11. Dispositif électroluminescent organique selon l'une quelconque des revendications précédentes, dans lequel la couche (6) a une épaisseur de 10 à 2100 Å.

12. Dispositif électroluminescent organique selon l'une quelconque des revendications précédentes, dans lequel une distance entre la couche (6) et la couche d'émission est de 50 Å ou plus.

13. Dispositif électroluminescent organique selon la revendication 1, dans lequel le composé à base d'anthracène est un de la formule 101 et la formule 102 ci-dessous, et le composé à base de quinolate est le quinolate de lithium (LiQ), 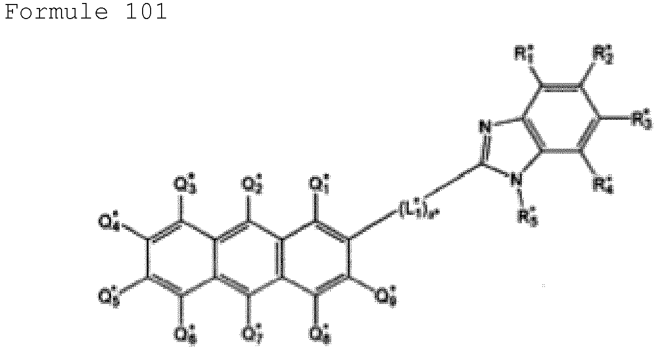 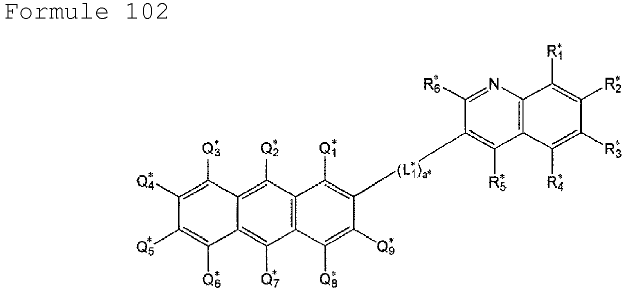 où, dans les formules 101 et 102,
R*₁ à R*₆ sont chacun indépendamment un atome d'hydrogène, un atome d'halogène, un groupe hydroxy, un groupe cyano, un groupe alkyle en C₁ à C₃₀ substitué ou non substitué, un groupe alkoxy en C₁ à C₃₀ substitué ou non substitué, un groupe acyle en C₁ à C₃₀ substitué ou non substitué, un groupe alcényle en C₂ à C₃₀ substitué ou non substitué, un groupe alcynyle en C₂ à C₃₀ substitué ou non substitué, un groupe aryle en C₆ à C₃₀ substitué ou non substitué, ou un groupe hétéroaryle en C₃ à C₃₀ substitué ou non substitué, où au moins deux groupes adjacents de R*₁ à R*₆ sont liés pour former un noyau saturé ou non saturé ;
L*₁ est une simple liaison, un groupe alkylène en C₁ à C₃₀ substitué ou non substitué, un groupe arylène en C₆ à C₃₀ substitué ou non substitué ou un groupe hétéroarylène en C₃ à C₃₀ substitué ou non substitué ;
Q*₁ à Q*₉ sont chacun indépendamment un atome d'hydrogène, un groupe aryle en C₆ à C₃₀ substitué ou non substitué ou un groupe hétéroaryle en C₃ à C₃₀ substitué ou non substitué ; et
a* est un nombre entier de 1 à 10.

14. Dispositif électroluminescent organique selon la revendication 1, dans lequel le composé à base d'anthracène est un de la formule 103 et de la formule 104 ci-dessous, et le composé à base de quinolate est le quinolate de lithium (LiQ),

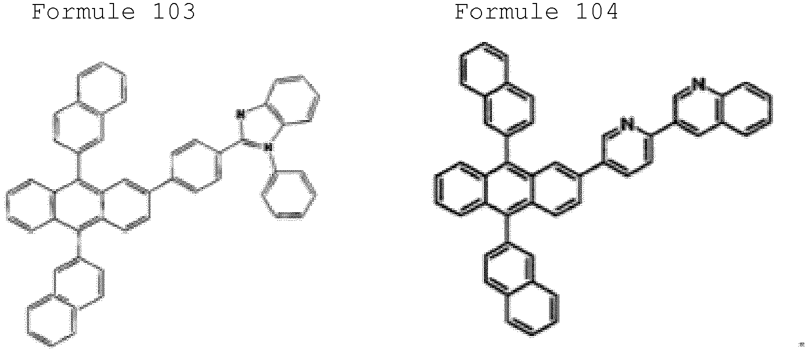

15. Dispositif électroluminescent organique selon la revendication 1, dans lequel la quantité du composé à base d'anthracène est de 50 à 150 parties en poids, sur la base de 100 parties en poids du composé à base de quinolate.

16. Dispositif électroluminescent organique selon l'une quelconque des revendications précédentes, dans lequel la couche d'émission (EML) comprend un dopant bleu et un hôte bleu.

17. Dispositif électroluminescent organique selon la revendication 16, dans lequel la couche d'émission comprend un dopant bleu se situant dans la formule 201 ci-dessous et un hôte bleu se situant dans la formule 202 ci-dessous, 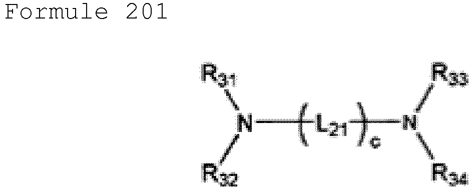 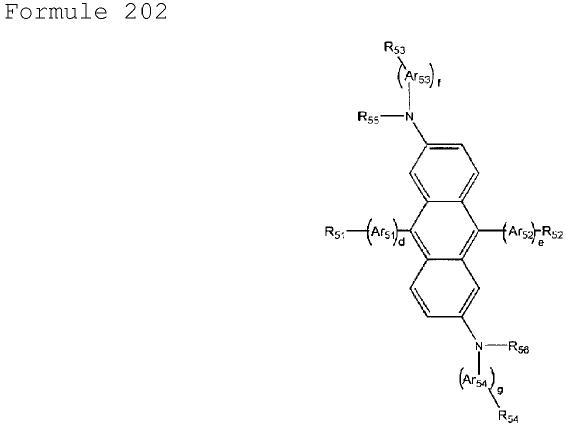 où, dans les formules 201 et 202,
L₂₁ est un groupe alkylène en C₁ à C₃₀ substitué ou non substitué, un groupe alcénylène en C₂ à C₃₀ substitué ou non substitué, un groupe arylène en C₅ à C₃₀ substitué ou non substitué ou un groupe hétéroarylène en C₄ à C₃₀ substitué ou non substitué ;
c est un nombre entier de 1 à 20 ;
R₃, à R₃₄ sont chacun indépendamment un groupe alkyle en C₁ à C₃₀ substitué ou non substitué, un groupe alcényle en C₂ à C₃₀ substitué ou non substitué, un groupe alcynyle en C₂ à C₃₀ substitué ou non substitué, un groupe alkoxy en C₁ à C₃₀ substitué ou non substitué, un groupe aryle en C₅ à C₃₀ substitué ou non substitué, ou un groupe hétéroaryle en C₄ à C₃₀ substitué ou non substitué.'
c groupes de L₂₁ dans -(L₂₁)_{c}- sont identiques ou différents l'un de l'autre ;
Ar₅₁, Ar₅₂, Ar₅₃ et Ar₅₄ sont chacun indépendamment un groupe phénylène, un groupe naphtylène, un groupe anthrylène, ou un groupe anthrylène substitué par un phényle,
R₅₁ à R₅₆ sont chacun indépendamment un atome d'hydrogène, un groupe méthyle, un groupe éthyle, un groupe propyle, un groupe butyle, un groupe phényle, un groupe naphtyle, un groupe anthryle, un groupe pyrényle, un groupe carbazolyle, ou -N(Q₂)(Q₃), où Q₂ et Q₃ sont chacun indépendamment un groupe méthyle, un groupe phényle, un groupe naphtyle, ou un groupe anthryle ; et
d, e, f et g sont chacun indépendamment un nombre entier de 0 à 10.
